# EUROPEAN PATENT APPLICATION

(11) **EP 4 199 685 A1**
(43) Date of publication of application: **21.06.2023**
(21) Application number: 22212750.8
(22) Date of filing: 12.12.2022
(51) Int. Cl.: H10K 85/30, H10K 50/11, H10K 101/20

(54) **LIGHT EMITTING ELEMENT AND ORGANOMETALLIC COMPOUND FOR LIGHT EMITTING ELEMENT**

(30) Priority: 14.12.2021 KR 20210179131
(71) Applicant: Samsung Display Co., Ltd., Yongin-si, Gyeonggi-do 17113 (KR)
(72) Inventor: LEE, HYUNJUNG, Hwaseong-si, Gyeonggi-do (KR); KO, SOO-BYUNG, 4104-1102 Giheung-gu, Yongin-si, Gyeonggi-do (KR); KIM, SUNGBUM, Giheung-gu, Yongin-si, Gyeonggi-do (KR); AHN, SEIHWAN, 702 Hwaseong-si, Gyeonggi-do (KR); AHN, EUNSOO, 202-404 Jinju-si, Gyeongsangnam-do (KR); LEE, EUNYOUN, Sejong-si (KR); LEE, JAESUNG, 408 Hwaseong-si, Gyeonggi-do (KR)
(74) Representative: Dr. Weitzel & Partner

(57) **Abstract**

A light emitting element that includes a first electrode, a second, and an emission layer between the first electrode and the second electrode and including an organometallic compound represented by Formula 1 is provided. The light emitting element has a high emission efficiency, high color purity properties and long-life characteristics.

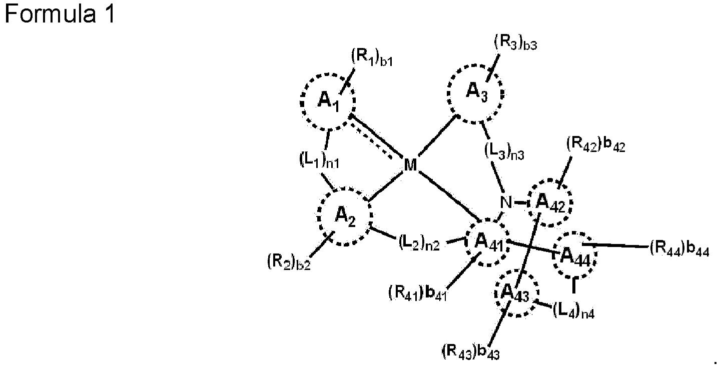

## Description

### BACKGROUND

### 1. Field

Aspects of one or more embodiments of the present disclosure herein relate to a light emitting element and an organometallic compound for a light emitting element, and for example, to a light emitting element including an organometallic compound in an emission layer and an organometallic compound used therein.

### 2. Description of the Related Art

Recently, the development of an organic electroluminescence display as an image display is being actively conducted. The organic electroluminescence display is different from a liquid crystal display and is a display of a self-luminescent type in which holes and electrons injected from a first electrode and a second electrode recombine in an emission layer so that a light emitting material in the emission layer emits light to achieve display.

In the application of a light emitting element to a display, the decrease of a driving voltage and the increase of emission efficiency and life of the light emitting element are required, and development on materials for a light emitting element, stably achieving the requirements is being continuously required, which is the underlying problem and at the same time the object of the invention.

### SUMMARY

Aspects of one or more embodiments of the present disclosure are directed to a light emitting element having high emission efficiency, high color purity and long-life characteristics, and an organometallic compound used therein.

The invention provides a light emitting element including a first electrode, a second electrode disposed on the first electrode, and an emission layer disposed between the first electrode and the second electrode and including a first compound represented by Formula 1 below, and at least one among second to fourth compounds, wherein the first compound to the fourth compound are different from each other.

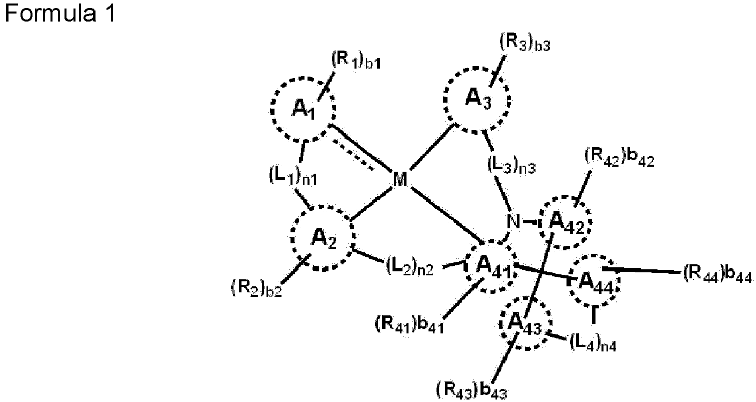

In Formula 1, M is Pt, Pd, Cu, Ag, Au, Rh, Ir, Ru or Os, A₁ to A₃, and A₄₁ to A₄₄ are each independently a hydrocarbon ring of 5 to 60 ring-forming carbon atoms, or a heterocycle of 1 to 60 carbon atoms, b1 to b3 are each independently an integer from 0 to 4, b41 to b44 are each independently an integer from 0 to 4, L₁ to L₄ are each independently selected from among a direct linkage, *-O-*', *-S-*', *-C(R₁₁)(R₁₂)-*', *-C(R₁₃)=*', *-C(R₁₄)=C(R₁₅)-*', *-C(=O)-*', *-C(=S)-*', *-C≡C-*', *-B(R₁₆)-*', *-N(R₁₇)-*', *-P(R₁₈)(R₁₉)-*', *-Si(R₂₀)(R₂₁)-*', and *-Ge(R₂₂)(R₂₃)-*', n1 and n3 are each independently an integer from 0 to 3, n2 and n4 are each independently an integer from 1 to 3, R₁ to R₃, and R₄₁ to R₄₄ are each independently a hydrogen atom, a deuterium atom, a halogen atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 3 to 30 ring-forming carbon atoms, and R₁₁ to R₂₃ are each independently a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms.

In an embodiment, Formula 1 is represented by Formula 2.

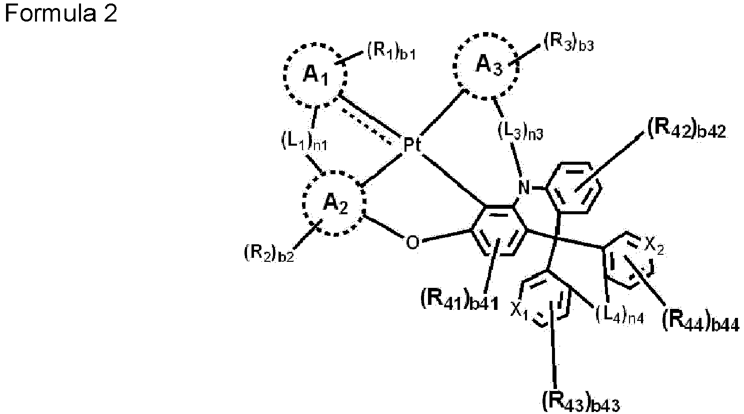

In Formula 2, X₁ and X₂ are each independently CRa, or N, Rₐ are a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms, b41 is an integer from 0 to 2, and A₁ to A₃, n1, n3, n4, L₁, L₃, L₄, b1 to b3, b42 to b44, R₁ to R₃, and R₄₁ to R₄₄ are the same as defined in Formula 1.

In an embodiment, Formula 2 is represented by Formula 3-1 or Formula 3-2.

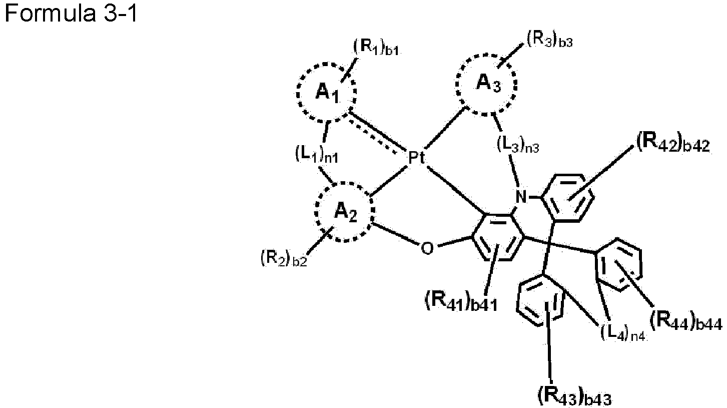

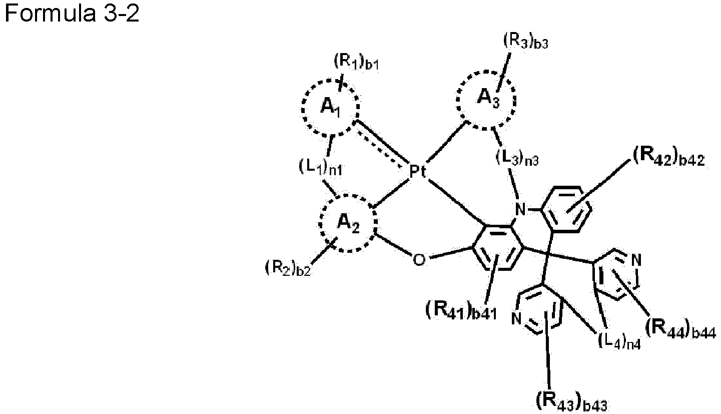

In Formula 3-1 and Formula 3-2, b41 may be an integer from 0 to 2, and A₁ to A₃, n1, n3, n4, L₁, L₃, L₄, b1 to b3, b42 to b44, R₁ to R₃, and R₄₁ to R₄₄ are the same as defined in Formula 1.

In an embodiment, Formula 3-1 may be represented by Formula 3A or Formula 3B.

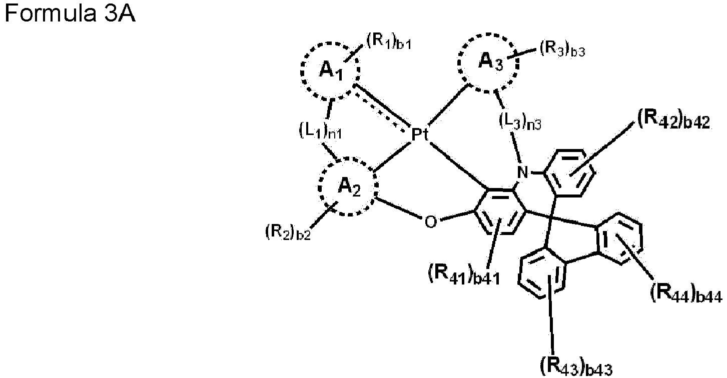

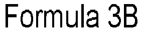

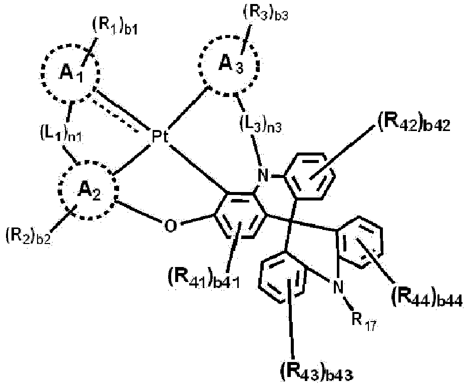

In Formula 3A and Formula 3B, b41 may be an integer from 0 to 2, and A₁ to A₃, n1, n3, L₁, L₃, b1 to b3, b42 to b44, R₁ to R₃, R₄₁ to R₄₄, and R₁₇ are the same as defined in Formula 1.

In an embodiment, R₁₇ in Formula 3B may be a substituted or unsubstituted phenyl group.

In an embodiment, R₄₃ and R₄₄ in Formula 3-2 may be hydrogen atoms.

In an embodiment, Formula 2 may be represented by Formula 4.

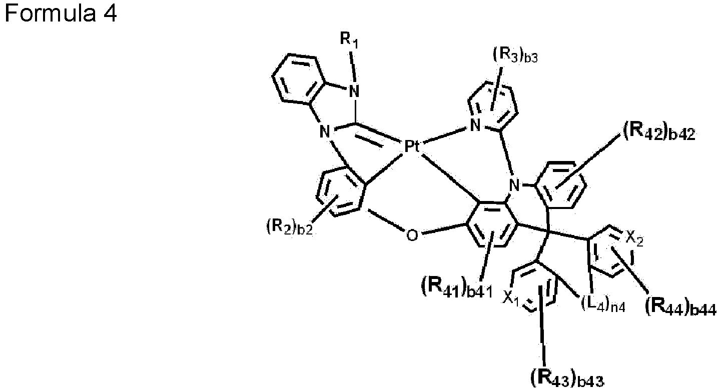

In Formula 4, b41 may be an integer from 0 to 2, and n4, L₄, b2, b3, b42 to b44, R₁ to R₃, R₄₁ to R₄₄, X₁, and X₂ are the same as defined in Formula 2.

In an embodiment, R₁ to R₃, and R₄₁ to R₄₄ may each independently be a hydrogen atom, a deuterium atom, a substituted or unsubstituted methyl group, a substituted or unsubstituted t-butyl group, or a substituted or unsubstituted phenyl group.

In an embodiment, the emission layer may include the second compound and the third compound, the first compound may be a phosphorescence dopant, the second compound may be a hole transport host, and the third compound may be an electron transport host.

In an embodiment, the emission layer may include the fourth compound, and the fourth compound may be a delayed fluorescence dopant.

In an embodiment, the emission layer may emit blue light.

According to an embodiment of the present disclosure, there is provided an organometallic compound represented by Formula 1.

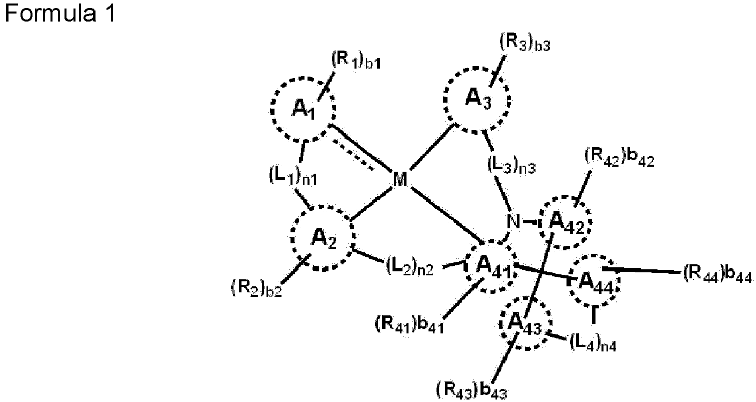

In Formula 1, M may be Pt, Pd, Cu, Ag, Au, Rh, Ir, Ru or Os, A₁ to A₃, and A₄₁ to A₄₄ may each independently be a hydrocarbon ring of 5 to 60 ring-forming carbon atoms, or a heterocycle of 1 to 60 carbon atoms, b1 to b3 may each independently be an integer from 0 to 4, b41 to b44 may each independently be an integer from 0 to 4, L₁ to L₄ may each independently be selected from among a direct linkage, *-O-*', *-S-*', *-C(R₁₁)(R₁₂)-*', *-C(R₁₃)=*', *-C(R₁₄)=C(R₁₅)-*', *-C(=O)-*', *-C(=S)-*', *-C≡C-*', *-B(R₁₆)-*', *-N(R₁₇)-*', *-P(R₁₈)(R₁₉)-*', *-Si(R₂₀)(R₂₁)-*', and *-Ge(R₂₂)(R₂₃)-*', n1 and n3 may each independently be an integer from 0 to 3, n2 and n4 may each independently be an integer from 1 to 3, R₁ to R₃, and R₄₁ to R₄₄ may each independently be a hydrogen atom, a deuterium atom, a halogen atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 3 to 30 ring-forming carbon atoms, and R₁₁ to R₂₃ may each independently be a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms.

In an embodiment, Formula 1 may be represented by Formula 2.

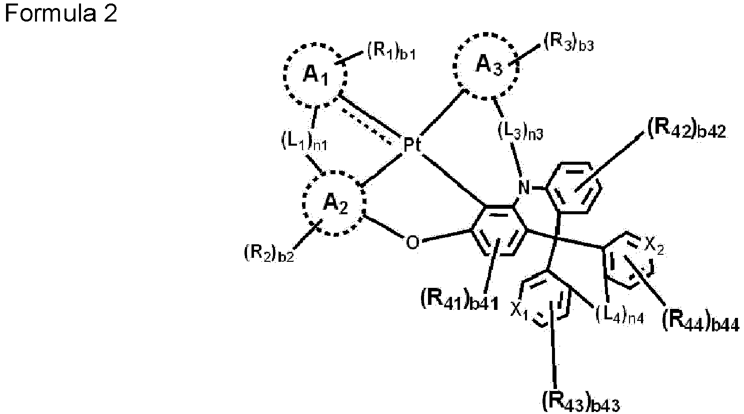

In Formula 2, X₁ and X₂ may each independently be CRa, or N, Rₐ may be a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms, b41 may be an integer from 0 to 2, and A₁ to A₃, n1, n3, n4, L₁, L₃, L₄, b1 to b3, b42 to b44, R₁ to R₃, and R₄₁ to R₄₄ are the same as defined in Formula 1.

In an embodiment, Formula 2 may be represented by Formula 3-1 or Formula 3-2.

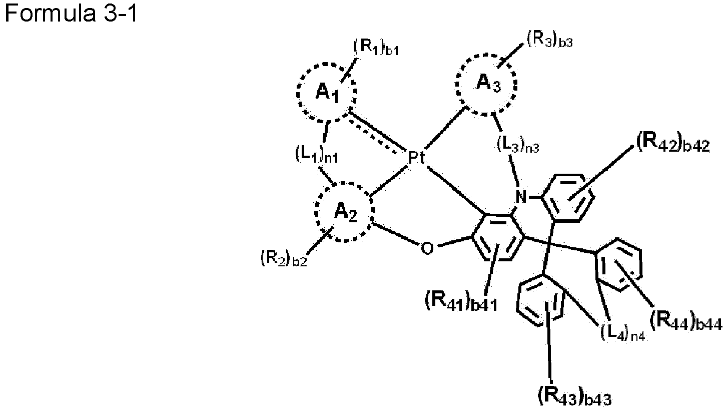

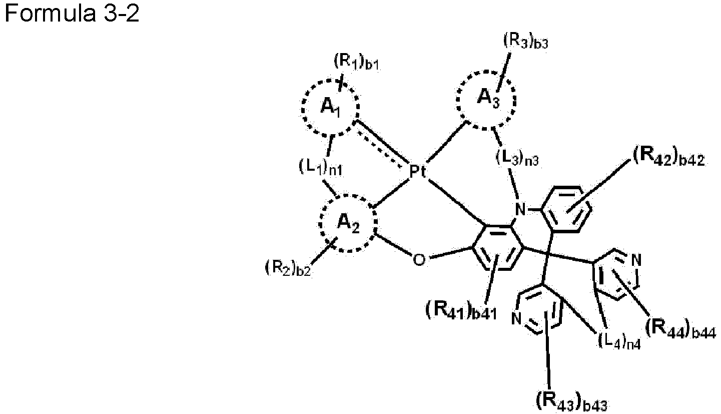

In Formula 3-1 and Formula 3-2, b41 may be an integer from 0 to 2, and A₁ to A₃, n1, n3, n4, L₁, L₃, L₄, b1 to b3, b42 to b44, R₁ to R₃, and R₄₁ to R₄₄ are the same as defined in Formula 1.

In an embodiment, Formula 3-1 may be represented by Formula 3A or Formula 3B.

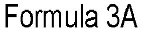

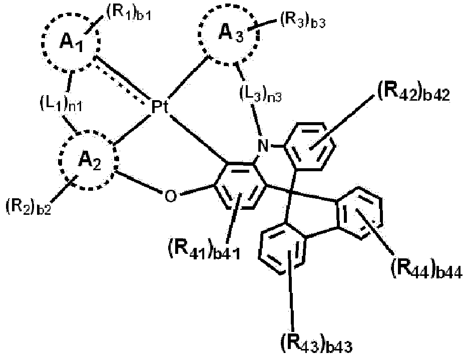

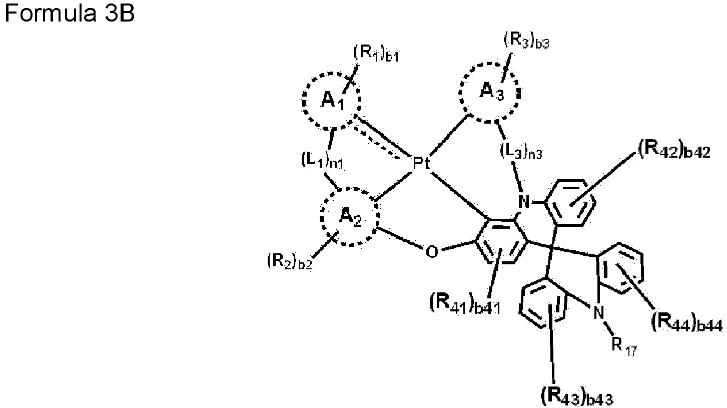

In Formula 3A and Formula 3B, b41 may be an integer from 0 to 2, and A₁ to A₃, n1, n3, L₁, L₃, b1 to b3, b42 to b44, R₁ to R₃, R₄₁ to R₄₄, and R₁₇ are the same as defined in Formula 1.

In an embodiment, R₁₇ in Formula 3B may be a substituted or unsubstituted phenyl group.

In an embodiment, R₄₃ and R₄₄ in Formula 3-2 may be hydrogen atoms.

In an embodiment, Formula 2 may be represented by Formula 4 below.

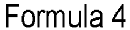

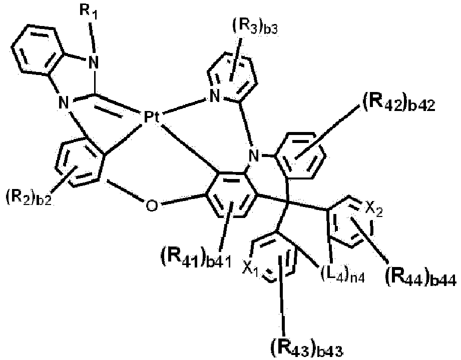

In Formula 4, n4, L₄, b2, b3, b41 may be an integer from 0 to 2, and b42 to b44, R₁ to R₃, R₄₁ to R₄₄, X₁, and X₂ are the same as defined in Formula 2.

### BRIEF DESCRIPTION OF THE FIGURES

The above and other aspects and features of certain embodiments of the disclosure will be more apparent from the following description taken in conjunction with the accompanying drawings, in which:
FIG. 1 is a plan view showing a display apparatus according to an embodiment;
FIG. 2 is a cross-sectional view of a display apparatus according to an embodiment;
FIG. 3 is a cross-sectional view schematically showing a light emitting element according to an embodiment;
FIG. 4 is a cross-sectional view schematically showing a light emitting element according to an embodiment;
FIG. 5 is a cross-sectional view schematically showing a light emitting element according to an embodiment;
FIG. 6 is a cross-sectional view schematically showing a light emitting element according to an embodiment;
FIG. 7 is a cross-sectional view of a display apparatus according to an embodiment;
FIG. 8 is a cross-sectional view of a display apparatus according to an embodiment;
FIG. 9 is a cross-sectional view of a display apparatus according to an embodiment; and
FIG. 10 is a cross-sectional view of a display apparatus according to an embodiment.

### DETAILED DESCRIPTION

The present disclosure may have one or more suitable modifications and may be embodied in different forms, and example embodiments will be explained in more detail with reference to the accompany drawings. The present disclosure may, however, be embodied in different forms and should not be construed as limited to the embodiments set forth herein. Rather, all modifications, equivalents, and substituents which are included in the spirit and technical scope of the present disclosure should be included in the present disclosure.

Like reference numerals refer to like elements throughout, and duplicative descriptions thereof may not be provided. In the drawings, the dimensions of structures may be exaggerated for clarity of illustration. It will be understood that, although the terms first, second, etc. may be used herein to describe one or more suitable elements, these elements should not be limited by these terms. These terms are only used to distinguish one element from another element. Thus, a first element could be termed a second element without departing from the teachings of the present invention. Similarly, a second element could be termed a first element. As used herein, the singular forms are intended to include the plural forms as well, unless the context clearly indicates otherwise.

In the disclosure, it will be further understood that the terms "comprises" and/or "comprising," when used in this specification, specify the presence of stated features, numerals, steps, operations, elements, parts, or the combination thereof, but do not preclude the presence or addition of one or more other features, numerals, steps, operations, elements, parts, or a combination thereof.

In the disclosure, when a layer, a film, a region, a plate, etc. is referred to as being "on" or "above" another part, it can be "directly on" the other part, or intervening layers may also be present. In addition, when a layer, a film, a region, a plate, etc. is referred to as being "under" or "below" another part, it can be "directly under" the other part, or intervening layers may also be present. Also, when an element is referred to as being disposed "on" another element, it can be disposed under the other element.

In the disclosure, the term "substituted or unsubstituted" corresponds to substituted or unsubstituted with at least one substituent selected from the group including (e.g., consisting of) a deuterium atom, a halogen atom, a cyano group, a nitro group, an amino group, a silyl group, an oxy group, a thio group, a sulfinyl group, a sulfonyl group, a carbonyl group, a boron group, a phosphine oxide group, a phosphine sulfide group, an alkyl group, an alkenyl group, an alkynyl group, a hydrocarbon ring group, an aryl group, and a heterocyclic group. In addition, each of the exemplified substituents may be substituted or unsubstituted. For example, a biphenyl group may be interpreted as an aryl group or a phenyl group substituted with a phenyl group.

In the disclosure, the term "forming a ring via the combination with an adjacent group" may refer to forming a substituted or unsubstituted hydrocarbon ring, or a substituted or unsubstituted heterocycle via the combination with an adjacent group. The hydrocarbon ring includes an aliphatic hydrocarbon ring and an aromatic hydrocarbon ring. The heterocycle includes an aliphatic heterocycle and an aromatic heterocycle. The hydrocarbon ring and the heterocycle may be monocycles or polycycles. In addition, the ring formed via the combination with an adjacent group may be combined with another ring to form a spiro structure.

In the disclosure, the term "adjacent group" may refer to a substituent substituted for an atom which is directly combined with an atom substituted with a corresponding substituent, another substituent substituted for an atom which is substituted with a corresponding substituent, or a substituent sterically positioned at the nearest position to a corresponding substituent. For example, in 1,2-dimethylbenzene, two methyl groups may be interpreted as "adjacent groups" to each other, and in 1,1-diethylcyclopentene, two ethyl groups may be interpreted as "adjacent groups" to each other. In addition, in 4,5-dimethylphenanthrene, two methyl groups may be interpreted as "adjacent groups" to each other.

In the disclosure, a halogen atom may be a fluorine atom, a chlorine atom, a bromine atom or an iodine atom.

In the disclosure, an alkyl group may be a linear or branched type. The carbon number of the alkyl group may be 1 to 50, 1 to 30, 1 to 20, 1 to 10, or 1 to 6. Examples of the alkyl group may include methyl, ethyl, n-propyl, isopropyl, n-butyl, s-butyl, t-butyl, i-butyl, 2-ethylbutyl, 3,3-dimethylbutyl, n-pentyl, i-pentyl, neopentyl, t-pentyl, 1-methylpentyl, 3-methylpentyl, 2-ethylpentyl, 4-methyl-2-pentyl, n-hexyl, 1-methylhexyl, 2-ethylhexyl, 2-butylhexyl, n-heptyl, 1-methylheptyl, 2,2-dimethylheptyl, 2-ethylheptyl, 2-butylheptyl, n-octyl, t-octyl, 2-ethyloctyl, 2-butyloctyl, 2-hexyloctyl, 3,7-dimethyloctyl, n-nonyl, n-decyl, adamantyl, 2-ethyldecyl, 2-butyldecyl, 2-hexyldecyl, 2-octyldecyl, n-undecyl, n-dodecyl, 2-ethyldodecyl, 2-butyldodecyl, 2-hexyldocecyl, 2-octyldodecyl, n-tridecyl, n-tetradecyl, n-pentadecyl, n-hexadecyl, 2-ethylhexadecyl, 2-butylhexadecyl, 2-hexylhexadecyl, 2-octylhexadecyl, n-heptadecyl, n-octadecyl, n-nonadecyl, n-eicosyl, 2-ethyleicosyl, 2-butyleicosyl, 2-hexyleicosyl, 2-octyleicosyl, n-henicosyl, n-docosyl, n-tricosyl, n-tetracosyl, n-pentacosyl, n-hexacosyl, n-heptacosyl, n-octacosyl, n-nonacosyl, n-triacontyl, etc., without limitation.

In the disclosure, a cycloalkyl group may refer to a ring-type alkyl group. The carbon number of the cycloalkyl group may be 3 to 50, 3 to 30, 3 to 20, or 3 to 10. Examples of the cycloalkyl group include a cyclopropyl group, a cyclobutyl group, a cyclopentyl group, a cyclohexyl group, a 4-methylcyclohexyl group, a 4-t-butylcyclohexyl group, a cycloheptyl group, a cyclooctyl group, a cyclononyl group, a cyclodecyl group, a norbornyl group, a 1-adamantyl group, a 2-adamantyl group, an isobornyl group, a bicycloheptyl group, etc., without limitation.

In the disclosure, an alkenyl group refers to a hydrocarbon group including one or more carbon double bonds in the middle or at the terminal of an alkyl group having a carbon number of 2 or more. The alkenyl group may be a linear chain or a branched chain. The carbon number is not limited, but may be 2 to 30, 2 to 20, or 2 to 10. Examples of the alkenyl group include a vinyl group, a 1-butenyl group, a 1-pentenyl group, a 1,3-butadienyl aryl group, a styrenyl group, a styrylvinyl group, etc., without limitation.

In the disclosure, an alkynyl group refers to a hydrocarbon group including one or more carbon triple bonds in the middle or at the terminal of an alkyl group having a carbon number of 2 or more. The alkynyl group may be a linear chain or a branched chain. The carbon number is not limited, but may be 2 to 30, 2 to 20, or 2 to 10. Examples of the alkynyl group include an ethynyl group, a propynyl group, etc., without limitation.

In the disclosure, a hydrocarbon ring group refers to an optional functional group or substituent derived from an aliphatic hydrocarbon ring. The hydrocarbon ring group may be a saturated hydrocarbon ring group of 5 to 20 ring-forming carbon atoms.

In the disclosure, an aryl group refers to an optional functional group or substituent derived from an aromatic hydrocarbon ring. The aryl group may be a monocyclic aryl group or a polycyclic aryl group. The carbon number for forming rings in the aryl group may be 6 to 30, 6 to 20, or 6 to 15. Examples of the aryl group may include phenyl, naphthyl, fluorenyl, anthracenyl, phenanthryl, biphenyl, terphenyl, quaterphenyl, quinquephenyl, sexiphenyl, triphenylenyl, pyrenyl, benzofluoranthenyl, chrysenyl, etc., without limitation.

In the disclosure, a fluorenyl group may be substituted, and two substituents may be combined with each other to form a spiro structure. Examples of a substituted fluorenyl group are as follows, but an embodiment of the present disclosure is not limited thereto.

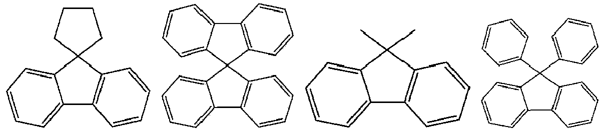

In the disclosure, a heterocyclic group refers to an optional functional group or substituent derived from a ring including one or more selected from among B, O, N, P, Si, and S as heteroatoms. The heterocyclic group includes an aliphatic heterocyclic group and/or an aromatic heterocyclic group. The aromatic heterocyclic group may be a heteroaryl group. The aliphatic heterocyclic group and/or the aromatic heterocyclic group may be a monocycle or a polycycle.

In the disclosure, a heterocyclic group may include one or more selected from among B, O, N, P, Si and S as heteroatoms. If the heterocyclic group includes two or more heteroatoms, two or more heteroatoms may be the same or different. The heterocyclic group may be a monocyclic heterocyclic group or a polycyclic heterocyclic group, and includes a heteroaryl group. The carbon number for forming rings of the heterocyclic group may be 2 to 30, 2 to 20, and 2 to 10.

In the disclosure, an aliphatic heterocyclic group may include one or more selected from among B, O, N, P, Si, and S as heteroatoms. The number of ring-forming carbon atoms of the aliphatic heterocyclic group may be 2 to 30, 2 to 20, or 2 to 10. Examples of the aliphatic heterocyclic group may include an oxirane group, a thiirane group, a pyrrolidine group, a piperidine group, a tetrahydrofuran group, a tetrahydrothiophene group, a thiane group, a tetrahydropyran group, a 1,4-dioxane group, etc., without limitation.

In the disclosure, a heteroaryl group may include one or more selected from among B, O, N, P, Si, and S as heteroatoms. When the heteroaryl group includes two or more heteroatoms, two or more heteroatoms may be the same or different. The heteroaryl group may be a monocyclic heterocyclic group or polycyclic heterocyclic group. The carbon number for forming rings of the heteroaryl group may be 2 to 30, 2 to 20, or 2 to 10. Examples of the heteroaryl group may include thiophene, furan, pyrrole, imidazole, triazole, pyridine, bipyridine, pyrimidine, triazine, triazole, acridyl, pyridazine, pyrazinyl, quinoline, quinazoline, quinoxaline, phenoxazine, phthalazine, pyrido pyrimidine, pyrido pyrazine, pyrazino pyrazine, isoquinoline, indole, carbazole, N-arylcarbazole, N-heteroarylcarbazole, N-alkylcarbazole, benzoxazole, benzoimidazole, benzothiazole, benzocarbazole, benzothiophene, dibenzothiophene, thienothiophene, benzofuran, phenanthroline, thiazole, isoxazole, oxazole, oxadiazole, thiadiazole, phenothiazine, dibenzosilole, dibenzofuran, etc., without limitation.

In the disclosure, the same explanation on the above-described aryl group may be applied to an arylene group except that the arylene group is a divalent group. The same explanation on the above-described heteroaryl group may be applied to a heteroarylene group except that the heteroarylene group is a divalent group.

In the disclosure, a silyl group includes an alkyl silyl group and/or an aryl silyl group. Examples of the silyl group include a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group, etc., without limitation.

In the disclosure, the carbon number of amino groups is not limited, but may be 1 to 30. The amino group may include an alkyl amino group, an aryl amino group, and/or a heteroaryl amino group. Examples of the amino group include a methylamino group, a dimethylamino group, a phenylamino group, a diphenylamino group, a naphthylamino group, a 9-methyl-anthracenylamino group, a triphenylamino group, etc., without limitation.

In the disclosure, the carbon number of a carbonyl group is not limited, but the carbon number may be 1 to 40, 1 to 30, or 1 to 20. For example, the carbonyl group may have the structures below, but is not limited thereto.

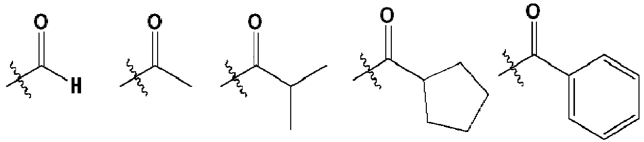

In the disclosure, the carbon number of a sulfinyl group and sulfonyl group is not limited, but may be 1 to 30. The sulfinyl group may include an alkyl sulfinyl group and/or an aryl sulfinyl group. The sulfonyl group may include an alkyl sulfonyl group and/or an aryl sulfonyl group.

In the disclosure, a thio group may include an alkyl thio group and/or an aryl thio group. The thio group may refer to the above-defined alkyl group or aryl group combined with a sulfur atom. Examples of the thio group include a methylthio group, an ethylthio group, a propylthio group, a pentylthio group, a hexylthio group, an octylthio group, a dodecylthio group, a cyclopentylthio group, a cyclohexylthio group, a phenylthio group, a naphthylthio group, etc., without limitation.

In the disclosure, an oxy group may refer to the above-defined alkyl group or aryl group which is combined with an oxygen atom. The oxy group may include an alkoxy group and/or an aryl oxy group. The alkoxy group may be a linear, branched or cyclic chain. The carbon number of the alkoxy group is not limited but may be, for example, 1 to 20 or 1 to 10. Examples of the oxy group may include methoxy, ethoxy, n-propoxy, isopropoxy, butoxy, pentyloxy, hexyloxy, octyloxy, nonyloxy, decyloxy, benzyloxy, etc. However, an embodiment of the present disclosure is not limited thereto.

In the disclosure, a boron group may refer to the above-defined alkyl group or aryl group, combined with a boron atom. The boron group may include an alkyl boron group and/or an aryl boron group. Examples of the boron group include a dimethylboron group, a diethylboron group, a t-butylmethylboron group, a diphenylboron group, a phenylboron group, etc., without limitation.

In the disclosure, an alkenyl group may be a linear chain or a branched chain. The carbon number is not limited but may be 2 to 30, 2 to 20, or 2 to 10. Examples of the alkenyl group may include a vinyl group, a 1-butenyl group, a 1-pentenyl group, a 1,3-butadienyl aryl group, a styrenyl group, a styryl vinyl group, etc., without limitation.

In the disclosure, the carbon number of an amine group is not limited, but may be 1 to 30. The amine group may include an alkyl amine group and/or an aryl amine group. Examples of the amine group include a methylamine group, a dimethylamine group, a phenylamine group, a diphenylamine group, a naphthylamine group, a 9-methyl-anthracenylamine group, a triphenylamine group, etc., without limitation.

In the disclosure, alkyl groups in an alkylthio group, alkylsulfoxy group, alkylaryl group, alkylamino group, alkylboron group, alkyl silyl group, and/or alkyl amine group may be the same as the examples of the above-described alkyl group.

In the disclosure, aryl groups in an aryloxy group, arylthio group, arylsulfoxy group, aryl amino group, arylboron group, and/or aryl silyl group may be the same as the examples of the above-described aryl group.

In the disclosure, a direct linkage may mean a single bond.

In some embodiments, in the disclosure, 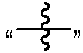 , and 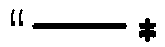 " refer to positions to be connected.

Hereinafter, embodiments of the present disclosure will be explained referring to the drawings.

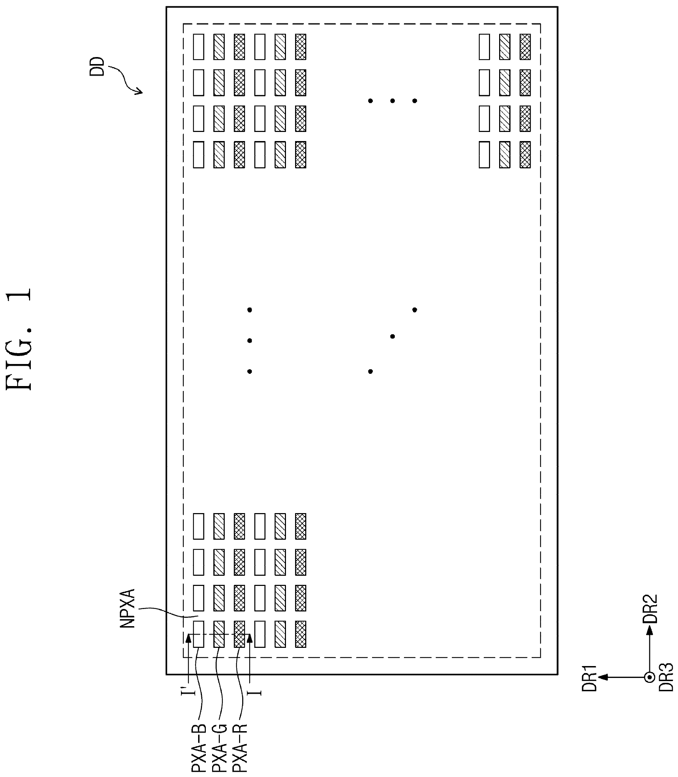

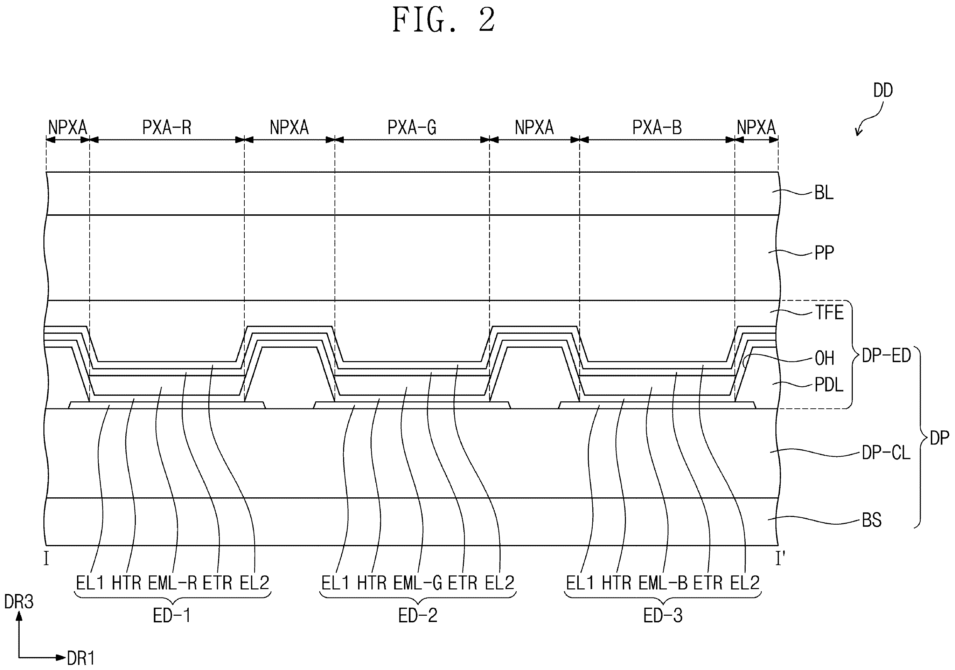

FIG. 1 is a plan view showing an embodiment of a display apparatus DD. FIG. 2 is a cross-sectional view of a display apparatus DD of an embodiment. FIG. 2 is a cross-sectional view showing a part corresponding to line I-I' of FIG. 1.

The display apparatus DD may include a display panel DP and an optical layer PP disposed on the display panel DP. The display panel DP includes light emitting elements ED-1, ED-2 and ED-3. The display apparatus DD may include multiple light emitting elements ED-1, ED-2 and ED-3. The optical layer PP may be disposed on the display panel DP and control reflected light by external light at the display panel DP. The optical layer PP may include, for example, a polarization layer or a color filter layer. In some embodiments, the optical layer PP may not be provided in the display apparatus DD.

On the optical layer PP, a base substrate BL may be disposed. The base substrate BL may be a member that provides a base surface on which the optical layer PP is disposed. The base substrate BL may be a glass substrate, a metal substrate, a plastic substrate, etc. However, an embodiment of the present disclosure is not limited thereto, and the base substrate BL may be an inorganic layer, an organic layer or a composite material layer. In some embodiments, the base substrate BL may not be provided.

The display apparatus DD according to an embodiment may further include a plugging layer. The plugging layer may be between a display device layer DP-ED and a base substrate BL. The plugging layer may be an organic layer. The plugging layer may include at least one selected from among an acrylic-based resin, a silicon-based resin and an epoxy-based resin.

The display panel DP may include a base layer BS, a circuit layer DP-CL provided on the base layer BS and a display device layer DP-ED. The display device layer DP-ED may include a pixel definition layer PDL, light emitting elements ED-1, ED-2 and ED-3 disposed in the pixel definition layer PDL, and an encapsulating layer TFE disposed on the light emitting elements ED-1, ED-2 and ED-3.

The base layer BS may be a member that provides a base surface in which the display device layer DP-ED is disposed. The base layer BS may be a glass substrate, a metal substrate, a plastic substrate, etc. However, an embodiment of the present disclosure is not limited thereto, and the base layer BS may be an inorganic layer, an organic layer or a composite material layer.

In an embodiment, the circuit layer DP-CL is on the base layer BS, and the circuit layer DP-CL may include multiple transistors. Each of the transistors may include a control electrode, an input electrode, and an output electrode. For example, the circuit layer DP-CL may include switching transistors and driving transistors for driving the light emitting elements ED-1, ED-2 and ED-3 of the display device layer DP-ED.

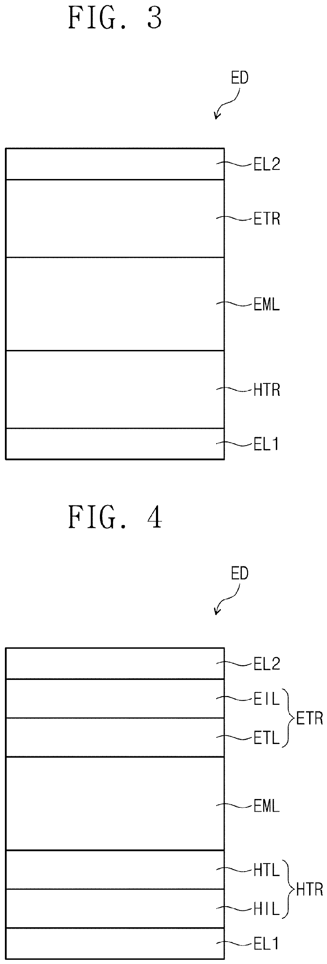

Each of the light emitting elements ED-1, ED-2 and ED-3 may have the structures of light emitting elements ED of embodiments according to FIG. 3 to FIG. 6 described below. Each of the light emitting elements ED-1, ED-2 and ED-3 may include a first electrode EL1, a hole transport region HTR, emission layers EML-R, EML-G and EML-B, an electron transport region ETR, and a second electrode EL2.

In FIG. 2, shown is an embodiment in which the emission layers EML-R, EML-G and EML-B of light emitting elements ED-1, ED-2 and ED-3 are disposed in opening portions OH defined in a pixel definition layer PDL, and a hole transport region HTR, an electron transport region ETR and a second electrode EL2 are provided as common layers in all light emitting elements, for example, ED-1, ED-2 and ED-3. However, an embodiment of the present disclosure is not limited thereto. In an embodiment, the hole transport region HTR and the electron transport region ETR may be patterned and provided in the opening portions OH defined in the pixel definition layer PDL. For example, in an embodiment, the hole transport region HTR, the emission layers EML-R, EML-G and EML-B, and the electron transport region ETR of the light emitting elements ED-1, ED-2 and ED-3 may be patterned by an ink jet printing method and provided.

An encapsulating layer TFE may cover the light emitting elements ED-1, ED-2 and ED-3. The encapsulating layer TFE may encapsulate the display device layer DP-ED. The encapsulating layer TFE may be a thin film encapsulating layer. The encapsulating layer TFE may be one layer or a stacked layer of multiple layers. The encapsulating layer TFE includes at least one insulating layer. The encapsulating layer TFE according to an embodiment may include at least one inorganic layer (hereinafter, encapsulating inorganic layer). In some embodiments, the encapsulating layer TFE according may include at least one organic layer (hereinafter, encapsulating organic layer) and at least one encapsulating inorganic layer.

The encapsulating inorganic layer protects the display device layer DP-ED from moisture/oxygen, and the encapsulating organic layer protects (reduces the exposure to foreign materials) the display device layer DP-ED from foreign materials such as dust particles. The encapsulating inorganic layer may include silicon nitride, silicon oxy nitride, silicon oxide, titanium oxide, and/or aluminum oxide, without specific limitation. The encapsulating organic layer may include an acrylic compound, an epoxy-based compound, etc. The encapsulating organic layer may include a photopolymerizable organic material, without specific limitation.

The encapsulating layer TFE may be on the second electrode EL2 and may be disposed while filling the opening portion OH.

Referring to FIG. 1 and FIG. 2, the display apparatus DD may include a non-luminous area NPXA and luminous areas PXA-R, PXA-G and PXA-B. The luminous areas PXA-R, PXA-G and PXA-B may be areas emitting light produced from the light emitting elements ED-1, ED-2 and ED-3, respectively. The luminous areas PXA-R, PXA-G and PXA-B may be separated from each other on a plane (e.g., in a plan view).

The luminous areas PXA-R, PXA-G and PXA-B may be areas separated by the pixel definition layer PDL. The non-luminous areas NPXA may be areas between neighboring luminous areas PXA-R, PXA-G and PXA-B and may be areas corresponding to the pixel definition layer PDL. In some embodiments, in the disclosure, each of the luminous areas PXA-R, PXA-G and PXA-B may correspond to each pixel. The pixel definition layer PDL may divide the light emitting elements ED-1, ED-2 and ED-3. The emission layers EML-R, EML-G and EML-B of the light emitting elements ED-1, ED-2 and ED-3 may be disposed and divided in the opening portions OH defined in the pixel definition layer PDL.

The luminous areas PXA-R, PXA-G and PXA-B may be divided into multiple groups according to the color of light produced from the light emitting elements ED-1, ED-2 and ED-3. In the display apparatus DD of an embodiment, shown in FIG. 1 and FIG. 2, three luminous areas PXA-R, PXA-G and PXA-B emitting red light, green light and blue light are illustrated as an embodiment. For example, the display apparatus DD of an embodiment may include a red luminous area PXA-R, a green luminous area PXA-G and a blue luminous area PXA-B, which are separated from each other.

In the display apparatus DD according to an embodiment, multiple light emitting elements ED-1, ED-2 and ED-3 may emit light having different wavelength regions. For example, in an embodiment, the display apparatus DD may include a first light emitting element ED-1 emitting red light, a second light emitting element ED-2 emitting green light, and a third light emitting element ED-3 emitting blue light. For example, each of the red luminous area PXA-R, the green luminous area PXA-G, and the blue luminous area PXA-B of the display apparatus DD may correspond to the first light emitting element ED-1, the second light emitting element ED-2, and the third light emitting element ED-3.

However, an embodiment of the present disclosure is not limited thereto, and the first to third light emitting elements ED-1, ED-2 and ED-3 may emit light in the same wavelength region, or at least one thereof may emit light in a different wavelength region. For example, all the first to third light emitting elements ED-1, ED-2 and ED-3 may emit blue light.

The luminous areas PXA-R, PXA-G and PXA-B in the display apparatus DD according to an embodiment may be arranged in a stripe shape. Referring to FIG. 1, multiple red luminous areas PXA-R may be arranged with each other along a second direction axis DR2, multiple green luminous areas PXA-G may be arranged with each other along the second direction axis DR2, and multiple blue luminous areas PXA-B may be arranged with each other along the second direction axis DR2. In some embodiments, the red luminous area PXA-R, the green luminous area PXA-G and the blue luminous area PXA-B may be arranged by turns along a first directional axis DR1. (DR3 is a third direction which is normal or perpendicular to the plane defined by the first direction DR1 and the second direction DR2).

In FIG. 1 and FIG. 2, the areas of the luminous areas PXA-R, PXA-G and PXA-B are shown to be substantially similar, but an embodiment of the present disclosure is not limited thereto. The areas of the luminous areas PXA-R, PXA-G and PXA-B may be different from each other according to the wavelength region of light emitted. In some embodiments, the areas of the luminous areas PXA-R, PXA-G and PXA-B may refer to areas on a plane defined by the first direction axis DR1 and the second direction axis DR2.

In some embodiments, the arrangement type of the luminous areas PXA-R, PXA-G and PXA-B is not limited to the configuration shown in FIG. 1, and the arrangement order of the red luminous areas PXA-R, the green luminous areas PXA-G and the blue luminous areas PXA-B may be provided in one or more suitable combinations according to the properties of display quality required for the display apparatus DD. For example, the arrangement type of the luminous areas PXA-R, PXA-G and PXA-B may be a pentile arrangement type (PENTILE^{®} arrangement form, for example, an RGBG matrix, an RGBG structure, or RGBG matrix structure), or a diamond arrangement type (Diamond Pixel^{™} arrangement form). PENTILE^{®} is a duly registered trademark of Samsung Display Co., Ltd. Diamond Pixel^{™} is a trademark of Samsung Display Co., Ltd.

In some embodiments, the areas (i.e., sizes) of the luminous areas PXA-R, PXA-G and PXA-B may be different from each other. For example, in an embodiment, the area of the green luminous area PXA-G may be smaller than the area of the blue luminous area PXA-B, but an embodiment of the present disclosure is not limited thereto.

Hereinafter, FIG. 3 to FIG. 6 are cross-sectional views schematically showing light emitting elements according to embodiments. The light emitting element ED according to an embodiment may include a first electrode EL1, a hole transport region HTR, an emission layer EML, an electron transport region ETR and a second electrode EL2, stacked in order.

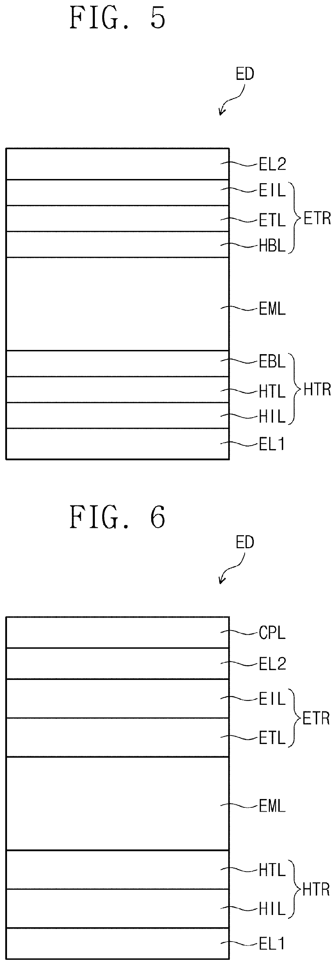

When compared to FIG. 3, FIG. 4 shows the cross-sectional view of a light emitting element ED of an embodiment, wherein a hole transport region HTR includes a hole injection layer HIL and a hole transport layer HTL, and an electron transport region ETR includes an electron injection layer EIL and an electron transport layer ETL. In some embodiments, when compared to FIG. 3, FIG. 5 shows the cross-sectional view of a light emitting element ED of an embodiment, wherein a hole transport region HTR includes a hole injection layer HIL, a hole transport layer HTL, and an electron blocking layer EBL, and an electron transport region ETR includes an electron injection layer EIL, an electron transport layer ETL, and a hole blocking layer HBL. When compared to FIG. 4, FIG. 6 shows the cross-sectional view of a light emitting element ED of an embodiment, including a capping layer CPL disposed on the second electrode EL2.

The first electrode EL1 has conductivity. The first electrode EL1 may be formed using a metal material, a metal alloy and/or a conductive compound. The first electrode EL1 may be an anode or a cathode. However, an embodiment of the present disclosure is not limited thereto. In some embodiments, the first electrode EL1 may be a pixel electrode. The first electrode EL1 may be a transmissive electrode, a transflective electrode, or a reflective electrode. The first electrode EL1 may include at least one selected from among Ag, Mg, Cu, Al, Pt, Pd, Au, Ni, Nd, Ir, Cr, Li, Ca, LiF, Mo, Ti, W, In, Sn, Zn, compounds comprising one or more of the foregoing elements, combinations of two or more of the foregoing elements or compounds, mixtures of two or more of the foregoing elements or compounds, and oxides thereof.

When the first electrode EL1 is the transmissive electrode, the first electrode EL1 may include a transparent metal oxide such as indium tin oxide (ITO), indium zinc oxide (IZO), zinc oxide (ZnO), and/or indium tin zinc oxide (ITZO). When the first electrode EL1 is the transflective electrode or the reflective electrode, the first electrode EL1 may include Ag, Mg, Cu, Al, Pt, Pd, Au, Ni, Nd, Ir, Cr, Li, Ca, LiF/Ca (stacked structure of Li and F), LiF/Al (stacked structure of Li and Al), Mo, Ti, W, compounds thereof, or mixtures thereof (for example, a mixture of Ag and Mg). Also, the first electrode EL1 may have a structure including multiple layers including a reflective layer or a transflective layer formed using the above materials, and a transmissive conductive layer formed using ITO, IZO, ZnO, or ITZO. For example, the first electrode EL1 may have a three-layer structure of ITO/Ag/ITO. However, an embodiment of the present disclosure is not limited thereto. The first electrode EL1 may include the above-described metal materials, combinations of two or more metal materials selected from the above-described metal materials, or oxides of the above-described metal materials. The thickness of the first electrode EL1 may be from about 700 Å to about 10,000 Å. For example, the thickness of the first electrode EL1 may be from about 1,000 Å to about 3,000 Å.

The hole transport region HTR is provided on the first electrode EL1. The hole transport region HTR may include at least one selected from a hole injection layer HIL, a hole transport layer HTL, a buffer layer, an emission auxiliary layer, and an emission blocking layer EBL. The thickness of the hole transport region HTR may be, for example, about 50 Å to about 15,000 Å.

The hole transport region HTR may have a single layer formed using a single material, a single layer formed using multiple different materials, or a multilayer structure including multiple layers formed using multiple different materials.

For example, the hole transport region HTR may have the structure of a single layer of a hole injection layer HIL or a hole transport layer HTL, and may have a structure of a single layer formed using a hole injection material and a hole transport material. In some embodiments, the hole transport region HTR may have a structure of a single layer formed using multiple different materials, or a structure stacked from the first electrode EL1 of hole injection layer HIL/hole transport layer HTL, hole injection layer HIL/hole transport layer HTL/buffer layer, hole injection layer HIL/buffer layer, hole transport layer HTL/buffer layer, or hole injection layer HIL/hole transport layer HTL/electron blocking layer EBL, without limitation.

The hole transport region HTR may be formed using one or more suitable methods such as a vacuum deposition method, a spin coating method, a cast method, a Langmuir-Blodgett (LB) method, an inkjet printing method, a laser printing method, and/or a laser induced thermal imaging (LITI) method.

The hole transport region HTR may include a compound represented by Formula H-1.

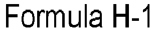

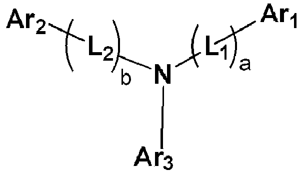

In Formula H-1, L₁ and L₂ may each independently be a direct linkage, a substituted or unsubstituted arylene group of 6 to 30 ring-forming carbon atoms, or a substituted or unsubstituted heteroarylene group of 2 to 30 ring-forming carbon atoms. "a" and "b" may each independently be an integer from 0 to 10. In some embodiments, when "a" or "b" is an integer of 2 or more, multiple L₁s and L₂s may each independently be a substituted or unsubstituted arylene group of 6 to 30 ring-forming carbon atoms, or a substituted or unsubstituted heteroarylene group of 2 to 30 ring-forming carbon atoms.

In Formula H-1, Ar₁ and Ar₂ may each independently be a substituted or unsubstituted aryl group of 6 to 30 ring-forming carbon atoms, or a substituted or unsubstituted heteroaryl group of 2 to 30 ring-forming carbon atoms. In some embodiments, in Formula H-1, Ar₃ may be a substituted or unsubstituted aryl group of 6 to 30 ring-forming carbon atoms.

The compound represented by Formula H-1 may be a monoamine compound. Or, the compound represented by Formula H-1 may be a diamine compound in which at least one among Ar₁ to Ar₃ includes an amine group as a substituent. In some embodiments, the compound represented by Formula H-1 may be a carbazole-based compound in which at least one selected from among Ar₁ and Ar₂ includes a substituted or unsubstituted carbazole group, or a fluorene-based compound in which at least one selected from among Ar₁ and Ar₂ includes a substituted or unsubstituted fluorene group.

The compound represented by Formula H-1 may be represented by one selected from among the compounds in Compound Group H. However, the compounds shown in Compound Group H are merely illustrations (examples), and the compound represented by Formula H-1 is not limited to the compounds represented in Compound Group H.

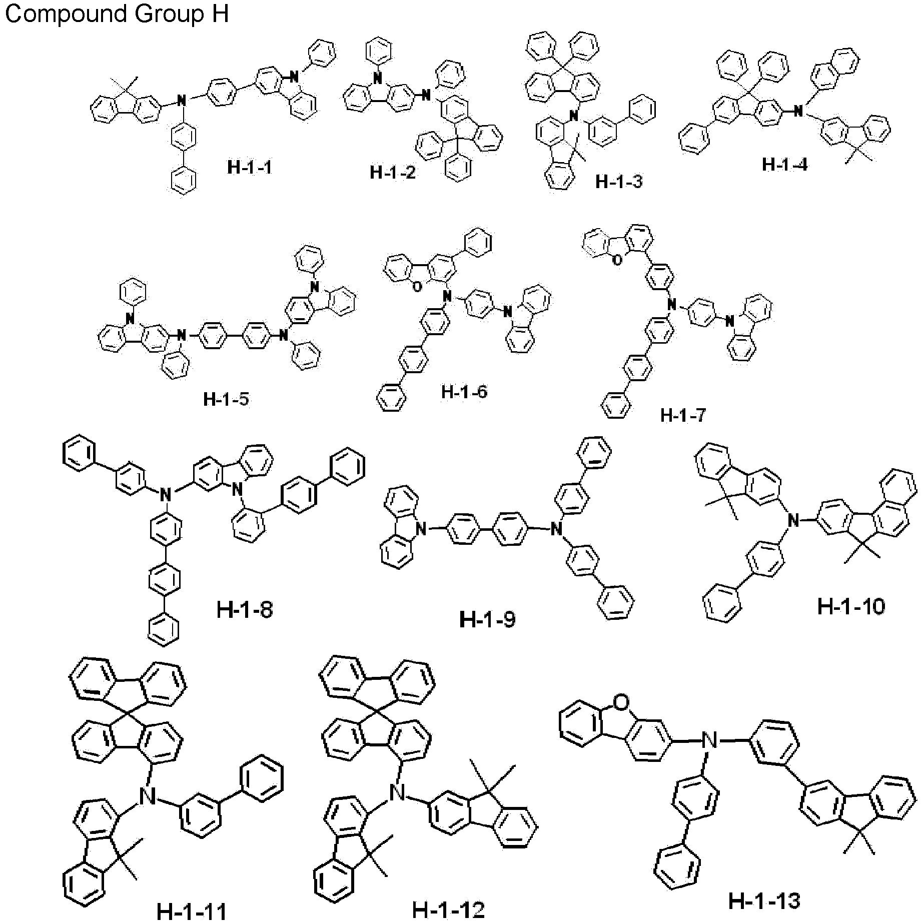

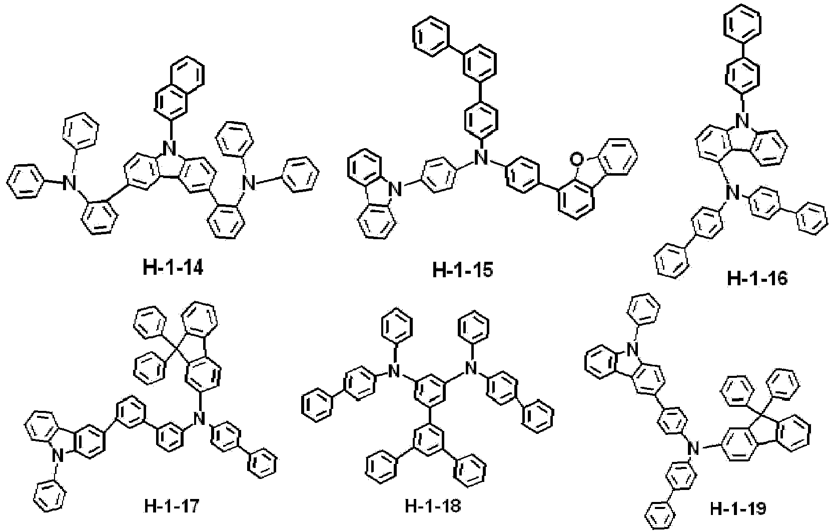

The hole transport region HTR may include a phthalocyanine compound such as copper phthalocyanine, N¹,N¹'-([1,1'-biphenyl]-4,4'-diyl)bis(N¹-phenyl-N⁴,N⁴-di-m-tolylbenzene-1,4-diamine) (DNTPD), 4,4',4"-[tris(3-methylphenyl)phenylamino] triphenylamine (m-MTDATA), 4,4',4"-tris(N,N-diphenylamino)triphenylamine (TDATA), 4,4',4"-tris[N(2-naphthyl)-N-phenylamino]-triphenylamine (2-TNATA), poly(3,4-ethylenedioxythiophene)/poly(4-styrenesulfonate) (PEDOT/PSS), polyaniline/dodecylbenzenesulfonic acid (PANI/DBSA), polyaniline/camphor sulfonic acid (PANI/CSA), polyaniline/poly(4-styrenesulfonate) (PANI/PSS), N,N'-di(1-naphthalene-1-yl)-N,N'-diphenyl-benzidine (NPB or NPD), triphenylamine-containing polyetherketone (TPAPEK), 4-isopropyl-4'-methyldiphenyliodonium [tetrakis(pentafluorophenyl)borate], and dipyrazino[2,3-f:2',3'-h] quinoxaline-2,3,6,7,10,11-hexacarbonitrile (HAT-CN).

The hole transport region HTR may include carbazole derivatives such as N-phenyl carbazole and polyvinyl carbazole, fluorene-based derivatives, N,N'-bis(3-methylphenyl)-N,N'-diphenyl-[1,1'-biphenyl]-4,4'-diamine (TPD), triphenylamine-based derivatives such as 4,4',4"-tris(N-carbazolyl)triphenylamine (TCTA), N,N'-di(1-naphthalene-1-yl)-N,N'-diphenyl-benzidine (NPB), 4,4'-cyclohexylidene bis[N,N-bis(4-methylphenyl)benzeneamine] (TAPC), 4,4'-bis[N,N'-(3-tolyl)amino]-3,3'-dimethylbiphenyl (HMTPD), 1,3-bis(N-carbazolyl)benzene (mCP), etc.

In some embodiments, the hole transport region HTR may include 9-(4-tert-butylphenyl)-3,6-bis(triphenylsilyl)-9H-carbazole (CzSi), 9-phenyl-9H-3,9'-bicarbazole (CCP), 1,3-bis(1,8-dimethyl-9H-carbazol-9-yl)benzene (mDCP), etc.

The hole transport region HTR may include the compounds of the hole transport region in at least one selected from among the hole injection layer HIL, hole transport layer HTL, and electron blocking layer EBL. The thickness of the hole transport region HTR may be from about 100 Å to about 10,000 Å, for example, from about 100 Å to about 5,000 Å. In an embodiment in which the hole transport region HTR includes a hole injection layer HIL, the thickness of the hole injection region HIL may be, for example, from about 30 Å to about 1,000 Å. In an embodiment in which the hole transport region HTR includes a hole transport layer HTL, the thickness of the hole transport layer HTL may be from about 30 Å to about 1,000 Å. For example, in an embodiment in which the hole transport region HTR includes an electron blocking layer, the thickness of the electron blocking layer EBL may be from about 10 Å to about 1,000 Å. When the thicknesses of the hole transport region HTR, the hole injection layer HIL, the hole transport layer HTL and the electron blocking layer EBL satisfy the above-described ranges, satisfactory (suitable) hole transport properties may be achieved without substantial increase of a driving voltage.

The hole transport region HTR may further include a charge generating material to increase conductivity in addition to the above-described materials. The charge generating material may be dispersed substantially uniformly or non-uniformly in the hole transport region HTR. The charge generating material may be, for example, a p-dopant. The p-dopant may include at least one selected from metal halide compounds, quinone derivatives, metal oxides, and cyano group-containing compounds, without limitation. For example, the p-dopant may include metal halide compounds such as Cui and Rbl, quinone derivatives such as tetracyanoquinodimethane (TCNQ) and 2,3,5,6-tetrafluoro-7,7',8,8-tetracyanoquinodimethane (F4-TCNQ), metal oxides such as tungsten oxide and molybdenum oxide, cyano group-containing compounds such as dipyrazino[2,3-f: 2',3'-h] quinoxaline-2,3,6,7,10,11-hexacarbonitrile (HAT-CN) and 4-[[2,3-bis[cyano-(4-cyano-2,3,5,6-tetrafluorophenyl)methylidene]cyclopropylidene]-cyanomethyl]-2,3,5,6-tetrafluorobenzonitrile (NDP9), etc., without limitation.

As described above, the hole transport region HTR may further include at least one selected from among a buffer layer and an electron blocking layer EBL in addition to the hole injection layer HIL and the hole transport layer HTL. The buffer layer may compensate resonance distance according to the wavelength of light emitted from an emission layer EML and may increase emission efficiency. As materials included in the buffer layer, materials which may be included in the hole transport region HTR may be used. The electron blocking layer EBL is a layer playing the role of blocking (reducing) the injection of electrons from the electron transport region ETR to the hole transport region HTR.

The emission layer EML is provided on the hole transport region HTR. The emission layer EML may have a thickness of, for example, about 100 Å to about 1,000 Å or about 100 Å to about 300 Å. The emission layer EML may have a single layer formed using a single material, a single layer formed using multiple different materials, or a multilayer structure having multiple layers formed using multiple different materials.

In the light emitting element ED of an embodiment, the emission layer EML may include a first compound, and at least one selected from among second to fourth compounds. The first compound to the fourth compound may be different from each other. The first compound may be an organometallic compound represented by Formula 1.

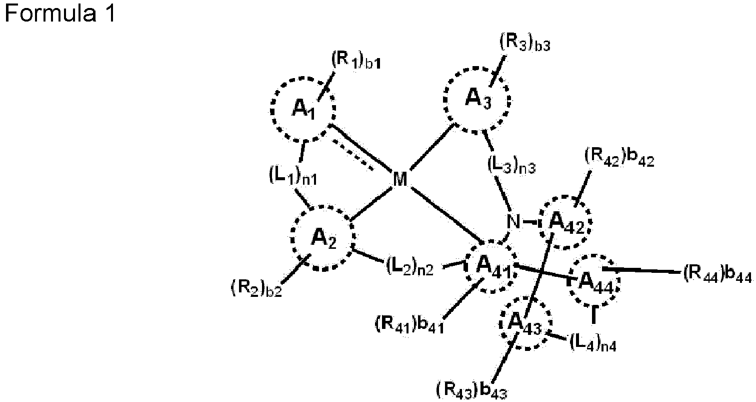

In Formula 1, M may be Pt, Pd, Cu, Ag, Au, Rh, Ir, Ru or Os. A₁ to A₃, and A₄₁ to A₄₄ may each independently be a hydrocarbon ring of 5 to 60 ring-forming carbon atoms, or a heterocycle of 1 to 60 carbon atoms. A₁ to A₃ may all be the same, or at least one may be different from the remainder. A₄₁ to A₄₄ may all be the same, or at least one may be different from the remainder.

R₁ to R₃, and R₄₁ to R₄₄ may each independently be a hydrogen atom, a deuterium atom, a halogen atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 3 to 30 ring-forming carbon atoms. For example, R₁ to R₃, and R₄₁ to R₄₄ may each independently be a hydrogen atom, a deuterium atom, a substituted or unsubstituted methyl group, a substituted or unsubstituted t-butyl group, or a substituted or unsubstituted phenyl group. R₁ to R₃ may all be the same, or at least one may be different from the remainder. R₄₁ to R₄₄ may all be the same, or at least one may be different from the remainder.

b1 to b3 may each independently be an integer from 0 to 4. When b1 is an integer of 2 or more, multiple R₁ may all be the same, or at least one R₁ may be different from the remainder. When b2 and b3 are integers of 2 or more, the same contents (rules/criteria) on the relation between b1 and R₁ may be applied to the relation between b2 and R₂, and the relation between b3 and R₃.

b41 to b44 may each independently be an integer of 0 to 4. If b41 is an integer of 2 or more, multiple R₄₁ may be all the same, or at least one R₁ may be different from the remainder. If b42 to b44 are integers of 2 or more, the same contents (rules/criteria) on the relation between b41 and R₄₁ may be applied to the relation between b42 and R₄₂, the relation between b43 and R₄₃, and the relation between b44 and R₄₄.

L₁ to L₄ may each independently be selected from among a direct linkage, *-O-*', *-S-*', *-C(R₁₁)(R₁₂)-*', *-C(R₁₃)=*', *-C(R₁₄)=C(R₁₅)-*', *-C(=O)-*', *-C(=S)-*', *-C≡C-*', *-B(R₁₆)-*', *-N(R₁₇)-*', *-P(R₁₈)(R₁₉)-*', *-Si(R₂₀)(R₂₁)-*', and *-Ge(R₂₂)(R₂₃)-*'. L₁ to L₄ may be all the same, or at least one may be different from the remainder.

R₁₁ to R₂₃ may each independently be a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms. R₁₁ to R₂₃ may be all the same, or at least one may be different from the remainder.

n1 and n3 may each independently be an integer of 0 to 3. When n1 is 0, A₁ and A₂ may not be combined. When n1 is an integer of 2 or more, multiple L₁ may be all the same, or at least one may be different from the remainder. When n3 is 0, A₃ and 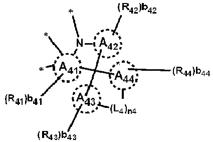 may not be combined. If n3 is an integer of 2 or more, multiple L₃ may be all the same, or at least one may be different from the remainder.

n2 and n4 may each independently be an integer from 1 to 3. When n2 is an integer of 2 or more, multiple L₂s may be all the same, or at least one may be different from the remainder. When n4 is an integer of 2 or more, multiple L₄s may be all the same, or at least one may be different from the remainder.

In Formula 1, " 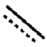 " may be a single bond or a double bond. For example, if " 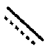 " is a single bond, M and A₁ may be combined via a single bond, and if " 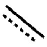 " is a double bond, M and A₂ may be combined via a double bond.

Formula 1 may be represented by Formula 2 below. Formula 2 corresponds to Formula 1 in which M, A₄₁ to A₄₄, L₂, and n2 are embodied (contained).

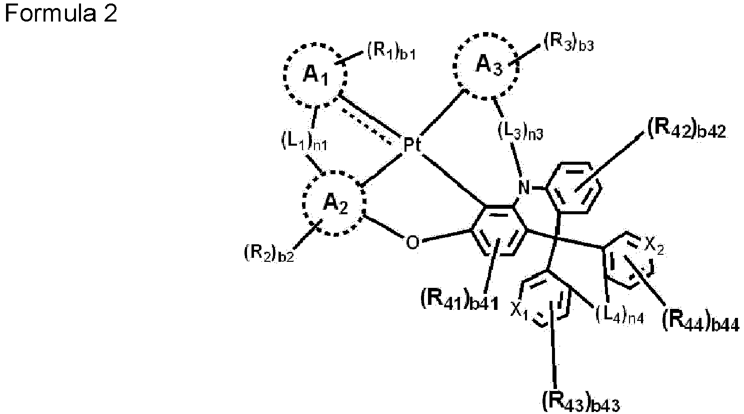

In Formula 2, X₁ and X₂ may each independently be CRa, or N. X₁ and X₂ may be the same or different from each other. Ra may be a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms.

In Formula 2, the same explanations (rules/criteria) regarding A₁ to A₃, n1 to n4, L₁ to L₄, b1 to b3, b41 to b44, R₁ to R₃, and R₄₁ to R₄₄ defined in Formula 1 may be applied. In some embodiments, b41 in Formula 2 may be an integer from 0 to 2.

Formula 2 may be represented by Formula 3-1 or Formula 3-2. Formula 3-1 corresponds to Formula 2 in which X₁ and X₂ are "CH". Formula 3-2 corresponds to Formula 2 in which X₁ and X₂ are "N".

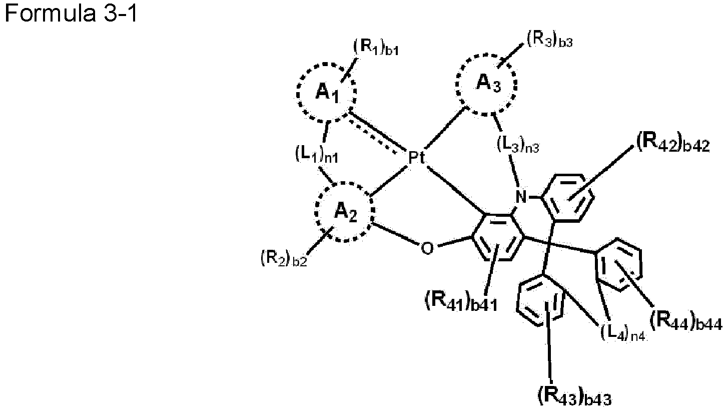

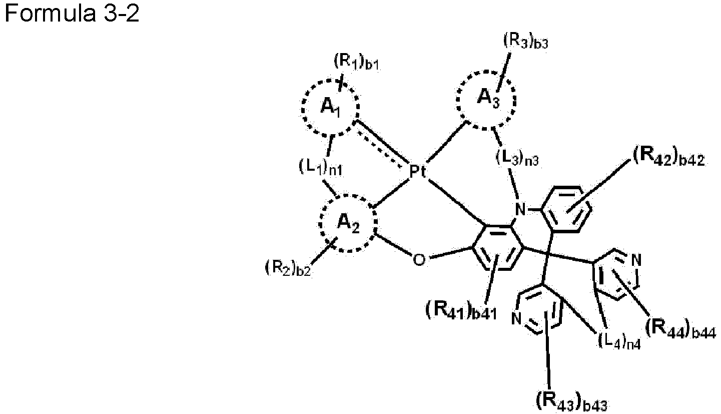

In Formula 3-1 and Formula 3-2, the same explanations (rules/criteria) regarding A₁ to A₃, n1, n3, n4, L₁, L₃, L₄, b1 to b3, b41 to b44, R₁ to R₃, and R₄₁ to R₄₄ defined in Formula 1 may be applied. in some embodiments, in Formula 3-2, R₄₃ and R₄₄ may be hydrogen atoms. In some embodiments, b41 in Formula 3-1 and Formula 3-2 may be an integer from 0 to 2.

Formula 3-1 may be represented by Formula 3A or Formula 3B below. Formula 3A corresponds to Formula 3-1 in the embodiment in which n4 is 1, and L₄ is a direct linkage. Formula 3B corresponds to Formula 3-1 in the embodiment in which n4 is 1, and L₄ is NR₁₇.

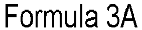

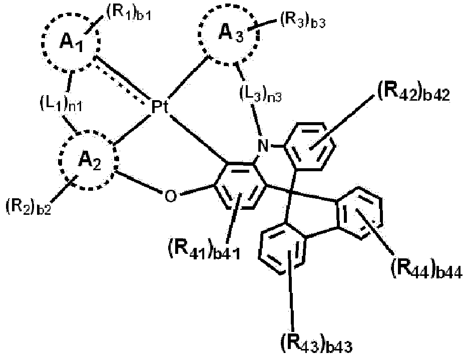

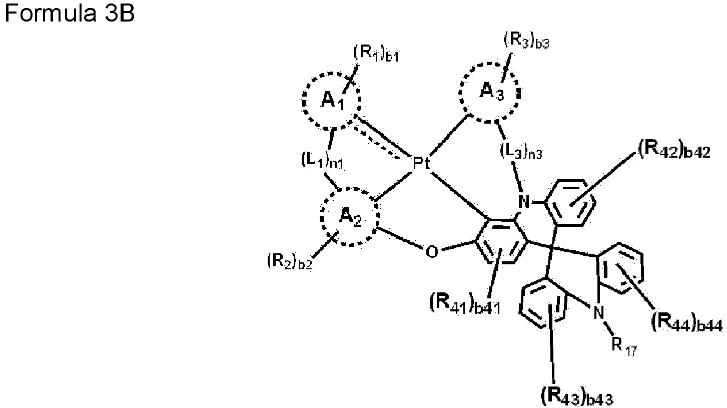

In Formula 3A and Formula 3B, the same explanations (rules/criteria) regarding A₁ to A₃, n1, n3, n4, L₁, L₃, b1 to b3, b41 to b44, R₁ to R₃, R₄₁ to R₄₄, and R₁₇ defined in Formula 1 may be applied. In some embodiments, in Formula 3B, R₁₇ may be a substituted or unsubstituted phenyl group. In some embodiments, b41 in Formula 3A and Formula 3B may be an integer from 0 to 2.

Formula 2 may be represented by Formula 4. Formula 4 corresponds to Formula 2 where A₁ to A₃ are embodied (contained).

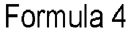

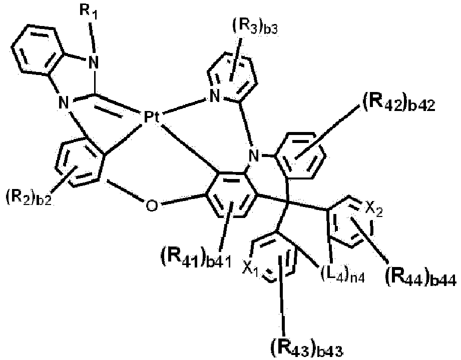

In Formula 4, the same explanations (rules/criteria) regarding n4, L₄, b2, b3, b41 to b44, R₁ to R₃, R₄₁ to R₄₄, X₁, and X₂ defined in Formula 2 may be applied. In some embodiments, b41 in Formula 4 may be an integer from 0 to 2.

Formula 1 may be represented by any one among the compounds in Compound Group 1.

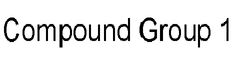

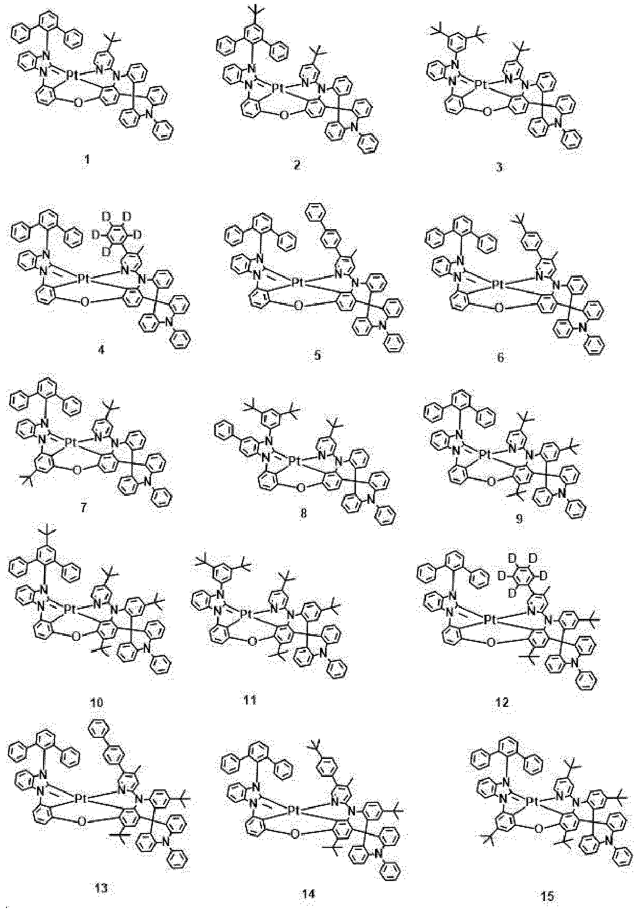

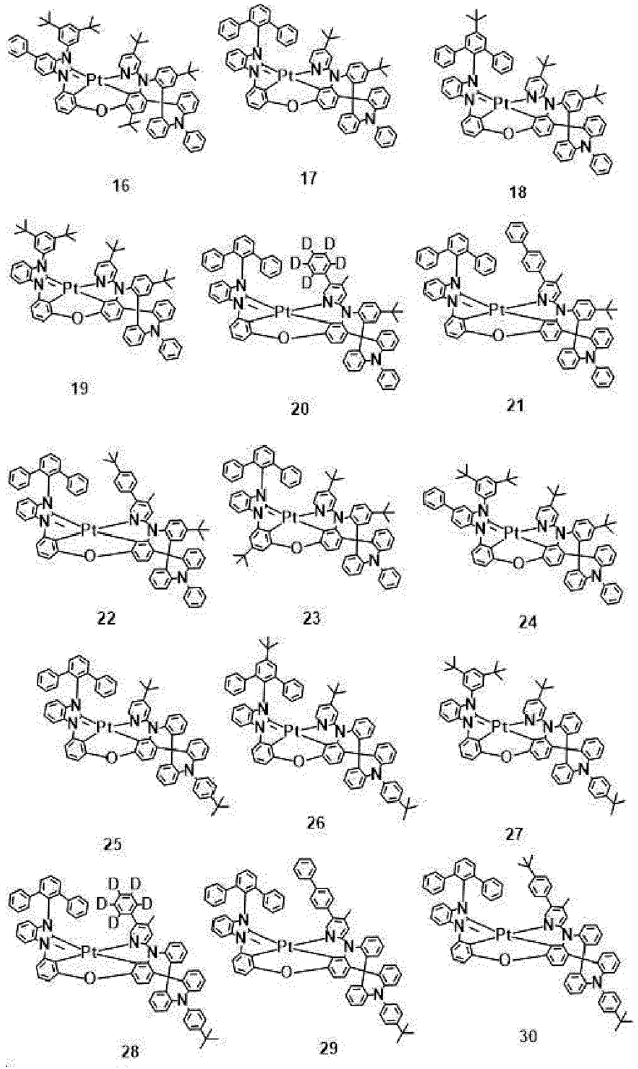

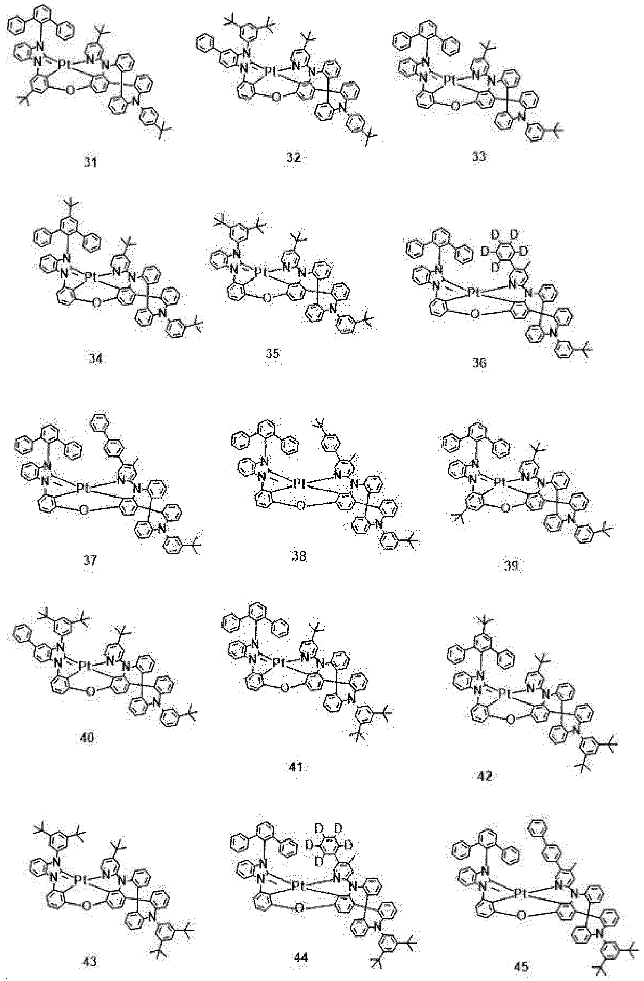

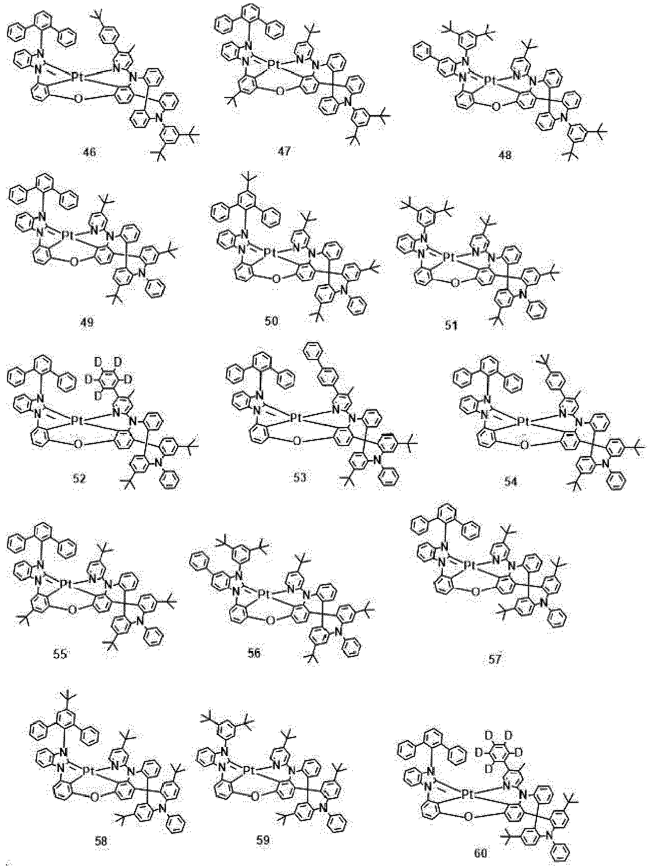

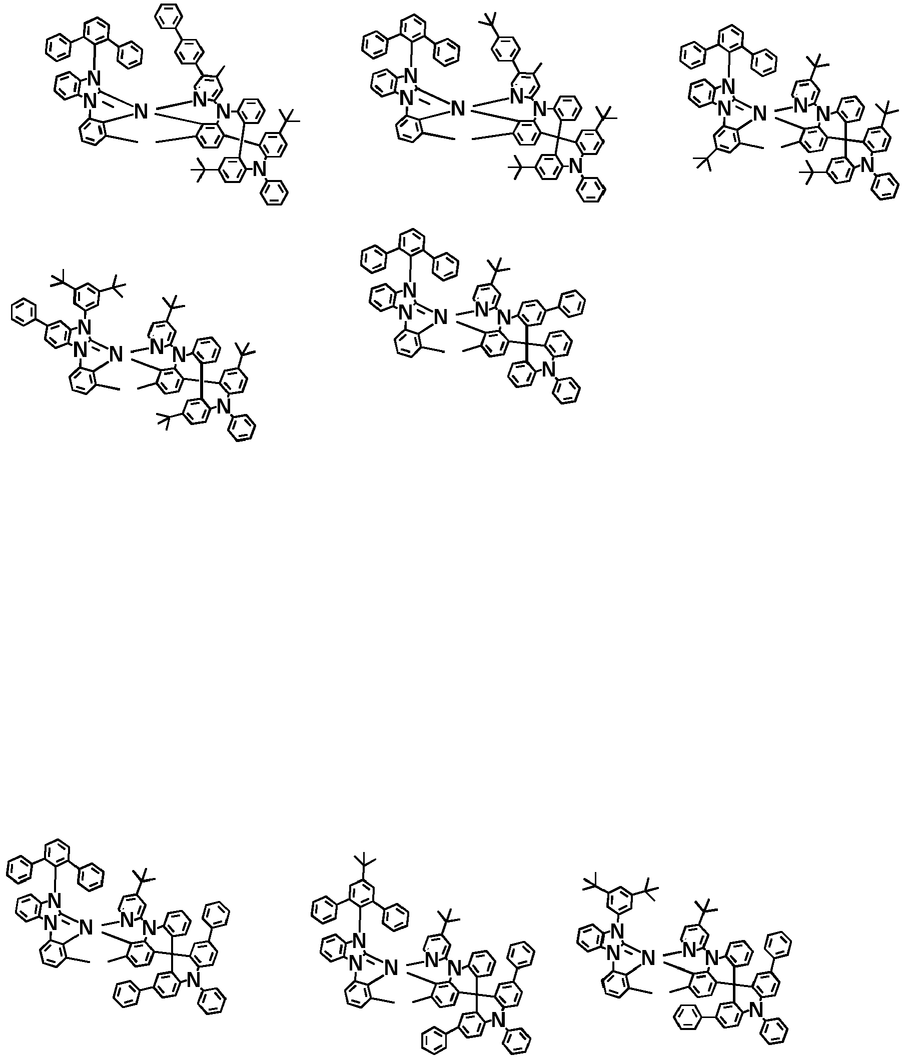

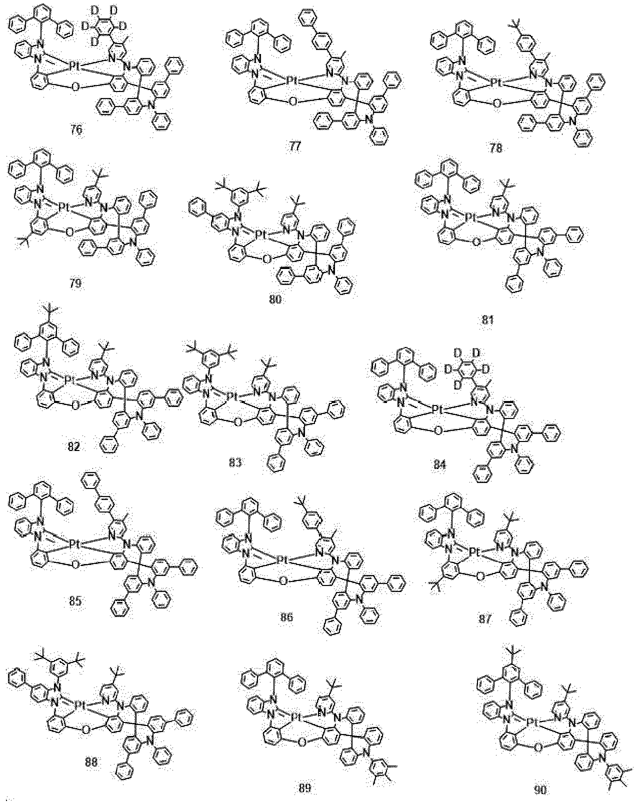

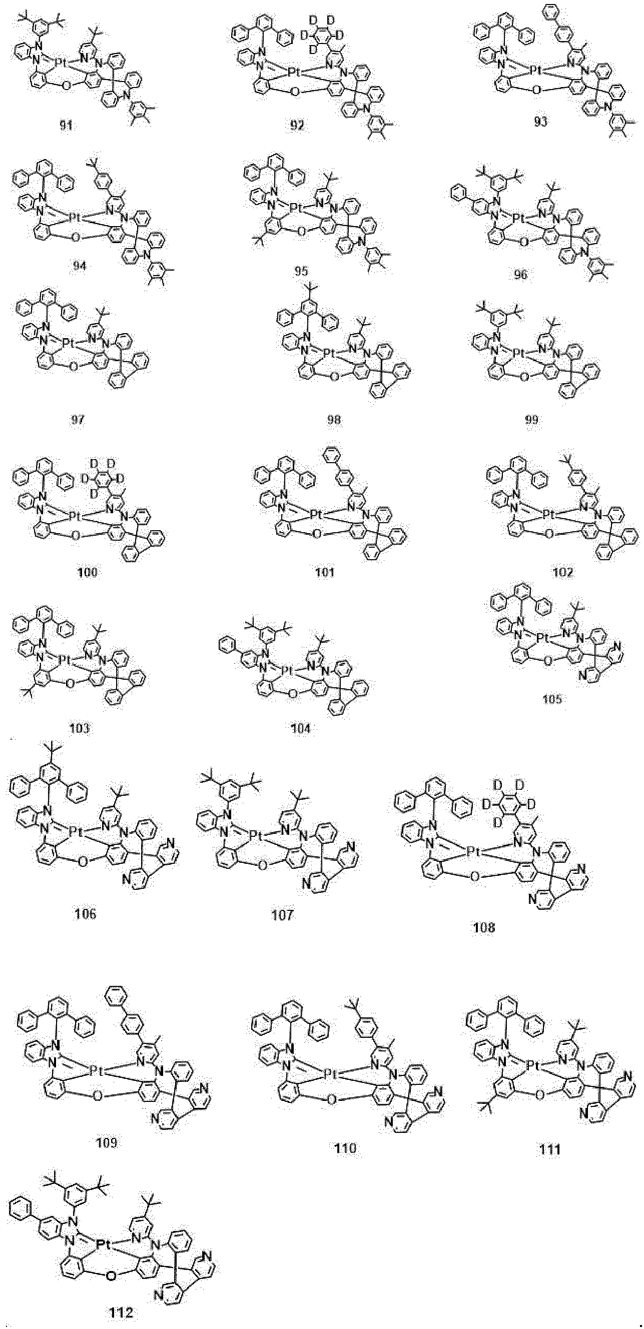

The organometallic compound of an embodiment may have a structure in which four ligands are bonded to a central metal, and any one among the ligands is spirobiacridine. The organometallic compound may have a structure in which spirobiacridine is bonded to a central metal, and may have a large metal to ligand charge transfer (³MLCT) value and a large metal centered state (³MC) value. The light emitting element ED of an embodiment may include an organometallic compound having a large ³MLCT value in an emission layer EML and may have excellent (suitable) color purity, high emission efficiency and long-life characteristics.

The organometallic compound of an embodiment, represented by Formula 1 may be used as a phosphorescence emitting material. For example, the organometallic compound of an embodiment may be used as a phosphorescence emitting dopant which emits blue light.

The organometallic compound of an embodiment may be a light emitting material having a light emitting central wavelength (λₘₐₓ) in a wavelength region of about 490 nm or less. For example, the organometallic compound of an embodiment, represented by Formula 1 may be a light emitting material having a light emitting central wavelength in a wavelength region of about 450 nm to about 470 nm. For example, the organometallic compound of an embodiment may be a blue phosphorescence dopant. However, an embodiment of the present disclosure is not limited thereto.

In the light emitting elements ED of embodiments shown in FIG. 3 to FIG. 6, an emission layer EML may include a host and a dopant, and the emission layer EML may include the organometallic compound of an embodiment as a light emitting dopant.

In the light emitting element ED of an embodiment, an emission layer EML may include a first compound to a third compound, which are different from each other. The first compound may be represented by Formula 1. The first compound may be a phosphorescence dopant, the second compound may be a first host, and the third compound may be a second host. In an embodiment, the second compound may be a hole transport host, and the third compound may be an electron transport host.

The light emitting element ED of an embodiment may include at least one compound among HT-1 to HT-4 in an emission layer EML as a hole transport host.

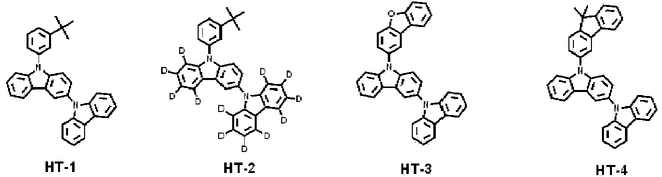

In some embodiments, the light emitting element ED may include at least one compound among ET-1 to ET-3 in an emission layer EML as an electron transport host.

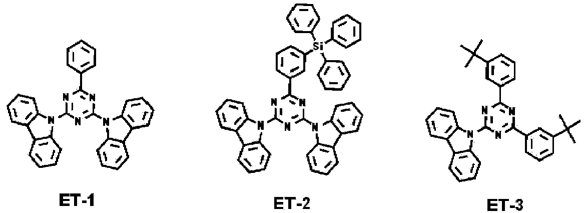

The electron transport host and the hole transport host may be combined to form an exciplex. The exciplex may transfer energy through energy transition to a phosphorescence dopant to arise (cause) light emission.

The triplet energy of the exciplex formed by the hole transport host and the electron transport host may correspond to a difference between the energy level of the lowest unoccupied molecular orbital (LUMO) of the electron transport host and the energy level of the highest occupied molecular orbital (HOMO) of the hole transport host. For example, the triplet energy of the exciplex formed by the hole transport host and the electron transport host in the light emitting element may be from about 2.4 eV to about 3.0 eV. In some embodiments, the triplet energy of the exciplex may be a value smaller than the energy gap of each host material. The energy gap may be a difference between the LUMO energy level and the HOMO energy level. For example, the energy gap of the hole transport host and the electron transport host may be about 3.0 eV or more, and the exciplex may have the triplet energy of about 3.0 eV or less.

In the light emitting element ED of an embodiment, the emission layer EML may include a fourth compound. For example, the fourth compound may be a delayed fluorescence dopant.

For example, the fourth compound may be a polycyclic compound including at least one electron-donor group having electron-donating properties, and at least one electron-withdrawing group having electron-withdrawing properties, or a fused ring compound which includes a boron (B) atom and two or more fused rings. For example, the electron-donor group may be a substituted or unsubstituted heteroaryl group of 3 to 60 ring-forming carbon atoms, including a pyridinic nitrogen atom. In some embodiments, the electron-withdrawing group may be a substituted or unsubstituted heteroaryl group of 1 to 60 ring-forming carbon atoms, including a sulfoxide group, a cyano group or a pyrrolic nitrogen atom.

For example, the fourth compound may include at least one selected from among Compounds DF1 to DF9, and DFD1.

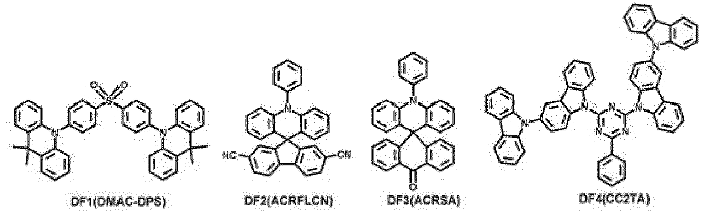

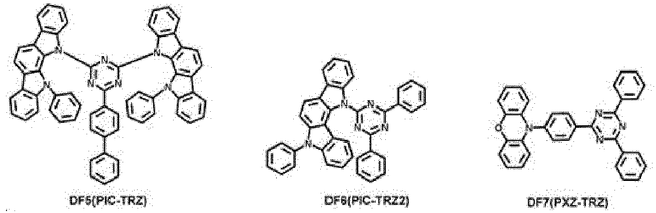

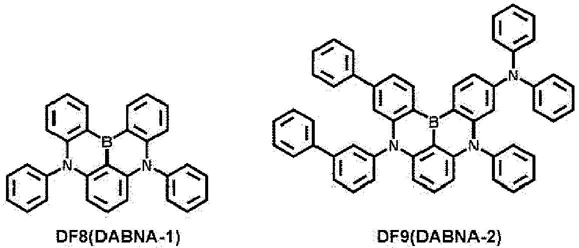

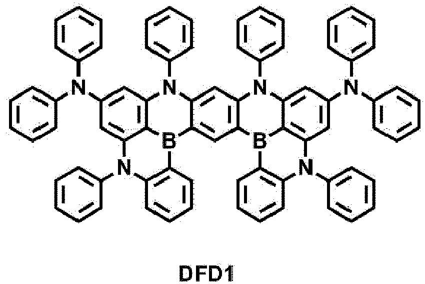

The light emitting element ED of an embodiment may further include a material for an emission layer described below, in addition to the organometallic compound of an embodiment, the first and second hosts, and the delayed fluorescence dopant. In the light emitting element ED of an embodiment, the emission layer EML may include anthracene derivatives, pyrene derivatives, fluoranthene derivatives, chrysene derivatives, dihydrobenzanthracene derivatives, or triphenylene derivatives. For example, the emission layer EML may include anthracene derivatives or pyrene derivatives.

In the light emitting elements ED of embodiments, shown in FIG. 3 to FIG. 6, the emission layer EML may include a host and a dopant, and the emission layer EML may include a compound represented by Formula E-1. The compound represented by Formula E-1 may be used as a fluorescence host material.

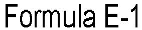

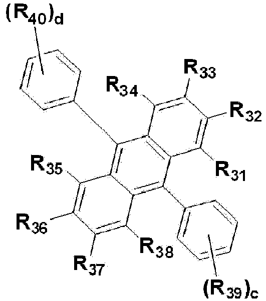

In Formula E-1, R₃₁ to R₄₀ may each be independently a hydrogen atom, a deuterium atom, a halogen atom, a substituted or unsubstituted silyl group, a substituted or unsubstituted thio group, a substituted or unsubstituted oxy group, a substituted or unsubstituted alkyl group of 1 to 10 carbon atoms, a substituted or unsubstituted alkenyl group of 1 to 10 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. In some embodiments, R₃₁ to R₄₀ may be combined with an adjacent group to form a saturated hydrocarbon ring, an unsaturated hydrocarbon ring, a saturated heterocycle, or an unsaturated heterocycle.

In Formula E-1, "c" and "d" may each independently be an integer from 0 to 5.

Formula E-1 may be represented by any one among Compound E1 to Compound E19.

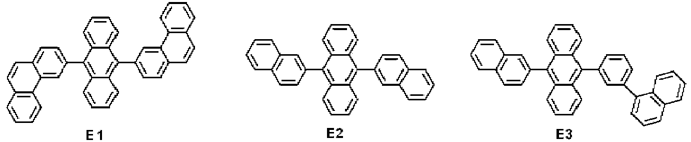

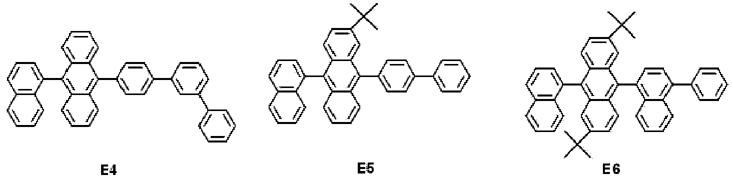

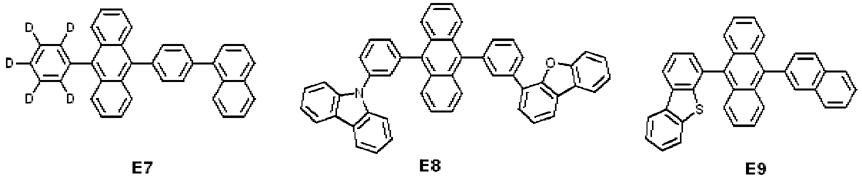

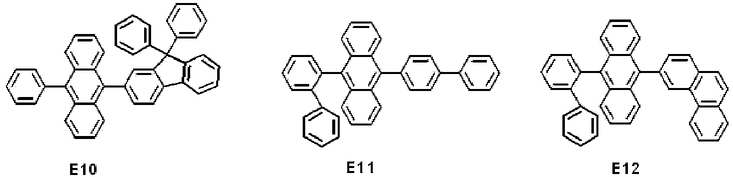

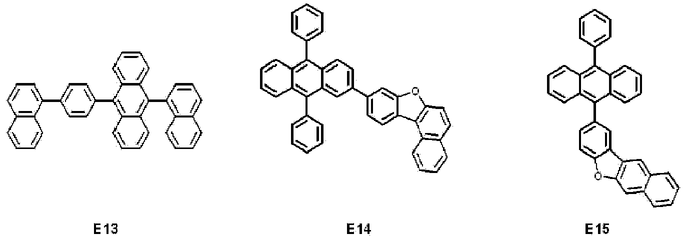

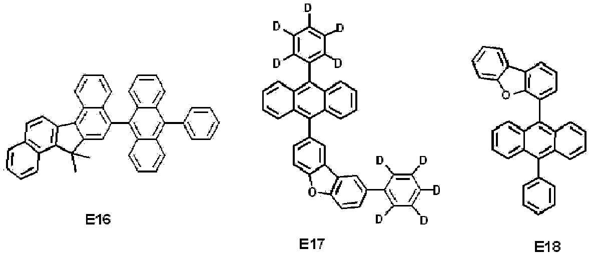

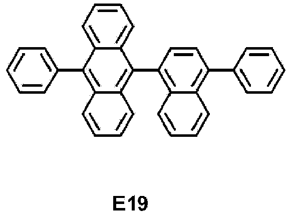

In an embodiment, the emission layer EML may include a compound represented by Formula E-2a or Formula E-2b. The compound represented by Formula E-2a or Formula E-2b may be used as a phosphorescence host material.

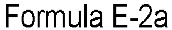

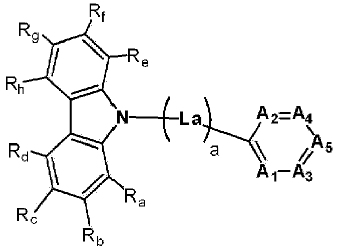

In Formula E-2a, "a" may be an integer from 0 to 10, La may be a direct linkage, a substituted or unsubstituted arylene group of 6 to 30 ring-forming carbon atoms, or a substituted or unsubstituted heteroarylene group of 2 to 30 ring-forming carbon atoms. In some embodiments, when "a" is an integer of 2 or more, multiple Las may each independently be a substituted or unsubstituted arylene group of 6 to 30 ring-forming carbon atoms, or a substituted or unsubstituted heteroarylene group of 2 to 30 ring-forming carbon atoms.

In some embodiments, in Formula E-2a, A₁ to A₅ may each independently be N or CRi. Rₐ to Rᵢ may each independently be a hydrogen atom, a deuterium atom, a substituted or unsubstituted amine group, a substituted or unsubstituted thio group, a substituted or unsubstituted oxy group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. Rₐ to Rᵢ may be combined with an adjacent group to form a hydrocarbon ring or a heterocycle including N, O, S, etc. as a ring-forming atom.

In some embodiments, in Formula E-2a, two or three selected from A₁ to A₅ may be N, and the remainder may be CRᵢ.

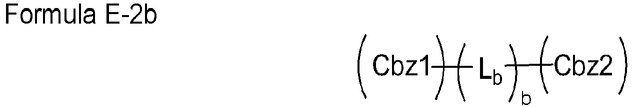

In Formula E-2b, Cbz1 and Cbz2 may each independently be an unsubstituted carbazole group, or a carbazole group substituted with an aryl group of 6 to 30 ring-forming carbon atoms. L_{b} may be a direct linkage, a substituted or unsubstituted arylene group of 6 to 30 ring-forming carbon atoms, or a substituted or unsubstituted heteroarylene group of 2 to 30 ring-forming carbon atoms, "b" is an integer from 0 to 10, and when "b" is an integer of 2 or more, multiple L_{b}s may each independently be a substituted or unsubstituted arylene group of 6 to 30 ring-forming carbon atoms, or a substituted or unsubstituted heteroarylene group of 2 to 30 ring-forming carbon atoms.

The compound represented by Formula E-2a or Formula E-2b may be represented by any one among the compounds in Compound Group E-2. However, the compounds shown in Compound Group E-2 are merely illustrations (examples), and the compound represented by Formula E-2a or Formula E-2b is not limited to the compounds represented in Compound Group E-2.

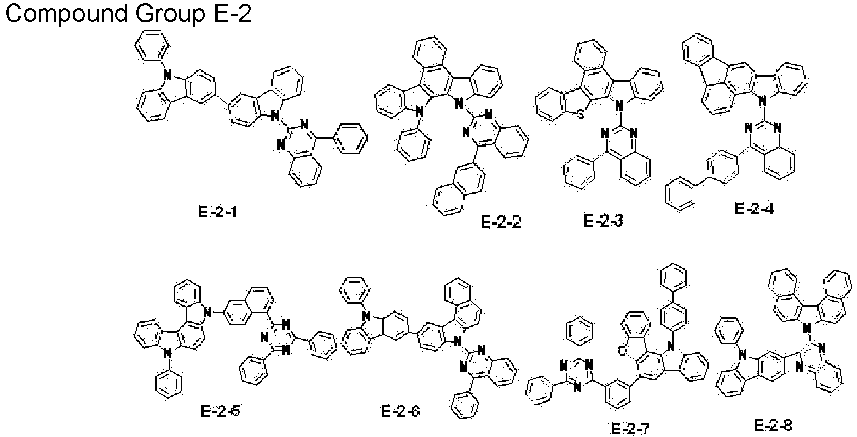

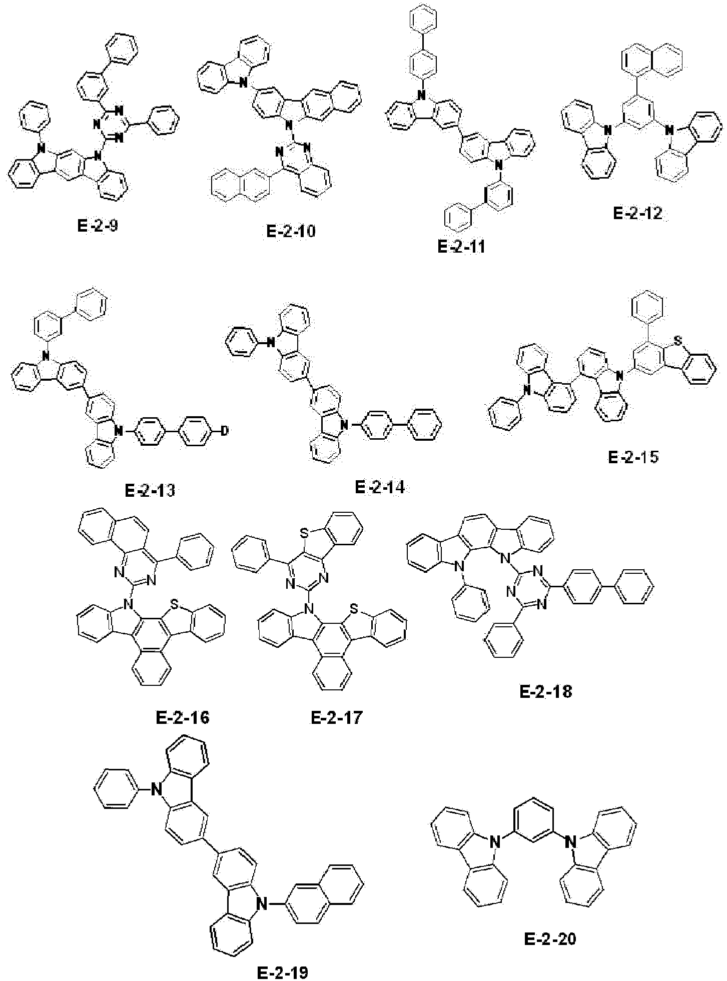

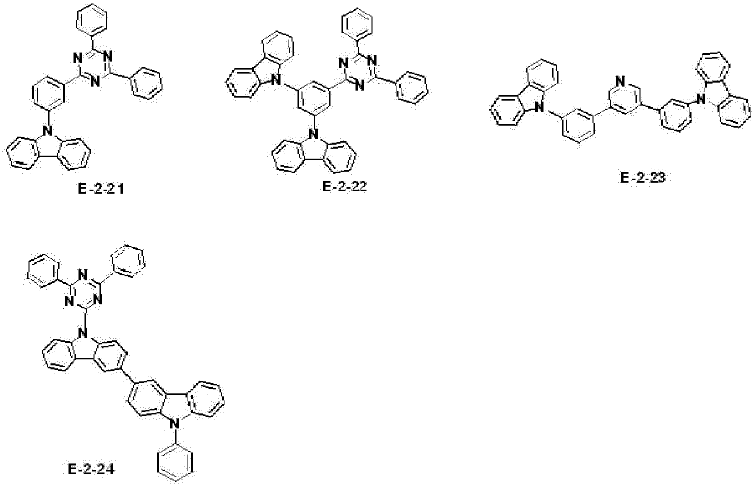

The emission layer EML may further include materials known in the art as host materials. For example, the emission layer EML may include as a host material, at least one selected from bis (4-(9H-carbazol-9-yl) phenyl) diphenylsilane (BCPDS), (4-(1-(4-(diphenylamino) phenyl) cyclohexyl) phenyl) diphenyl-phosphine oxide (POPCPA), bis[2-(diphenylphosphino)phenyl] ether oxide (DPEPO), 4,4'-bis(carbazol-9-yl)biphenyl (CBP), 1,3-bis(carbazol-9-yl)benzene (mCP), 2,8-bis(diphenylphosphoryl)dibenzo[b,d]furan (PPF), 4,4',4"-tris(carbazol-9-yl)-triphenylamine (TCTA), and 1,3,5-tris(1-phenyl-1H-benzo[d]imidazole-2-yl)benzene (TPBi). However, an embodiment of the present disclosure is not limited thereto. For example, tris(8-hydroxyquinolino)aluminum (Alqs), 9,10-di(naphthalene-2-yl)anthracene (ADN), 2-tert-butyl-9,10-di(naphth-2-yl)anthracene (TBADN), distyrylarylene (DSA), 4,4'-bis(9-carbazolyl)-2,2'-dimethyl-biphenyl (CDBP), 2-methyl-9,10-bis(naphthalen-2-yl)anthracene (MADN), hexaphenyl cyclotriphosphazene (CP1), 1,4-bis(triphenylsilyl)benzene (UGH2), hexaphenylcyclotrisiloxane (DPSiOs), octaphenylcyclotetra siloxane (DPSiO₄), etc. may be used as the host material.

The emission layer EML may further include a compound represented by Formula M-a. The compound represented by Formula M-a may be used as a phosphorescence dopant material.

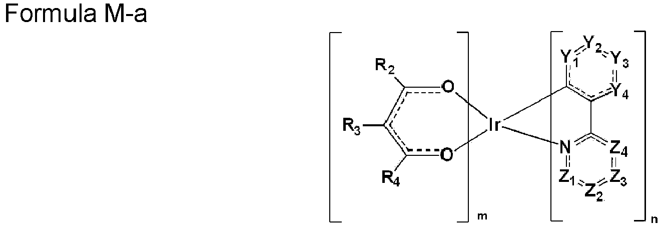

In Formula M-a, Y₁ to Y₄, and Z₁ to Z₄ may each independently be CR₁ or N, and R₁ to R₄ may each independently be a hydrogen atom, a deuterium atom, a substituted or unsubstituted amine group, a substituted or unsubstituted thio group, a substituted or unsubstituted oxy group, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. In Formula M-a, "m" may be 0 or 1, and "n" may be 2 or 3. In Formula M-a, when "m" is 0, "n" is 3, and when "m" is 1, "n" is 2.

The compound represented by Formula M-a may be represented by any one among Compounds M-a1 to M-a25. However, Compounds M-a1 to M-a25 below are illustrations (examples), and the compound represented by Formula M-a is not limited to the compounds represented by Compounds M-a1 to M-a25.

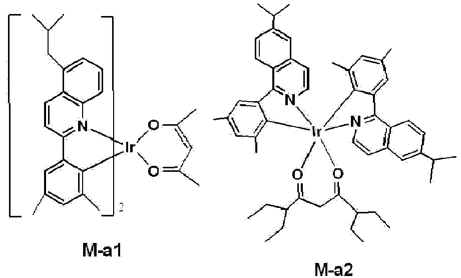

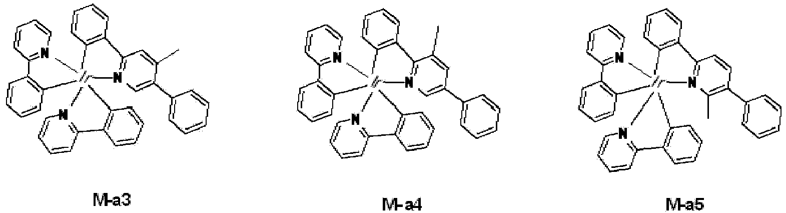

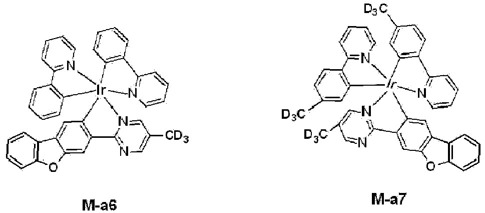

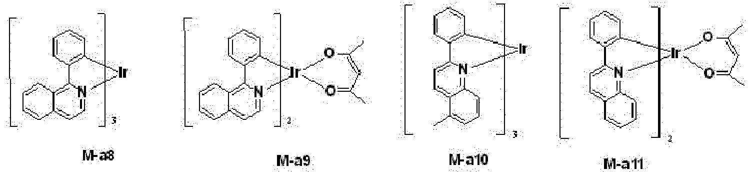

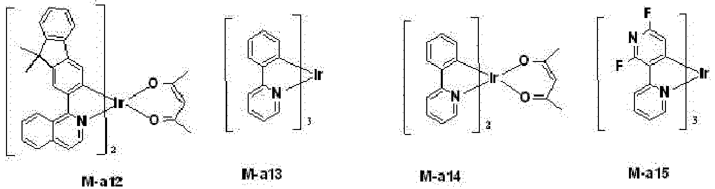

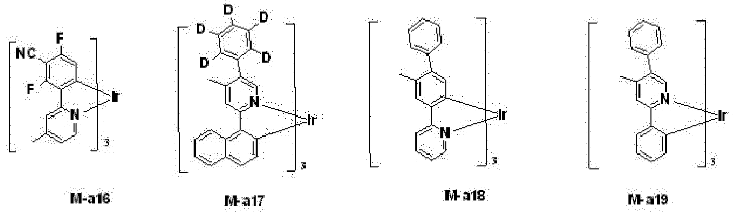

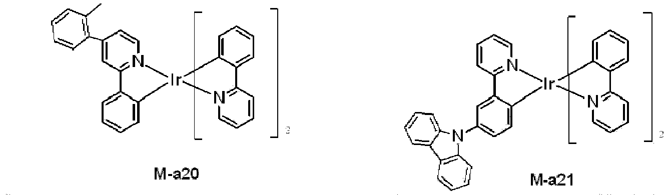

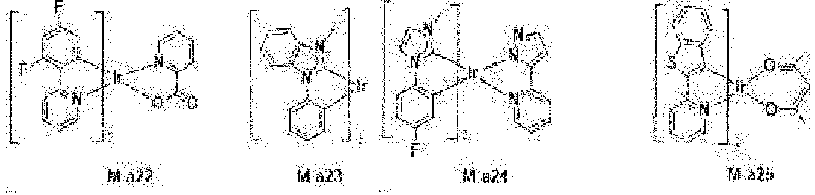

The emission layer EML may include any one among Formula F-a to Formula F-c. The compounds represented by Formula F-a to Formula F-c may be used as fluorescence dopant materials.

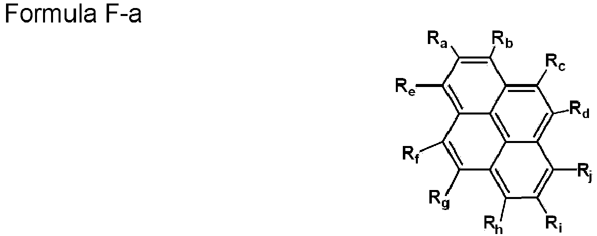

In Formula F-a, two selected from Rₐ to Rⱼ may each independently be substituted with ∗-NAr₁Ar₂. The remainder not substituted with ∗-NAr₁Ar₂ among Rₐ to Rⱼ may each independently be a hydrogen atom, a deuterium atom, a halogen atom, a cyano group, a substituted or unsubstituted amine group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In ∗-NAr₁Ar₂, Ar₁ and Ar₂ may each independently be a substituted or unsubstituted aryl group of 6 to 30 ring-forming carbon atoms, or a substituted or unsubstituted heteroaryl group of 2 to 30 ring-forming carbon atoms. For example, at least one among Ar₁ and Ar₂ may be a heteroaryl group including O and/or S as a ring-forming atom.

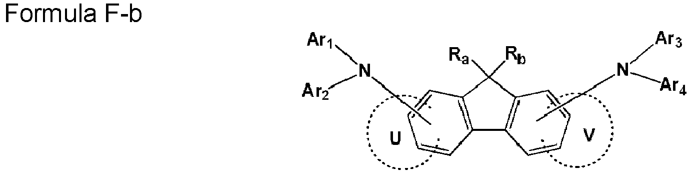

In Formula F-b, Rₐ and R_{b} may each independently be a hydrogen atom, a deuterium atom, a substituted or unsubstituted alkyl group of 1 to 20 carbon atoms, a substituted or unsubstituted alkenyl group of 2 to 20 carbon atoms, a substituted or unsubstituted aryl group of 6 to 30 ring-forming carbon atoms, or a substituted or unsubstituted heteroaryl group of 2 to 30 ring-forming carbon atoms, and/or may be combined with an adjacent group to form a ring. Ar₁ to Ar₄ may each be independently an aryl group of 6 to 30 ring-forming carbon atoms, or a substituted or unsubstituted heteroaryl group of 2 to 30 ring-forming carbon atoms.

In Formula F-b, U and V may each independently be a substituted or unsubstituted hydrocarbon ring of 5 to 30 ring-forming carbon atoms, or a substituted or unsubstituted heterocycle of 2 to 30 ring-forming carbon atoms.

In Formula F-b, the number of rings represented by U and V may each independently be 0 or 1. For example, in Formula F-b, when the number of U or V is 1, one ring forms a fused ring at the designated part by U or V, and when the number of U or V is 0, a ring is not present at the designated part by U or V. For example, when the number of U is 0, and the number of V is 1, or when the number of U is 1, and the number of V is 0, a fused ring having the fluorene core of Formula F-b may be a ring compound with four rings. In some embodiments, when the number of both U and V is 0, the fused ring of Formula F-b may be a ring compound with three rings. In some embodiments, when the number of both U and V is 1, a fused ring having the fluorene core of Formula F-b may be a ring compound with five rings.

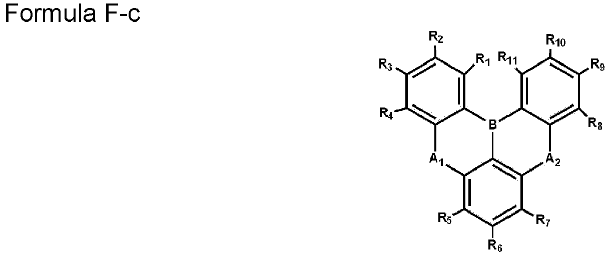

In Formula F-c, A₁ and A₂ may each independently be O, S, Se, or NRₘ, and Rₘ may be a hydrogen atom, a deuterium atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms. R₁ to R₁₁ may each independently be a hydrogen atom, a deuterium atom, a halogen atom, a cyano group, a substituted or unsubstituted amine group, a substituted or unsubstituted boryl group, a substituted or unsubstituted oxy group, a substituted or unsubstituted thio group, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms, and/or combined with an adjacent group to form a ring.

In Formula F-c, A₁ and A₂ may each independently be combined with the substituents of an adjacent ring to form a fused ring. For example, when A₁ and A₂ are each independently NRₘ, A₁ may be combined with R₄ or R₅ to form a ring. In some embodiments, A₂ may be combined with R₇ or R₈ to form a ring.

In an embodiment, the emission layer EML may include as a known dopant material, styryl derivatives (for example, 1,4-bis[2-(3-N-ethylcarbazoryl)vinyl]benzene (BCzVB), 4-(di-p-tolylamino)-4'-[(di-p-tolylamino)styryl]stilbene (DPAVB), N-(4-((E)-2-(6-((E)-4-(diphenylamino)styryl)naphthalen-2-yl)vinyl)phenyl)-N-phenylbenzenamine (N-BDAVBi), and 4,4'-bis[2-(4-(N,N-diphenylamino)phenyl)vinyl]biphenyl (DPAVBi)), perylene and the derivatives thereof (for example, 2,5,8,11-tetra-t-butylperylene (TBP)), pyrene and the derivatives thereof (for example, 1,1-dipyrene, 1,4-dipyrenylbenzene, and 1,4-bis(N,N-diphenylamino)pyrene), etc. The emission layer EML may further include a known phosphorescence dopant material. For example, the phosphorescence dopant may use a metal complex including iridium (Ir), platinum (Pt), osmium (Os), gold (Au), titanium (Ti), zirconium (Zr), hafnium (Hf), europium (Eu), terbium (Tb) or thulium (Tm). For example, iridium(III) bis(4,6-difluorophenylpyridinato-N,C2')picolinate (FIrpic), bis(2,4-difluorophenylpyridinato)-tetrakis(1-pyrazolyl)borate iridium(III) (Fir6), or platinum octaethyl porphyrin (PtOEP) may be used as the phosphorescence dopant. However, an embodiment of the present disclosure is not limited thereto.

The emission layer EML may include a quantum dot material. The core of the quantum dot may be selected from a II-VI group compound, a III-VI group compound, a I-III-VI group compound, a III-V group compound, a III-II-V group compound, a IV-VI group compound, a IV group element, a IV group compound, and one or more combinations thereof.

The II-VI group compound may be selected from the group including (e.g., consisting of): a binary compound selected from the group including (e.g., consisting of) CdSe, CdTe, CdS, ZnS, ZnSe, ZnTe, ZnO, HgS, HgSe, HgTe, MgSe, MgS, and one or more mixtures thereof; a ternary compound selected from the group including (e.g., consisting of) CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS, and one or more mixtures thereof; and a quaternary compound selected from the group including (e.g., consisting of) HgZnTeS, CdZnSeS, CdZnSeTe, CdZnSTe, CdHgSeS, CdHgSeTe, CdHgSTe, HgZnSeS, HgZnSeTe, HgZnSTe, and one or more mixtures thereof.

The III-VI group compound may include a binary compound such as In₂S₃, and/or In₂Se₃, a ternary compound such as InGaSs, and/or InGaSes, or one or more combinations thereof.

The I-III-VI group compound may be selected from a ternary compound selected from the group including (e.g., consisting of) AgInS, AgInS₂, CuInS, CuInS₂, AgGaS₂, CuGaS₂, CuGaO₂, AgGaO₂, AgAlO₂ and one or more mixtures thereof, or a quaternary compound such as AgInGaS₂, and CuInGaS₂.

The III-V group compound may be selected from the group including (e.g., consisting of) a binary compound selected from the group including (e.g., consisting of) GaN, GaP, GaAs, GaSb, AlN, AlP, AlAs, AlSb, InN, InP, InAs, InSb, and one or more mixtures thereof, a ternary compound selected from the group including (e.g., consisting of) GaNP, GaNAs, GaNSb, GaPAs, GaPSb, AlNP, AlNAs, AlNSb, AlPAs, AlPSb, InGaP, InAlP, InNP, InNAs, InNSb, InPAs, InPSb, and mixtures thereof, and a quaternary compound selected from the group including (e.g., consisting of) GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and one or more mixtures thereof. In some embodiments, the III-V group compound may further include a II group metal. For example, InZnP, etc. may be selected as a III-II-V group compound.

The IV-VI group compound may be selected from the group including (e.g., consisting of) a binary compound selected from the group including (e.g., consisting of) SnS, SnSe, SnTe, PbS, PbSe, PbTe, and one or more mixtures thereof, a ternary compound selected from the group including (e.g., consisting of) SnSeS, SnSeTe,

SnSTe, PbSeS, PbSeTe, PbSTe, SnPbS, SnPbSe, SnPbTe, and one or more mixtures thereof, and a quaternary compound selected from the group including (e.g., consisting of) SnPbSSe, SnPbSeTe, SnPbSTe, and one or more mixtures thereof. The IV group element may be selected from the group including (e.g., consisting of) Si, Ge, and a mixture thereof. The IV group compound may be a binary compound selected from the group including (e.g., consisting of) SiC, SiGe, and a mixture thereof.

In this embodiment, the binary compound, the ternary compound or the quaternary compound may be present at a substantially uniform concentration in a particle or may be present at a partially different concentration distribution state in the same particle. In some embodiments, a core/shell structure in which one quantum dot wraps another quantum dot may be possible. The interface of the core and the shell may have a concentration gradient in which the concentration of an element present in the shell is decreased toward the center.

In some embodiments, the quantum dot may have the above-described core-shell structure including a core including a nanocrystal and a shell wrapping the core. The shell of the quantum dot may play the role of a protection layer for preventing (reducing) the chemical deformation of the core to maintain semiconductor properties and/or a charging layer for imparting the quantum dot with electrophoretic properties. The shell may have a single layer or a multilayer. Examples of the shell of the quantum dot may include a metal or non-metal oxide, a semiconductor compound, or one or more combinations thereof.

For example, the metal or non-metal oxide may include a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄ and/or NiO, or a ternary compound such as MgAl₂O₄, CoFe₂O₄, NiFe₂O₄ and/or CoMn₂O₄, but an embodiment of the present disclosure is not limited thereto.

Also, the semiconductor compound may include CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AIP, AlSb, etc., but an embodiment of the present disclosure is not limited thereto.

The quantum dot may have a full width of half maximum (FWHM) of emission wavelength spectrum of about 45 nm or less, about 40 nm or less, or about 30 nm or less. Within the foregoing ranges, color purity or color reproducibility may be improved (increased). In some embodiments, light emitted via such a quantum dot is emitted in all directions, and light viewing angle properties may be improved (increased).

In some embodiments, the shape of the quantum dot may be shapes generally used in the art, without specific limitation. For example, the shape of a substantially spherical, pyramidal, multi-arm, or cubic nanoparticle, nanotube, nanowire, nanofiber, nanoplate particle, etc. may be used.

The quantum dot may control the color of light emitted according to the particle size, and accordingly, the quantum dot may have one or more suitable emission colors such as blue, red and green.

In the light emitting elements ED of embodiments, as shown in FIG. 3 to FIG. 6, the electron transport region ETR is provided on the emission layer EML. The electron transport region ETR may include at least one selected from a hole blocking layer HBL, an electron transport layer ETL and an electron injection layer EIL. However, an embodiment of the present disclosure is not limited thereto.

The electron transport region ETR may have a single layer formed using a single material, a single layer formed using multiple different materials, or a multilayer structure having multiple layers formed using multiple different materials.

For example, the electron transport region ETR may have a single layer structure of an electron injection layer EIL or an electron transport layer ETL, or a single layer structure formed using an electron injection material and an electron transport material. In some embodiments, the electron transport region ETR may have a single layer structure formed using multiple different materials, or a structure stacked from the emission layer EML of electron transport layer ETL/electron injection layer EIL, or hole blocking layer HBL/electron transport layer ETL/electron injection layer EIL, without limitation. The thickness of the electron transport region ETR may be, for example, from about 1,000 Å to about 1,500 Å.

The electron transport region ETR may be formed using one or more suitable methods such as a vacuum deposition method, a spin coating method, a cast method, a Langmuir-Blodgett (LB) method, an inkjet printing method, a laser printing method, and/or a laser induced thermal imaging (LITI) method.

The electron transport region ETR may include a compound represented by Formula ET-1.

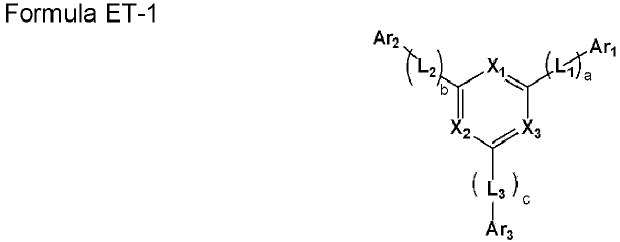

In Formula ET-1, at least one among X₁ to X₃ is N, and the remainder are CRₐ. Rₐ may be a hydrogen atom, a deuterium atom, a substituted or unsubstituted alkyl of 1 to 20 carbon atoms, a substituted or unsubstituted aryl group of 6 to 30 ring-forming carbon atoms, or a substituted or unsubstituted heteroaryl group of 2 to 30 ring-forming carbon atoms. Ar₁ to Ar₃ may each independently be a hydrogen atom, a deuterium atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 2 to 30 ring-forming carbon atoms.

In Formula ET-1, "a" to "c" may each independently be an integer from 0 to 10. In Formula ET-1, L₁ to L₃ may each independently be a direct linkage, a substituted or unsubstituted arylene group of 6 to 30 ring-forming carbon atoms, or a substituted or unsubstituted heteroarylene group of 2 to 30 ring-forming carbon atoms. In some embodiments, when "a" to "c" are integers of 2 or more, L₁ to L₃ may be each independently a substituted or unsubstituted arylene group of 6 to 30 ring-forming carbon atoms, or a substituted or unsubstituted heteroarylene group of 2 to 30 ring-forming carbon atoms.

The electron transport region ETR may include an anthracene-based compound. However, an embodiment of the present disclosure is not limited thereto, and the electron transport region ETR may include, for example, tris(8-hydroxyquinolinato)aluminum (Alqs), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazolyl-1-ylphenyl)-9,10-dinaphthylanthracene, 1,3,5-tri(1-phenyl-1H-benzo[d]imidazol-2-yl)benzene (TPBi), 2,9-dimethyl-4,7-diphenyl-1,10-phenanthroline (BCP), 4,7-diphenyl-1,10-phenanthroline (Bphen), 3-(4-biphenylyl)-4-phenyl-5-tert-butylphenyl-1,2,4-triazole (TAZ), 4-(naphthalen-1-yl)-3,5-diphenyl-4H-1,2,4-triazole (NTAZ), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), berylliumbis(benzoquinolin-10-olate) (Bebq₂), 9,10-di(naphthalene-2-yl)anthracene (ADN), 1,3-bis[3,5-di(pyridin-3-yl)phenyl]benzene (BmPyPhB), and/or one or more mixtures thereof, without limitation.

The electron transport region ETR may include at least one among Compounds ET1 to ET36 below.

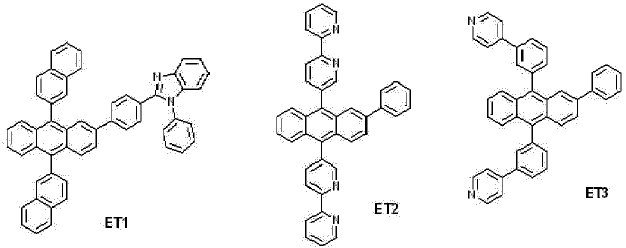

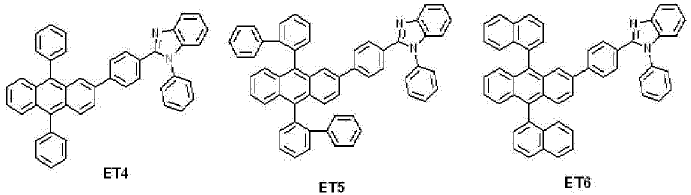

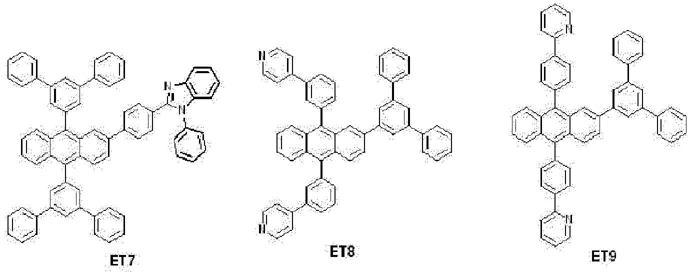

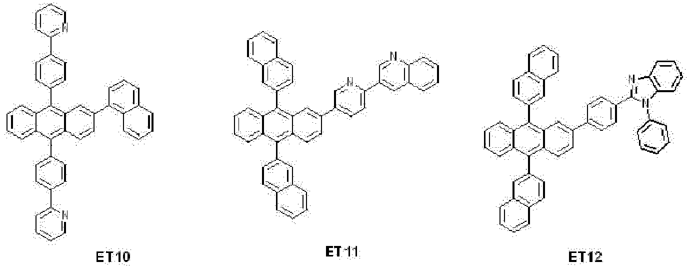

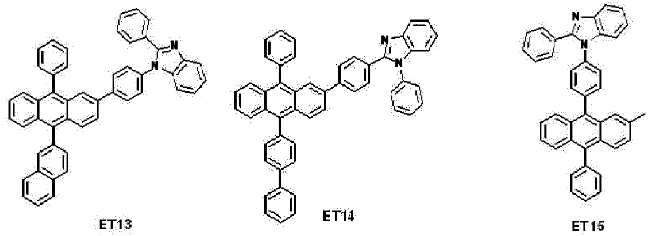

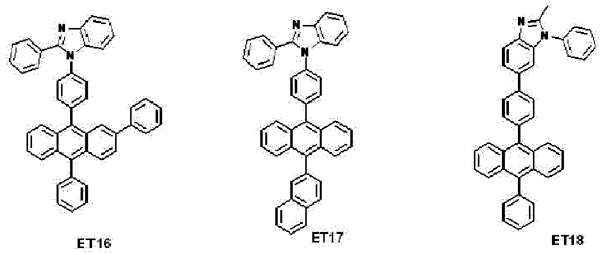

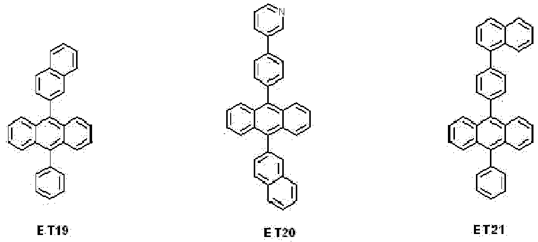

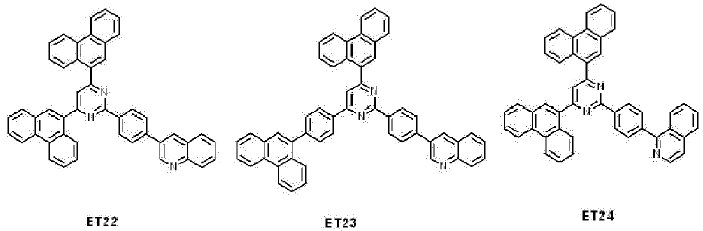

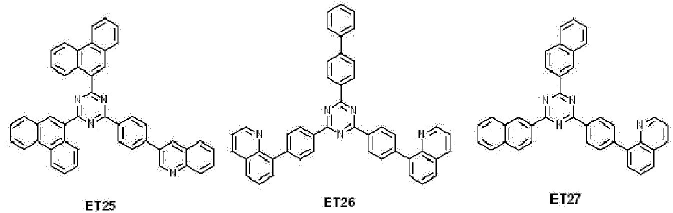

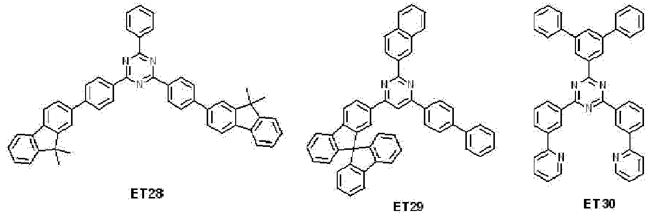

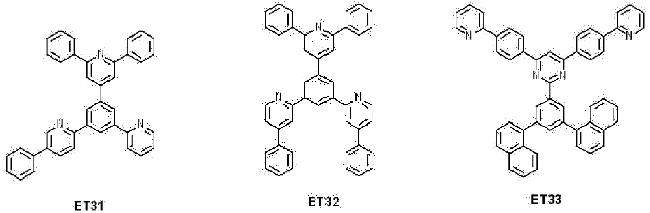

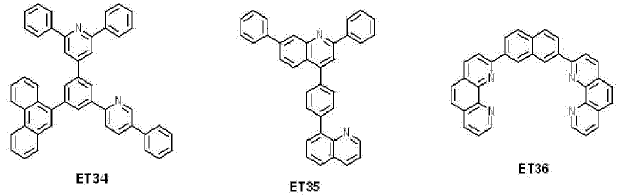

In some embodiments, the electron transport region ETR may include a metal halide such as LiF, NaCl, CsF, RbCl, RbI, CuI and/or KI, a metal in lanthanoides such as Yb, and/or a co-depositing material of the metal halide and the metal in lanthanoides. For example, the electron transport region ETR may include KI:Yb, RbI:Yb, LiF:Yb, etc., as the co-depositing material. In some embodiments, the electron transport region ETR may use a metal oxide such as Li₂O and/or BaO, and/or 8-hydroxy-lithium quinolate (Liq). However, an embodiment of the present disclosure is not limited thereto. The electron transport region ETR also may be formed using a mixture material of an electron transport material and an insulating organo metal salt. The organo metal salt may be a material having an energy band gap of about 4 eV or more. For example, the organo metal salt may include, for example, metal acetates, metal benzoates, metal acetoacetates, metal acetylacetonates, or metal stearates.

The electron transport region ETR may include at least one selected from 2,9-dimethyl-4,7-diphenyl-1,10-phenanthroline (BCP), diphenyl(4-(triphenylsilyl)phenyl)phosphine oxide (TSPO1) and 4,7-diphenyl-1,10-phenanthroline (Bphen) in addition to the aforementioned materials. However, an embodiment of the present disclosure is not limited thereto.

The electron transport region ETR may include the compounds of the electron transport region in at least one selected from among an electron injection layer EIL, an electron transport layer ETL, and a hole blocking layer HBL.

When the electron transport region ETR includes the electron transport layer ETL, the thickness of the electron transport layer ETL may be from about 100 Å to about 1,000 Å, for example, from about 150 Å to about 500 Å. When the thickness of the electron transport layer ETL satisfies the above-described range, satisfactory (suitable) electron transport properties may be obtained without substantial increase of a driving voltage. When the electron transport region ETR includes the electron injection layer EIL, the thickness of the electron injection layer EIL may be from about 1 Å to about 100 Å, and from about 3 Å to about 90 Å. When the thickness of the electron injection layer EIL satisfies the above described range, satisfactory (suitable) electron injection properties may be obtained without inducing substantial increase of a driving voltage.

The second electrode EL2 is provided on the electron transport region ETR. The second electrode EL2 may be a common electrode. The second electrode EL2 may be a cathode or an anode, but an embodiment of the present disclosure is not limited thereto. For example, when the first electrode EL1 is an anode, the second cathode EL2 may be a cathode, and when the first electrode EL1 is a cathode, the second electrode EL2 may be an anode. The second electrode may include at least one selected from among Ag, Mg, Cu, Al, Pt, Pd, Au, Ni, Nd, Ir, Cr, Li, Ca, LiF, Mo, Ti, W, In, Sn, and Zn, compounds of two or more selected therefrom, mixtures of two or more selected therefrom, or oxides thereof.

The second electrode EL2 may be a transmissive electrode, a transflective electrode or a reflective electrode. When the second electrode EL2 is the transmissive electrode, the second electrode EL2 may include a transparent metal oxide, for example, ITO, IZO, ZnO, ITZO, etc.

When the second electrode EL2 is the transflective electrode or the reflective electrode, the second electrode EL2 may include Ag, Mg, Cu, Al, Pt, Pd, Au, Ni, Nd, Ir, Cr, Li, Ca, LiF/Ca, LiF/Al, Mo, Ti, Yb, W, one or more compounds or mixtures including thereof (for example, AgMg, AgYb, or MgAg). Or, the second electrode EL2 may have a multilayered structure including a reflective layer or a transflective layer formed using the above-described materials and a transparent conductive layer formed using ITO, IZO, ZnO, ITZO, etc. For example, the second electrode EL2 may include the aforementioned metal materials, combinations of two or more metal materials selected from the aforementioned metal materials, or oxides of the aforementioned metal materials.

The second electrode EL2 may be connected with an auxiliary electrode. When the second electrode EL2 is connected with the auxiliary electrode, the resistance of the second electrode EL2 may decrease.

In some embodiments, on the second electrode EL2 in the light emitting element ED of an embodiment, a capping layer CPL may be further disposed. The capping layer CPL may include a multilayer or a single layer.

In an embodiment, the capping layer CPL may be an organic layer or an inorganic layer. For example, if the capping layer CPL may include an inorganic material. The inorganic material may include an alkali metal compound such as LiF, an alkaline earth metal compound such as MgF₂, SiON, SiNx, SiOy, etc.

For example, when the capping layer CPL includes an organic material, the organic material may include α-NPD, NPB, TPD, m-MTDATA, Alqs, CuPc, N4,N4,N4',N4'-tetra(biphenyl-4-yl) biphenyl-4,4'-diamine (TPD15), 4,4',4"-tris(carbazol sol-9-yl) triphenylamine (TCTA), etc., and/or includes an epoxy-based resin, or acrylate such as methacrylate. In some embodiments, a capping layer CPL may include at least one among Compounds P1 to P5, but an embodiment of the present disclosure is not limited thereto.

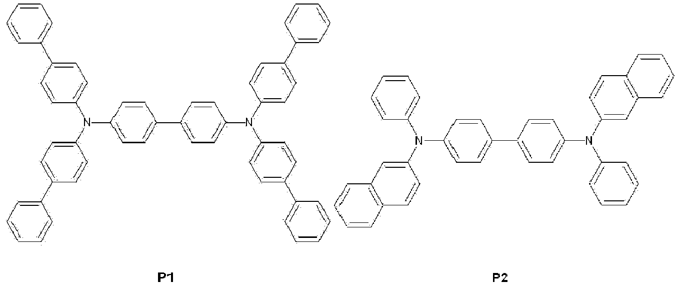

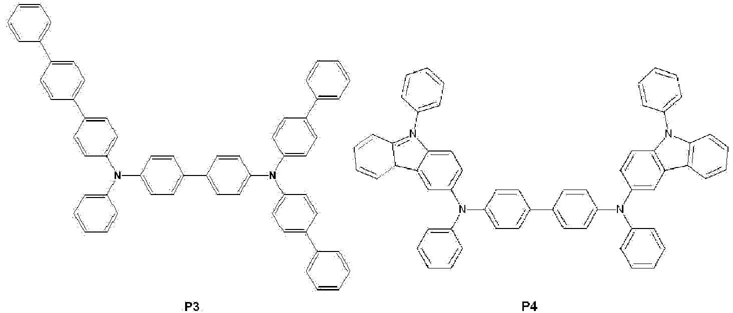

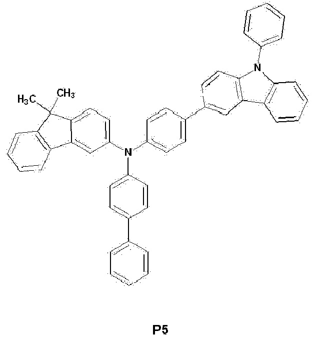

In some embodiments, the refractive index of the capping layer CPL may be about 1.6 or more. For example, the refractive index of the capping layer CPL with respect to light in a wavelength range of about 550 nm to about 660 nm may be about 1.6 or more.

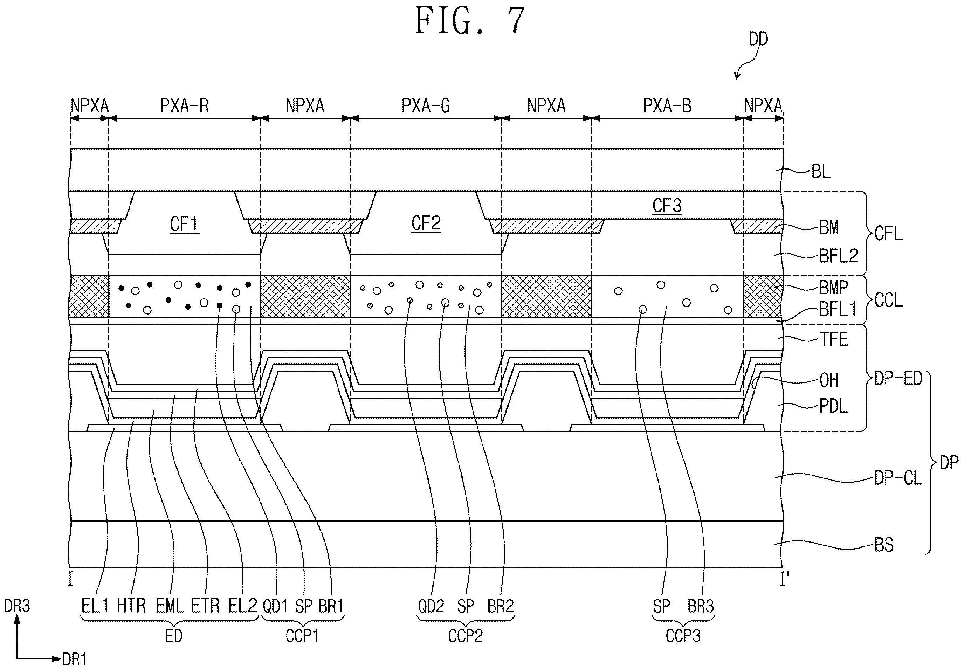

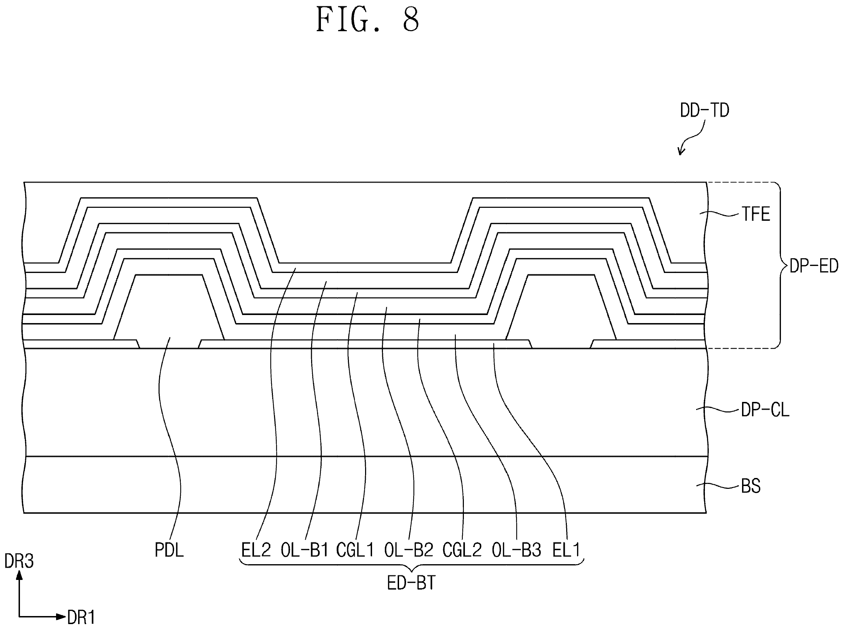

FIG. 7 and FIG. 8 are cross-sectional views of display apparatuses according to embodiments. In the explanation on the display apparatuses of embodiments, referring to FIG. 7 and FIG. 8, the overlapping parts with the explanation on FIG. 1 to FIG. 6 may not be explained again, and the different features will primarily be explained.

Referring to FIG. 7, a display apparatus DD according to an embodiment may include a display panel DP including a display device layer DP-ED, a light controlling layer CCL disposed on the display panel DP, and a color filter layer CFL.

In an embodiment shown in FIG. 7, the display panel DP includes a base layer BS, a circuit layer DP-CL provided on the base layer BS and a display device layer DP-ED, and the display device layer DP-ED may include a light emitting element ED.

The light emitting element ED may include a first electrode EL1, a hole transport region HTR on the first electrode EL1, an emission layer EML on the hole transport region HTR, an electron transport region ETR on the emission layer EML, and a second electrode EL2 on the electron transport region ETR. In some embodiments, the same structures of the light emitting elements of FIG. 3 to FIG. 6 may be applied to the structure of the light emitting element ED shown in FIG. 7.

Referring to FIG. 7, the emission layer EML may be in an opening part OH defined in a pixel definition layer PDL. For example, the emission layer EML divided by the pixel definition layer PDL and correspondingly provided to each of luminous areas PXA-R, PXA-G and PXA-B may emit light in substantially the same wavelength region. In the display apparatus DD of an embodiment, the emission layer EML may emit blue light. In some embodiments, the emission layer EML may be provided as a common layer for all luminous areas PXA-R, PXA-G and PXA-B.

The light controlling layer CCL may be disposed on the display panel DP. The light controlling layer CCL may include a light converter. The light converter may be a quantum dot or a phosphor. The light converter may transform the wavelength of light provided and then emit the light. For example, the light controlling layer CCL may be a layer including a quantum dot or a layer including a phosphor.

The light controlling layer CCL may include multiple light controlling parts CCP1, CCP2 and CCP3. The light controlling parts CCP1, CCP2 and CCP3 may be separated from one another.

Referring to FIG.7, a partition pattern BMP may be disposed between the separated light controlling parts CCP1, CCP2 and CCP3, but an embodiment of the present disclosure is not limited thereto. In FIG. 7, the partition pattern BMP is shown not to be overlapped with the light controlling parts CCP1, CCP2 and CCP3, but at least a portion of the edge of the light controlling parts CCP1, CCP2 and CCP3 may be overlapped with the partition pattern BMP.

The light controlling layer CCL may include a first light controlling part CCP1 including a first quantum dot QD1 converting first color light provided from the light emitting element ED into second color light, a second light controlling part CCP2 including a second quantum dot QD2 converting first color light into third color light, and a third light controlling part CCP3 transmitting first color light.

In an embodiment, the first light controlling part CCP1 may provide red light which is the second color light, and the second light controlling part CCP2 may provide green light which is the third color light. The third color controlling part CCP3 may transmit and provide blue light which is the first color light provided from the light emitting element ED. For example, the first quantum dot QD1 may be a red quantum dot, and the second quantum dot QD2 may be a green quantum dot. For the quantum dots QD1 and QD2, the same contents (materials/criteria) as those described above may be applied.

In some embodiments, the light controlling layer CCL may further include a scatterer SP. The first light controlling part CCP1 may include the first quantum dot QD1 and the scatterer SP, the second light controlling part CCP2 may include the second quantum dot QD2 and the scatterer SP, and the third light controlling part CCP3 may not include (e.g., may exclude) a quantum dot but may include the scatterer SP.

The scatterer SP may be an inorganic particle. For example, the scatterer SP may include at least one selected from among TiO₂, ZnO, Al₂O₃, SiO₂, and hollow silica. The scatterer SP may include at least one selected from among TiO₂, ZnO, Al₂O₃, SiO₂, and hollow silica, or may be a mixture or mixtures of two or more materials selected from among TiO₂, ZnO, Al₂O₃, SiO₂, and hollow silica.

Each of the first light controlling part CCP1, the second light controlling part CCP2, and the third light controlling part CCP3 may include base resins BR1, BR2 and BR3 dispersing the quantum dots QD1 and QD2 and the scatterer SP. In an embodiment, the first light controlling part CCP1 may include the first quantum dot QD1 and the scatterer SP dispersed in the first base resin BR1, the second light controlling part CCP2 may include the second quantum dot QD2 and the scatterer SP dispersed in the second base resin BR2, and the third light controlling part CCP3 may include the scatterer particle SP dispersed in the third base resin BR3. The base resins BR1, BR2 and BR3 are mediums in which the quantum dots QD1 and QD2 and the scatterer SP are dispersed, and may be composed of one or more suitable resin compositions which may be generally referred to as a binder. For example, the base resins BR1, BR2 and BR3 may be acrylic resins, urethane-based resins, silicone-based resins, epoxy-based resins, etc. The base resins BR1, BR2 and BR3 may be transparent resins. In an embodiment, the first base resin BR1, the second base resin BR2 and the third base resin BR3 may be the same or different from each other.

The light controlling layer CCL may include a barrier layer BFL1. The barrier layer BFL1 may play the role of blocking (reducing) the penetration of moisture and/or oxygen (hereinafter, will be referred to as "humidity/oxygen"). The barrier layer BFL1 may be disposed on the light controlling parts CCP1, CCP2 and CCP3 to block (reduce) the exposure of the light controlling parts CCP1, CCP2 and CCP3 to humidity/oxygen. In some embodiments, the barrier layer BFL1 may cover the light controlling parts CCP1, CCP2 and CCP3. In some embodiments, the barrier layer BFL2 may be provided between the light controlling parts CCP1, CCP2 and CCP3 and a color filter layer CFL.

The barrier layers BFL1 and BFL2 may include at least one inorganic layer. For example, the barrier layers BFL1 and BFL2 may be formed by including an inorganic material. For example, the barrier layers BFL1 and BFL2 may be formed by including silicon nitride, aluminum nitride, zirconium nitride, titanium nitride, hafnium nitride, tantalum nitride, silicon oxide, aluminum oxide, titanium oxide, tin oxide, cerium oxide and silicon oxynitride and/or a metal thin film securing light transmittance. In some embodiments, the barrier layers BFL1 and BFL2 may further include an organic layer. The barrier layers BFL1 and BFL2 may be composed of a single layer or multiple layers.

In the display apparatus DD of an embodiment, the color filter layer CFL may be on the light controlling layer CCL. For example, the color filter layer CFL may be directly on the light controlling layer CCL. In this embodiment, the barrier layer BFL2 may not be provided.

The color filter layer CFL may include a light blocking part BM and filters CF1, CF2 and CF3. The color filter layer CFL may include a first filter CF1 transmitting a second color light, a second filter CF2 transmitting a third color light, and a third filter CF3 transmitting a first color light. For example, the first filter CF1 may be a red filter, the second filter CF2 may be a green filter, and the third filter CF3 may be a blue filter. Each of the filters CF1, CF2 and CF3 may include a polymer photosensitive resin and a pigment or dye. The first filter CF1 may include a red pigment or dye, the second filter CF2 may include a green pigment or dye, and the third filter CF3 may include a blue pigment or dye. Although, an embodiment of the present disclosure is not limited thereto, and the third filter CF3 may not include (e.g., may exclude) the pigment or dye. The third filter CF3 may include a polymer photosensitive resin and not include (e.g., may exclude) the pigment or dye. The third filter CF3 may be transparent. The third filter CF3 may be formed using a transparent photosensitive resin.

In some embodiments, the first filter CF1 and the second filter CF2 may be yellow filters. The first filter CF1 and the second filter CF2 may be provided in one body without distinction.

The light blocking part BM may be a black matrix. The light blocking part BM may be formed by including an organic light blocking material or an inorganic light blocking material including a black pigment or black dye. The light blocking part BM may prevent (reduce) a light leakage phenomenon and divide the boundaries among adjacent filters CF1, CF2 and CF3. In some embodiments, the light blocking part BM may be formed as a blue filter.

Each of the first to third filters CF1, CF2 and CF3 may be disposed corresponding to each of a red luminous area PXA-R, green luminous area PXA-G, and blue luminous area PXA-B.

On the color filter layer CFL, a base substrate BL may be disposed. The base substrate BL may be a member providing a base surface on which the color filter layer CFL, the light controlling layer CCL, etc. are disposed. The base substrate BL may be a glass substrate, a metal substrate, a plastic substrate, etc. However, an embodiment of the present disclosure is not limited thereto, and the base substrate BL may be an inorganic layer, an organic layer or a composite material layer. In some embodiments, the base substrate BL may not be provided.

FIG. 8 is a cross-sectional view showing a portion of the display apparatus according to an embodiment. In FIG. 8, the cross-sectional view of a portion corresponding to the display panel DP in FIG. 7 is shown. In a display apparatus DD-TD of an embodiment, the light emitting element ED-BT may include multiple light emitting structures OL-B1, OL-B2 and OL-B3. The light emitting element ED-BT may include oppositely disposed first electrode EL1 and second electrode EL2, and the multiple light emitting structures OL-B1, OL-B2 and OL-B3 stacked in order in a thickness direction and provided between the first electrode EL1 and the second electrode EL2. Each of the light emitting structures OL-B1, OL-B2 and OL-B3 may include an emission layer EML (FIG. 7), and a hole transport region HTR and an electron transport region ETR, disposed with the emission layer EML (FIG. 7) therebetween.

For example, the light emitting element ED-BT included in the display apparatus DD-TD of an embodiment may be a light emitting element of a tandem structure including multiple emission layers.

In an embodiment shown in FIG. 8, light emitted from the light emitting structures OL-B1, OL-B2 and OL-B3 may be all blue light. However, an embodiment of the present disclosure is not limited thereto, and the wavelength regions of light emitted from the light emitting structures OL-B1, OL-B2 and OL-B3 may be different from each other. For example, the light emitting element ED-BT including the multiple light emitting structures OL-B1, OL-B2 and OL-B3 emitting light in different wavelength regions may emit white light.

Between neighboring light emitting structures OL-B1, OL-B2 and OL-B3, charge generating layers CGL1 and CGL2 may be disposed. The charge generating layers CGL1 and CGL2 may include a p-type charge generating layer and/or an n-type charge generating layer.

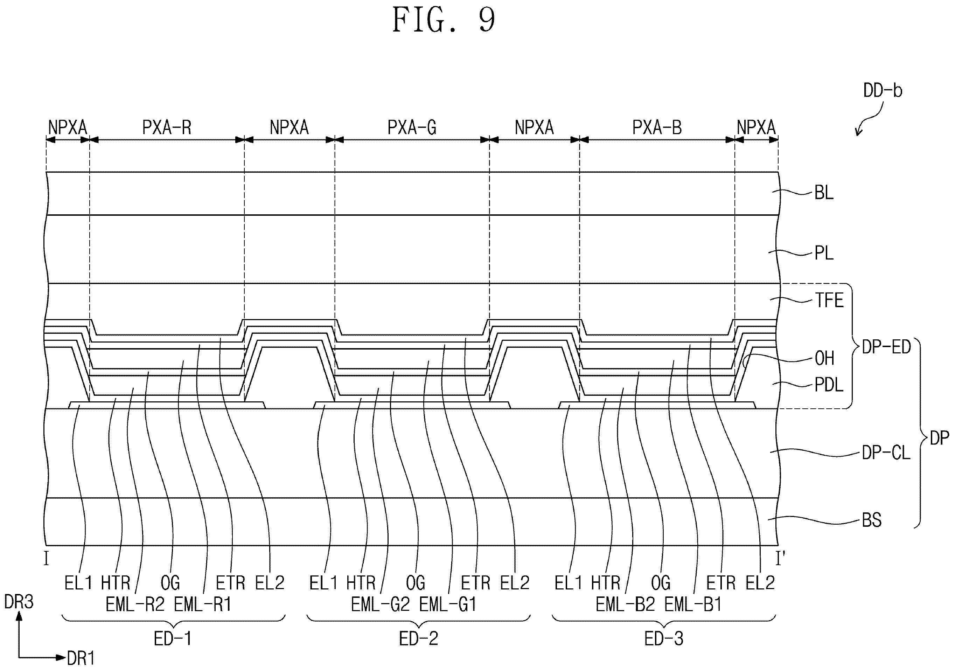

Referring to FIG. 9, a display apparatus DD-b according to an embodiment may include light emitting elements ED-1, ED-2 and ED-3, formed by stacking two emission layers. Compared to the display apparatus DD of an embodiment, shown in FIG. 2, an embodiment shown in FIG. 9 is different in that first to third light emitting elements ED-1, ED-2 and ED-3 include two emission layers stacked in a thickness direction, each. In the first to third light emitting elements ED-1, ED-2 and ED-3, two emission layers may emit light in substantially the same wavelength region.

The first light emitting element ED-1 may include a first red emission layer EML-R1 and a second red emission layer EML-R2. The second light emitting element ED-2 may include a first green emission layer EML-G1 and a second green emission layer EML-G2. In some embodiments, the third light emitting element ED-3 may include a first blue emission layer EML-B1 and a second blue emission layer EML-B2. Between the first red emission layer EML-R1 and the second red emission layer EML-R2, between the first green emission layer EML-G1 and the second green emission layer EML-G2, and between the first blue emission layer EML-B1 and the second blue emission layer EML-B2, an emission auxiliary part OG may be disposed.

The emission auxiliary part OG may include a single layer or a multilayer. The emission auxiliary part OG may include a charge generating layer. For example, the emission auxiliary part OG may include an electron transport region, a charge generating layer, and a hole transport region stacked in order. The emission auxiliary part OG may be provided as a common layer in all of the first to third light emitting elements ED-1, ED-2 and ED-3. However, an embodiment of the present disclosure is not limited thereto, and the emission auxiliary part OG may be patterned and provided in an opening part OH defined in a pixel definition layer PDL.

The first red emission layer EML-R1, the first green emission layer EML-G1 and the first blue emission layer EML-B1 may be disposed between the hole transport region HTR and the emission auxiliary part OG. The second red emission layer EML-R2, the second green emission layer EML-G2 and the second blue emission layer EML-B2 may be disposed between the emission auxiliary part OG and the electron transport region ETR.

For example, the first light emitting element ED-1 may include a first electrode EL1, a hole transport region HTR, a second red emission layer EML-R2, an emission auxiliary part OG, a first red emission layer EML-R1, an electron transport region ETR, and a second electrode EL2, stacked in order from the first electrode EL-1. The second light emitting element ED-2 may include a first electrode EL1, a hole transport region HTR, a second green emission layer EML-G2, an emission auxiliary part OG, a first green emission layer EML-G1, an electron transport region ETR, and a second electrode EL2, stacked in order from the first electrode EL-1. The third light emitting element ED-3 may include a first electrode EL1, a hole transport region HTR, a second blue emission layer EML-B2, an emission auxiliary part OG, a first blue emission layer EML-B1, an electron transport region ETR, and a second electrode EL2, stacked in order from the first electrode EL-1.

In some embodiments, an optical auxiliary layer PL may be disposed on a display element layer DP-ED. The optical auxiliary layer PL may include a polarization layer. The optical auxiliary layer PL may be disposed on a display panel DP and may control reflected light at the display panel DP by external light. In some embodiments, the optical auxiliary layer PL may not be provided in the display apparatus.

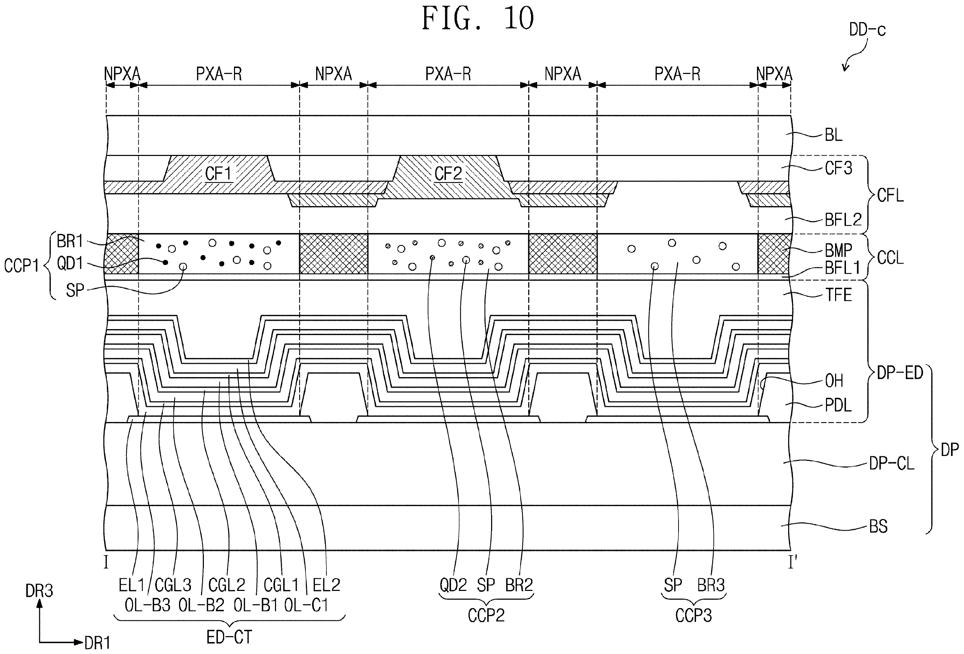

Different from FIG. 8 and FIG. 9, a display apparatus DD-c in FIG. 10 is shown to include four light emitting structures OL-B1, OL-B2, OL-B3 and OL-C1. A light emitting element ED-CT may include oppositely disposed first electrode EL1 and second electrode EL2, and first to fourth light emitting structures OL-B1, OL-B2, OL-B3 and OL-C1 stacked in order in a thickness direction between the first electrode EL1 and the second electrode EL2. Between the first to fourth light emitting structures OL-B1, OL-B2, OL-B3 and OL-C1, charge generating layers CGL1, CGL2 and CGL3 may be disposed. Among the four light emitting structures, the first to third light emitting structures OL-B1, OL-B2 and OL-B3 may emit blue light, and the fourth light emitting structure OL-C1 may emit green light. However, an embodiment of the present disclosure is not limited thereto, and the first to fourth light emitting structures OL-B1, OL-B2, OL-B3 and OL-C1 may emit different wavelengths of light.

The charge generating layers CGL1, CGL2 and CGL3 disposed between the neighboring light emitting structures OL-B1, OL-B2, OL-B3 and OL-C1 may include a p-type charge generating layer and/or an n-type charge generating layer.

Hereinafter, referring to embodiments and comparative embodiments, the organometallic compound and the light emitting element of the present disclosure are explained in more detail below. The embodiments below are merely illustrations (examples) to assist the understanding of the present disclosure, and the scope of the present disclosure is not limited thereto.

### Examples

### 1. Synthesis of organometallic compound

First, the synthetic method of the organometallic compound according to an embodiment of the present disclosure is explained referring to the synthetic methods of Compound 1, Compound 36, Compound 60 and Compound 97 in Compound Group 1. The synthetic methods of the organometallic compounds explained hereinafter are merely examples, and the synthetic method of the organometallic compound according to the present disclosure is not limited to the embodiments below.

### (1) Synthesis of Compound 1

Compound 1 according to an embodiment may be synthesized by, for example, the steps of Reaction 1-1 to Reaction 1-3.

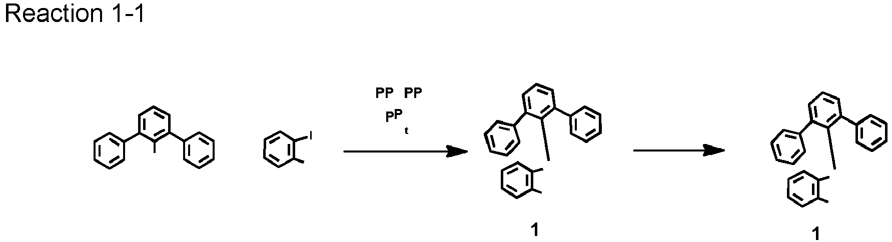

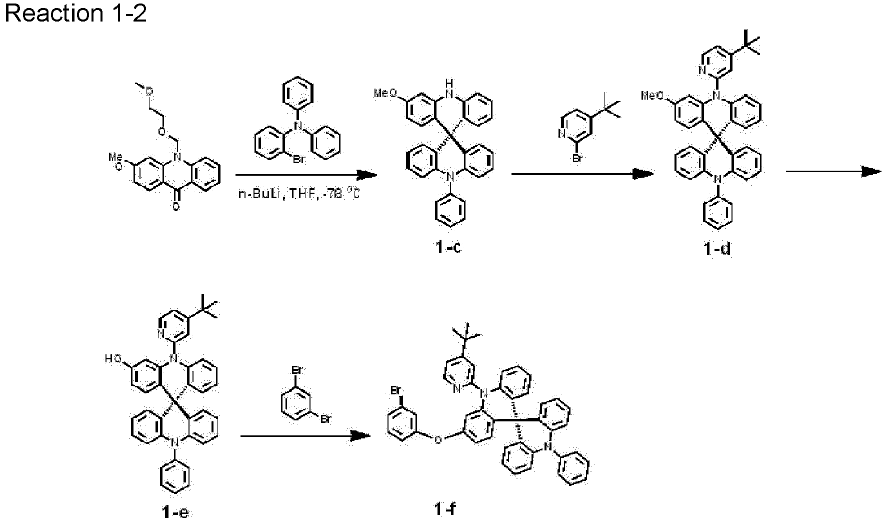

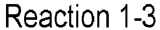

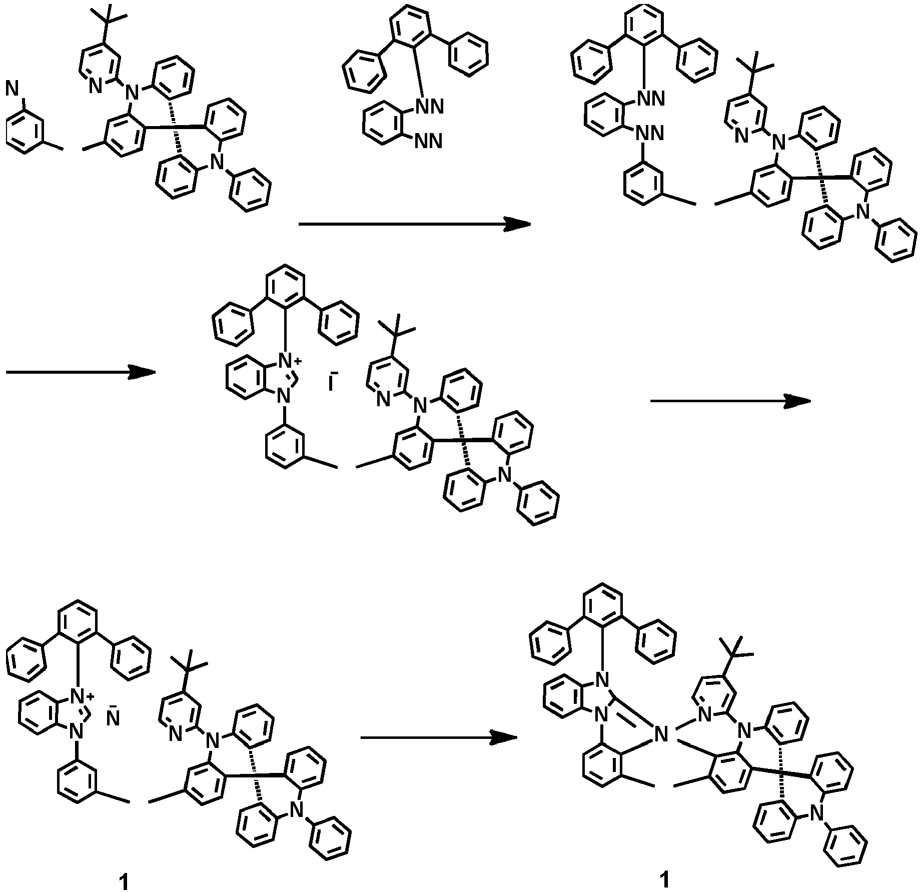

### 1) Synthesis of Intermediate Compound 1-a

2,6-Diphenylaniline (1.0 eq), 2-iodo-nitrobenzene (2.0 eq), Pd₂(dba)₃ (10 mol%), Sphos (15 mol%) and sodium tert-butoxide (3.0 eq) were dissolved in toluene (0.1 M) and stirred at about 110 °C for about 12 hours to obtain a reaction product. After cooling to room temperature, the reaction product was extracted using dichloromethane and water three times to obtain an organic layer. The organic layer thus obtained was dried over magnesium sulfate and concentrated, and the crude product thus obtained was separated by column chromatography (MC: hexane = 1: 9 by a volume ratio) to synthesize Intermediate Compound 1-a (yield 70%).

### 2) Synthesis of Intermediate Compound 1-b

Intermediate 1-a (1.0 eq), Sn (1.5 eq) and HCl (30 eq) were dissolved in ethanol and stirred at about 80 °C for about 12 hours. After cooling, the reaction mixture was neutralized using a NaOH solution. The resultant reaction mixture was extracted using dichloromethane and water to obtain an organic layer, and the organic layer was filtered using celite/silica gel. The filtrate was dried over magnesium sulfate and concentrated, and the crude product thus obtained was separated by column chromatography (MC: hexane = 1: 3) to synthesize Intermediate Compound 1-b (yield 89%).

### 3) Synthesis of Intermediate Compound 1-c

2-Bromotriphenylamine (1.0 eq) was dissolved in anhydrous THF (0.3 M), and 1.6 M of n-BuLi (1.1 eq) was slowly added thereto at about -78 °C, followed by stirring for about 2 hours. To the resultant product, a solution in which 3-methoxy-10-((2-methoxyethoxy)methyl)acridin-9(10H)-one (1.0 eq) was dissolved in anhydrous THF (0.2 M) was added and stirred at room temperature for about 20 hours. Then, a 1.0 M HCl aqueous solution (2.0 eq) was added thereto and stirred again for about 20 hours to obtain a reaction product. The reaction product was neutralized using K₂CO₃ and filtered using silica gel to synthesize Intermediate Compound 1-c (yield 55%).

### 4) Synthesis of Intermediate Compound 1-d

Intermediate Compound 1-c (1.1 eq), 2-bromo-4-tert-butyl-pyridine (1.0 eq), Pd₂(dba)₃ (5 mol%), Sphos (7 mol%) and sodium tert-butoxide (2.0 eq) were dissolved in toluene (0.1 M) and stirred at about 110 °C for about 12 hours to obtain a reaction product. After cooling to room temperature, the reaction product was extracted using dichloromethane and water three times to obtain an organic layer. The organic layer thus obtained was dried over magnesium sulfate and concentrated, and the crude product thus obtained was separated by column chromatography (EA: hexane = 1: 4 by a volume ratio) to synthesize Intermediate Compound 1-d (yield 75%).

### 5) Synthesis of Intermediate Compound 1-e

Intermediate Compound 1-d (1.0 eq), HBr and acetic acid were stirred at about 120 °C for about 16 hours. After cooling to room temperature, the reaction mixture was neutralized to pH 7 using a NaOH aqueous solution at about 0 °C, and the resultant mixture was extracted using ethyl acetate and water three times to obtain an organic layer. The organic layer thus obtained was dried over magnesium sulfate and concentrated to synthesize Intermediate Compound 1-e (yield 92%).

### 6) Synthesis of Intermediate Compound 1-f

1,3-Dibromobenzene (1.2 eq), Intermediate Compound 1-e (1.0 eq), Cui (10 mol%), a BPPO ligand (10 mol%) and potassium phosphate tribasic (2.0 eq) were dissolved in DMF (0.1 M), followed by stirring at about 160 °C for about 10 hours. After cooling the reaction product to room temperature, DMF was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 10 by a volume ratio) to synthesize Intermediate Compound 1-f (yield 57%).

### 7) Synthesis of Intermediate Compound 1-g

Intermediate Compound 1-f (1.0 eq), 1-b (1.2 eq), Pd₂(dba)₃ (5 mol%), Sphos (7 mol%) and sodium tert-butoxide (2.0 eq) were dissolved in toluene (0.1 M), followed by stirring at about 110 °C for about 3 hours. After cooling the reaction product to room temperature, toluene was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 4 by a volume ratio) to synthesize Intermediate Compound 1-g (yield 90%).

### 8) Synthesis of Intermediate Compound 1-h

Intermediate Compound 1-g (1.0 eq) was dissolved in triethyl orthoformate (30 eq), and 37wt% HCl (1.5 eq) was added thereto, followed by stirring at about 80 °C for about 12 h. After cooling at room temperature, triethyl orthoformate was concentrated, and the resultant product was extracted using dichloromethane and water three times to obtain an organic layer. The organic layer thus obtained was dried over magnesium sulfate and concentrated, and the resultant crude product was separated by column chromatography (MC: 5 vol% of methanol) to synthesize Intermediate Compound 1-h (yield 85%).

### 9) Synthesis of Intermediate Compound 1-i

Intermediate Compound 1-h (1.0 eq) and ammonium hexafluorophosphate (3.0 eq) were dissolved in methanol (0.5 M), and distilled water was added thereto, followed by stirring at room temperature for about 5 hours. The resultant product was washed with distilled water and filtered to obtain a solid. The solid was extracted using dichloromethane and water three times to obtain an organic layer. The organic layer thus obtained was dried over magnesium sulfate and concentrated to synthesize Intermediate Compound 1-i (yield 95%).

### 10) Synthesis of Compound 1

Intermediate Compound 1-i (1.0 eq), dichloro(1,5-cyclooctadiene)platinum(II) (1.1 eq) and sodium acetate (2.0 eq) were dissolved in anhydrous 1,4-dioxane (0.05 M), followed by stirring under nitrogen conditions at about 120°C for about 4 days. After cooling at room temperature, the resultant product was extracted using dichloromethane and water three times to obtain an organic layer. The organic layer thus obtained was dried over magnesium sulfate and concentrated, and the resultant crude product was separated by column chromatography (30 vol% of MC: hexane) to synthesize Compound 1 (yield 25%).

### (2) Synthesis of Compound 36

Compound 36 according to an embodiment may be synthesized by, for example, the steps of Reaction 2-1 and Reaction 2-2.

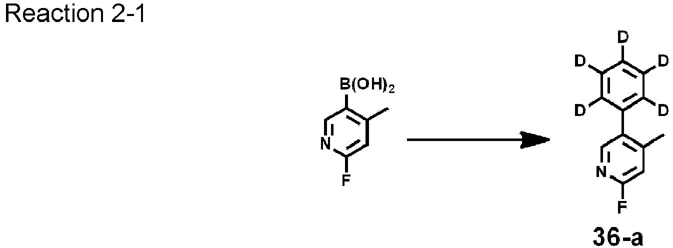

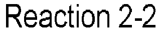

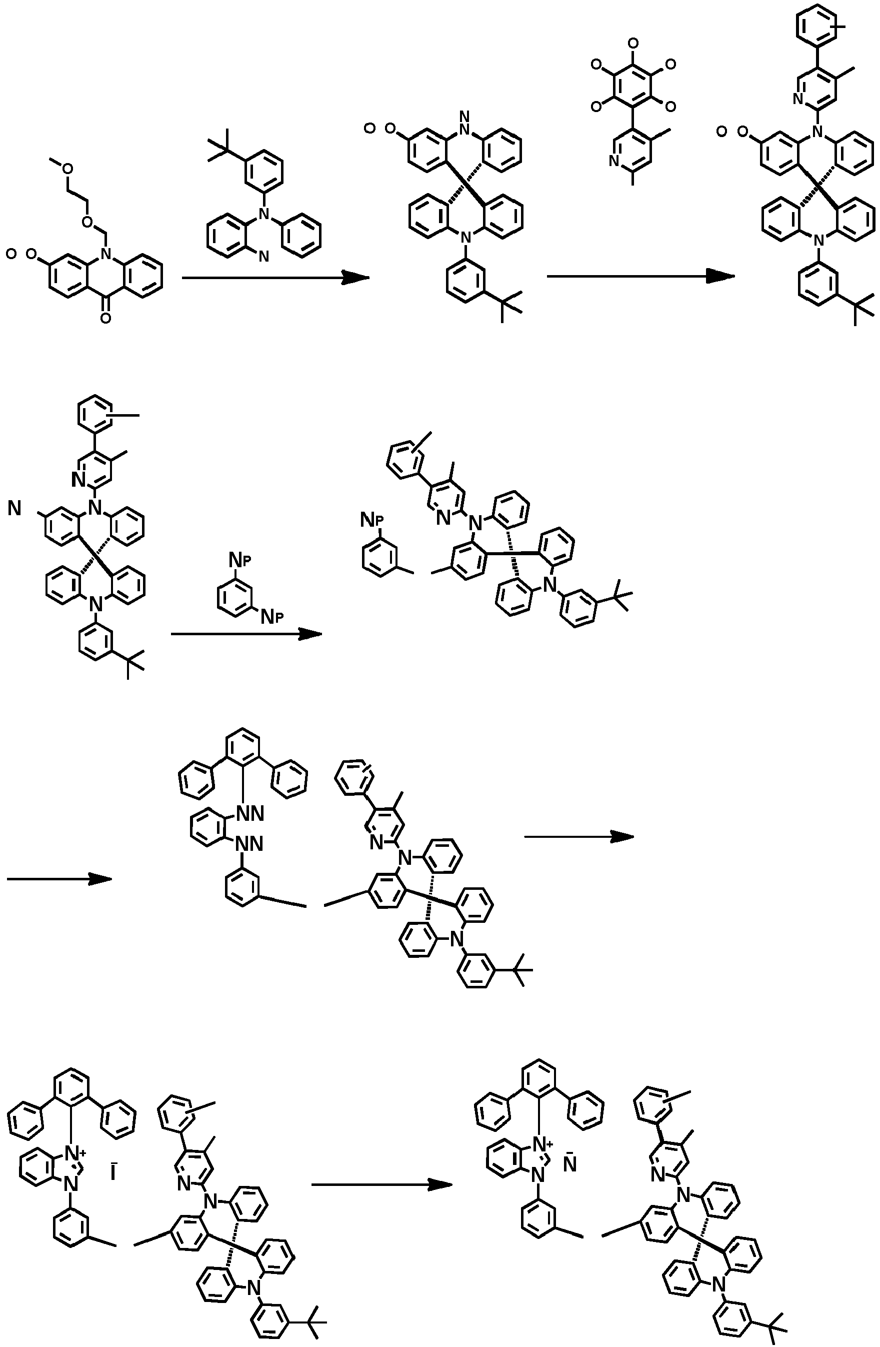

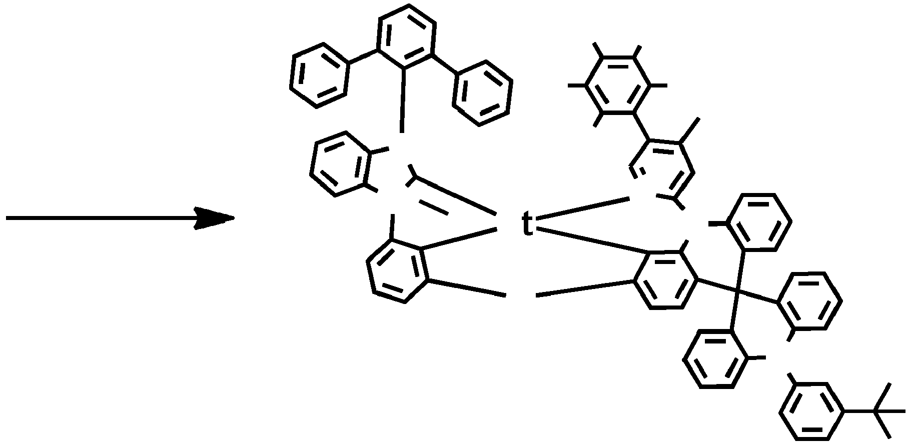

### 1) Synthesis of Intermediate Compound 36-a

(6-Fluoro-4-methylpyridin-3-yl)boronic acid (1.0 eq), bromobenzene-d₅ (1.2 eq), Pd(PPh₃)₄ (5 mol%) and sodium carbonate (3.0 eq) were dissolved in dioxane: H₂O (0.1 M, a volume ratio = 4: 1) and stirred at about 100°C for about 18 hours to obtain a reaction product. After cooling to room temperature, the reaction product was extracted using ethyl acetate and a sodium chloride aqueous solution three times to obtain an organic layer. The organic layer thus obtained was dried over magnesium sulfate and concentrated, and the crude product thus obtained was separated by column chromatography (EA: hexane = 1: 20 by a volume ratio) to synthesize Intermediate Compound 36-a (yield 90%).

### 2) Synthesis of Intermediate Compound 36-b

2-Bromo-N-(3-(tert-butyl)phenyl)-N-phenylaniline (1.0 eq) was dissolved in anhydrous THF (0.3 M), and 1.6 M of n-BuLi (1.1 eq) was slowly added thereto at about -78 °C, followed by stirring for about 2 hours. To the resultant product, a solution in which 3-methoxy-10-((2-methoxyethoxy)methyl)acridin-9(10H)-one (1.0 eq) was dissolved in anhydrous THF (0.2 M) was added and stirred at room temperature for about 20 hours. To the resultant product, a HCl aqueous solution (2.0 eq) was added, followed by stirring again for about 20 hours to obtain a reaction product. The reaction product was neutralized using K₂CO₃ and filtered using silica gel to synthesize Intermediate Compound 36-b (yield 57%).

### 3) Synthesis of Intermediate Compound 36-c

Intermediate Compound 36-b (1.1 eq), 36-a (1.0 eq), Pd₂(dba)₃ (5 mol%), Sphos (7 mol%) and sodium tert-butoxide (2.0 eq) were dissolved in toluene (0.1 M) and stirred at about 110 °C for about 12 hours to obtain a reaction product. After cooling to room temperature, the reaction product was extracted using dichloromethane and water three times to obtain an organic layer. The organic layer thus obtained was dried over magnesium sulfate and concentrated, and the crude product thus obtained was separated by column chromatography (EA: hexane = 1: 10 by a volume ratio) to synthesize Intermediate Compound 36-c (yield 72%).

### 4) Synthesis of Intermediate Compound 36-d

Intermediate Compound 36-c (1.0 eq), HBr and acetic acid were stirred at about 120 °C for about 16 hours. After cooling to room temperature, the reaction mixture was neutralized to pH 7 using a NaOH aqueous solution at about 0 °C, and the resultant mixture was extracted using ethyl acetate and water three times to obtain an organic layer. The organic layer thus obtained was dried over magnesium sulfate and concentrated to synthesize Intermediate Compound 36-d (yield 92%).

### 5) Synthesis of Intermediate Compound 36-e

1,3-Dibromobenzene (1.2 eq), Intermediate Compound 36-d (1.0 eq), Cui (10 mol%), a BPPO ligand (10 mol%) and potassium phosphate tribasic (2.0 eq) were dissolved in DMF (0.1 M), followed by stirring at about 160 °C for about 10 hours. After cooling the reaction product to room temperature, DMF was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 10 by a volume ratio) to synthesize Intermediate Compound 36-e (yield 60%).

### 6) Synthesis of Intermediate Compound 36-f

Intermediate Compound 36-e (1.0 eq), 1-b (1.2 eq), Pd₂(dba)₃ (5 mol%), Sphos (7 mol%) and sodium tert-butoxide (2.0 eq) were dissolved in toluene (0.1 M), followed by stirring at about 110 °C for about 3 hours. After cooling the reaction product to room temperature, toluene was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 4 by a volume ratio) to synthesize Intermediate Compound 36-f (yield 86%).

### 7) Synthesis of Intermediate Compound 36-g

Intermediate Compound 36-f (1.0 eq) was dissolved in triethyl orthoformate (30 eq), and 37wt% HCl (1.5 eq) was added thereto, followed by stirring at about 80 °C for about 12 hours. After cooling at room temperature, triethyl orthoformate was concentrated, and the resultant product was extracted using dichloromethane and water three times to obtain an organic layer. The organic layer thus obtained was dried over magnesium sulfate and concentrated, and the resultant crude product was separated by column chromatography (MC: 5 vol% of methanol) to synthesize Intermediate Compound 36-g (yield 89%).

### 8) Synthesis of Intermediate Compound 36-h

Intermediate Compound 36-g (1.0 eq) and ammonium hexafluorophosphate (3.0 eq) were dissolved in methanol (0.5 M), and distilled water was added thereto, followed by stirring at room temperature for about 5 hours. The resultant product was washed with distilled water and filtered to obtain a solid. The solid was extracted using dichloromethane and water three times to obtain an organic layer. The organic layer thus obtained was dried over magnesium sulfate and concentrated to synthesize Intermediate Compound 36-h (yield 95%).

### 9) Synthesis of Compound 36

Intermediate Compound 36-h (1.0 eq), dichloro(1,5-cyclooctadiene)platinum(II) (1.1 eq) and sodium acetate (2.0 eq) were dissolved in anhydrous 1,4-dioxane (0.05 M), followed by stirring under nitrogen conditions at about 120 °C for about 4 days. After cooling at room temperature, the resultant product was extracted using dichloromethane and water three times to obtain an organic layer. The organic layer thus obtained was dried over magnesium sulfate and concentrated, and the resultant crude product was separated by column chromatography (30 vol% of MC: hexane) to synthesize Compound 36 (yield 23%).

### (3) Synthesis of Compound 60

Compound 60 according to an embodiment may be synthesized by, for example, the steps of Reaction 3 below.

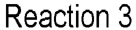

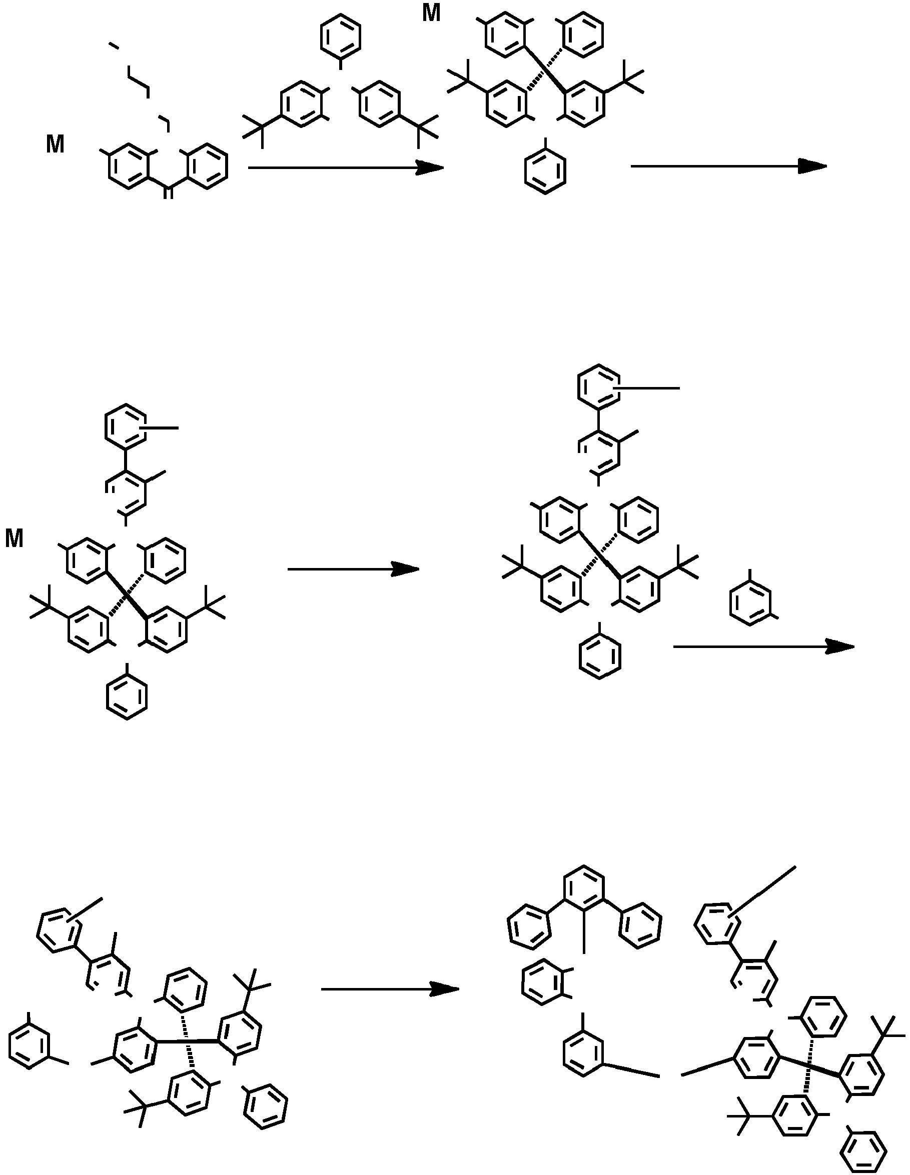

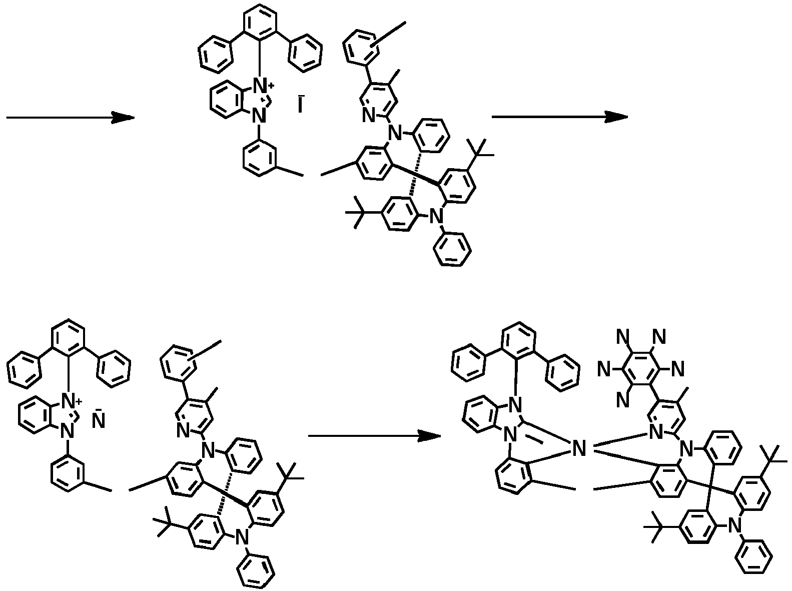

### 1) Synthesis of Intermediate Compound 60-a

2-Bromo-4-(tert-butyl)-N-(4-(tert-butyl)phenyl)-N-phenylaniline (1.0 eq) was dissolved in anhydrous THF (0.3 M), and 1.6 M of n-BuLi (1.1 eq) was slowly added thereto at about -78 °C, followed by stirring for about 2 hours. To the resultant product, a solution in which 3-methoxy-10-((2-methoxyethoxy)methyl)acridin-9(10H)-one (1.0 eq) was dissolved in anhydrous THF (0.2 M) was added and stirred at room temperature for about 20 hours. Then, a HCl aqueous solution (2.0 eq) was added thereto and stirred again for about 20 hours to obtain a reaction product. The reaction product was neutralized using K₂CO₃ and filtered using silica gel to synthesize Intermediate Compound 60-a (yield 52%).

### 2) Synthesis of Intermediate Compound 60-b

Intermediate Compounds 60-a (1.1 eq) and 36-a (1.0 eq), Pd₂(dba)₃ (5 mol%), Sphos (7 mol%) and sodium tert-butoxide (2.0 eq) were dissolved in toluene (0.1 M) and stirred at about 110 °C for about 12 hours to obtain a reaction product. After cooling to room temperature, the reaction product was extracted using dichloromethane and water three times to obtain an organic layer. The organic layer thus obtained was dried over magnesium sulfate and concentrated, and the crude product thus obtained was separated by column chromatography (EA: hexane = 1: 10 by a volume ratio) to synthesize Intermediate Compound 60-b (yield 71%).

### 3) Synthesis of Intermediate Compound 60-c

Intermediate Compound 60-b (1.0 eq), HBr and acetic acid were stirred at about 120 °C for about 16 hours. After cooling to room temperature, the reaction mixture was neutralized to pH 7 using a NaOH aqueous solution at about 0 °C, and the resultant mixture was extracted using ethyl acetate and water three times to obtain an organic layer. The organic layer thus obtained was dried over magnesium sulfate and concentrated to synthesize Intermediate Compound 60-c (yield 92%).

### 4) Synthesis of Intermediate Compound 60-d

1,3-Dibromobenzene (1.2 eq), Intermediate Compound 60-c (1.0 eq), Cui (10 mol%), a BPPO ligand (10 mol%) and potassium phosphate tribasic (2.0 eq) were dissolved in DMF (0.1 M), followed by stirring at about 160°C for about 10 hours. After cooling the reaction product to room temperature, DMF was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 10 by a volume ratio) to synthesize Intermediate Compound 60-d (yield 67%).

### 5) Synthesis of Intermediate Compound 60-e

Intermediate Compounds 60-d (1.0 eq) and 1-b (1.2 eq), Pd₂(dba)₃ (5 mol%), Sphos (7 mol%) and sodium tert-butoxide (2.0 eq) were dissolved in toluene (0.1 M), followed by stirring at about 110 °C for about 3 hours. After cooling the reaction product to room temperature, toluene was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 4 by a volume ratio) to synthesize Intermediate Compound 60-e (yield 80%).

### 6) Synthesis of Intermediate Compound 60-f

Intermediate Compound 60-e (1.0 eq) was dissolved in triethyl orthoformate (30 eq), and 37wt% HCl (1.5 eq) was added thereto, followed by stirring at about 80 °C for about 12 h. After cooling at room temperature, triethyl orthoformate was concentrated, and the resultant product was extracted using dichloromethane and water three times to obtain an organic layer. The organic layer thus obtained was dried over magnesium sulfate and concentrated, and the resultant crude product was separated by column chromatography (MC: 5 vol% of methanol) to synthesize Intermediate Compound 60-f (yield 88%).

### 7) Synthesis of Intermediate Compound 60-g

Intermediate Compound 60-f (1.0 eq) and ammonium hexafluorophosphate (3.0 eq) were dissolved in methanol (0.5 M), and distilled water was added thereto, followed by stirring at room temperature for about 5 hours. The resultant product was washed with distilled water and filtered to obtain a solid. The solid was extracted using dichloromethane and water three times to obtain an organic layer. The organic layer thus obtained was dried over magnesium sulfate and concentrated to synthesize Intermediate Compound 60-g (yield 93%).

### 8) Synthesis of Compound 60

Intermediate Compound 60-g (1.0 eq), dichloro(1,5-cyclooctadiene)platinum(II) (1.1 eq) and sodium acetate (2.0 eq) were dissolved in anhydrous 1,4-dioxane (0.05 M), followed by stirring under nitrogen conditions at about 120 °C for about 4 days. After cooling at room temperature, the resultant product was extracted using dichloromethane and water three times to obtain an organic layer. The organic layer thus obtained was dried over magnesium sulfate and concentrated, and the resultant crude product was separated by column chromatography (30 vol% of MC: hexane) to synthesize Compound 60 (yield 25%).

### (4) Synthesis of Compound 97

Compound 97 according to an embodiment may be synthesized by, for example, the steps of Reaction 4 below.

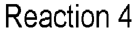

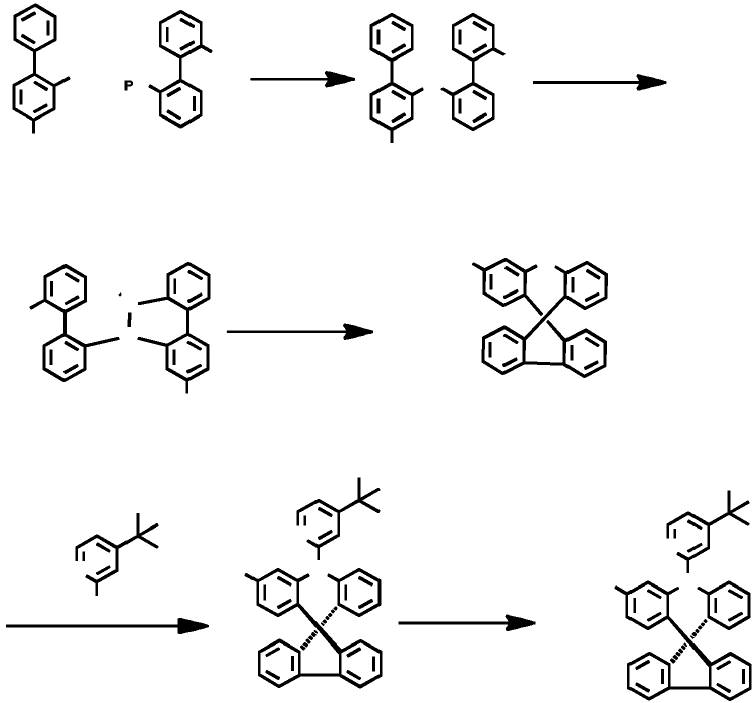

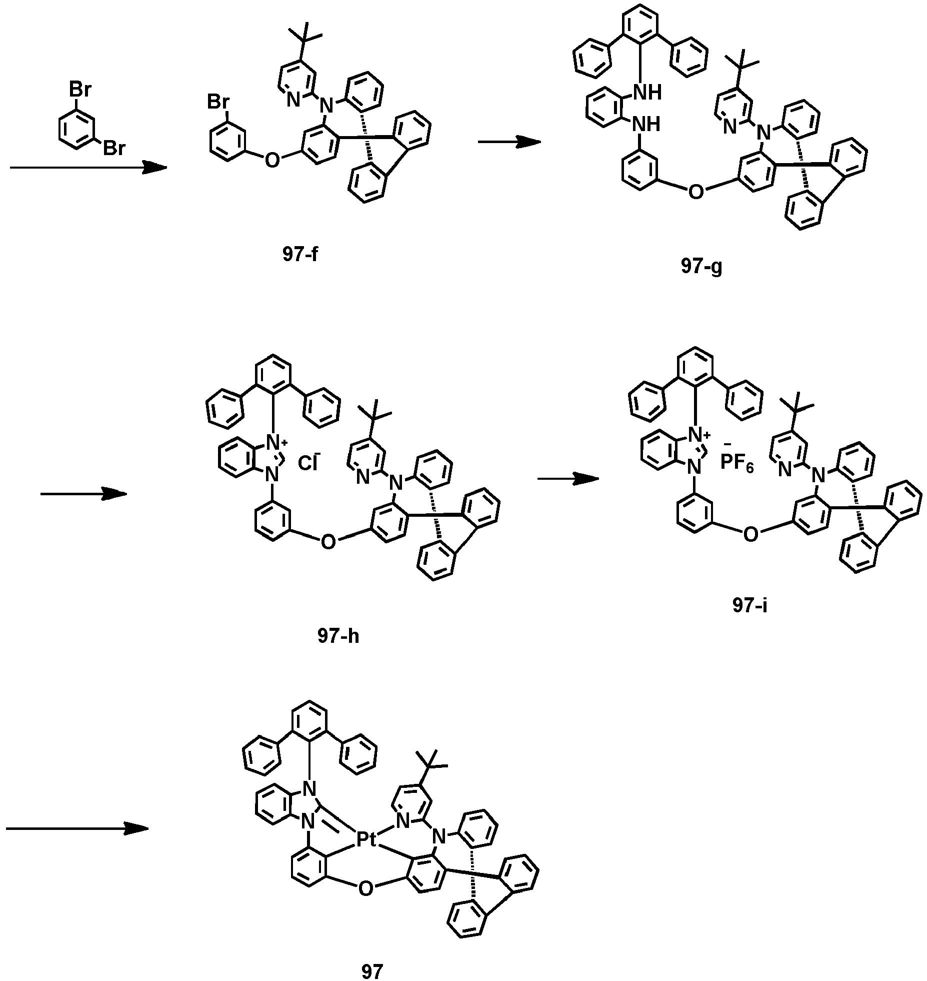

### 1) Synthesis of Intermediate Compound 97-a

2-lodo-4-methoxy-1,1'-biphenyl (1.5 eq), 2'-bromo-[1,1'-biphenyl]-2-amine (1.0 eq), 2,2'-bis(diphenylphosphino)-1,1'-binaphthalene (0.4 eq), Pd(OAc)₂ (10 mol%) and sodium tert-butoxide (1.5 eq) were dissolved in toluene (0.1 M) and stirred at about 110 °C for about 18 hours to obtain a reaction product. After cooling the reaction product to room temperature, toluene was removed by distilling under a reduced pressure, and the reaction product was extracted using dichloromethane and water three times to obtain an organic layer. The organic layer thus obtained was dried over magnesium sulfate and concentrated, and the crude product thus obtained was separated by column chromatography (MC: hexane = 1: 10 by a volume ratio) to synthesize Intermediate Compound 97-a (yield 60%).

### 2) Synthesis of Intermediate Compound 97-b

Intermediate 97-a (1.0 eq) was dissolved in a 1,2-dichlorobenzene (0.025 M) solvent under nitrogen conditions. To the mixture, a 1.0 M BBrs solution in MC (1.2 eq) was added and stirred at about 190 °C for about 18 hours to obtain a reaction product. After cooling to room temperature, the solvent was removed under a reduced pressure. The resultant reaction product was extracted using dichloromethane and water three times to obtain an organic layer. The organic layer thus obtained was dried over magnesium sulfate and concentrated, and the crude product thus obtained was separated by column chromatography (MC: hexane = 1: 4 by a volume ratio) to synthesize Intermediate Compound 97-b (yield 60%).

### 3) Synthesis of Intermediate Compound 97-c

Intermediate Compound 97-b (1.0 eq), Pd(PPh₃)₄ (5 mol%) and K₂CO₃ (2.0 eq) were dissolved in dimethoxyethane (DME): water (volume ratio = 3: 1, 0.1 M), followed by stirring under nitrogen conditions at about 120 °C for about 18 hours to obtain a reaction product. After cooling to room temperature, the reaction product was extracted using dichloromethane and water three times to obtain an organic layer. The organic layer thus obtained was dried over magnesium sulfate and concentrated, and the resultant crude product was separated using column chromatography (MC: hexane = 1: 20 by a volume ratio) to synthesize Intermediate Compound 97-c (yield 36%).

### 4) Synthesis of Intermediate Compound 97-d

Intermediate Compound 97-c (1.1 eq), 2-bromo-4-tert-butyl-pyridine (1.0 eq), Pd₂(dba)₃ (5 mol%), Sphos (7 mol%) and sodium tert-butoxide (2.0 eq) were dissolved in toluene (0.1 M) and stirred at about 110 °C for about 12 hours to obtain a reaction product. After cooling to room temperature, the reaction product was extracted using dichloromethane and water three times to obtain an organic layer. The organic layer thus obtained was dried over magnesium sulfate and concentrated, and the crude product thus obtained was separated by column chromatography (EA: hexane = 1: 4 by a volume ratio) to synthesize Intermediate Compound 97-d (yield 71%).

### 5) Synthesis of Intermediate Compound 97-e

Intermediate Compound 97-d (1.0 eq), HBr and acetic acid were stirred at about 120 °C for about 16 hours. After cooling to room temperature, the reaction mixture was neutralized to pH 7 using a NaOH aqueous solution at about 0°C, and the resultant mixture was extracted using ethyl acetate and water three times to obtain an organic layer. The organic layer thus obtained was dried over magnesium sulfate and concentrated to synthesize Intermediate Compound 97-e (yield 91%).

### 6) Synthesis of Intermediate Compound 97-f

1,3-Dibromobenzene (1.2 eq), Intermediate Compound 97-e (1.0 eq), Cui (10 mol%), a BPPO ligand (10 mol%) and potassium phosphate tribasic (2.0 eq) were dissolved in DMF (0.1 M), followed by stirring at about 160°C for about 10 hours. After cooling the reaction product to room temperature, DMF was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 10 by a volume ratio) to synthesize Intermediate Compound 97-f (yield 54%).

### 7) Synthesis of Intermediate Compound 97-g

Intermediate Compounds 97-f (1.0 eq) and [1-b] (1.2 eq), Pd₂(dba)₃ (5 mol%), Sphos (7 mol%) and sodium tert-butoxide (2.0 eq) were dissolved in toluene (0.1 M), followed by stirring at about 110 °C for about 3 hours. After cooling the reaction product to room temperature, toluene was removed under a reduced pressure, and the resultant product was extracted using dichloromethane and water three times to obtain an organic layer. The organic layer thus obtained was dried over magnesium sulfate and concentrated, and the resultant crude product was separated by column chromatography (EA: hexane = 1: 4 by a volume ratio) to synthesize Intermediate Compound 97-g (yield 90%).

### 8) Synthesis of Intermediate Compound 97-h

Intermediate Compound 97-g (1.0 eq) was dissolved in triethyl orthoformate (30 eq), and 37wt% HCl (1.5 eq) was added thereto, followed by stirring at about 80 °C for about 12 hours. After cooling at room temperature, triethyl orthoformate was concentrated, and the resultant product was extracted using dichloromethane and water three times to obtain an organic layer. The organic layer thus obtained was dried over magnesium sulfate and concentrated, and the resultant crude product was separated by column chromatography (MC: 5 vol% of methanol) to synthesize Intermediate Compound 97-h (yield 83%).

### 9) Synthesis of Intermediate Compound 97-i

Intermediate Compound 97-h (1.0 eq) and ammonium hexafluorophosphate (3.0 eq) were dissolved in methanol (0.5 M), and distilled water was added thereto, followed by stirring at room temperature for about 5 hours. The resultant product was washed with distilled water and filtered to obtain a solid. The solid was extracted using dichloromethane and water three times to obtain an organic layer. The organic layer thus obtained was dried over magnesium sulfate and concentrated to synthesize Intermediate Compound 97-i (yield 97%).

### 10) Synthesis of Compound 97

Intermediate Compound 97-i (1.0 eq), dichloro(1,5-cyclooctadiene)platinum(II) (1.1 eq) and sodium acetate (2.0 eq) were dissolved in anhydrous 1,4-dioxane (0.05 M), followed by stirring under nitrogen conditions at about 120 °C for about 4 days. After cooling at room temperature, the resultant product was extracted using dichloromethane and water three times to obtain an organic layer. The organic layer thus obtained was dried over magnesium sulfate and concentrated, and the resultant crude product was separated by column chromatography (30 vol% of MC: hexane) to synthesize Compound 97 (yield 25%).

### 2. Manufacture and evaluation of light emitting element

### Manufacture of light emitting element

A light emitting element of an embodiment, including an organometallic compound of an embodiment in an emission layer was manufactured by a method below. Light emitting elements of Examples 1 to 4 were manufactured using Compounds 1, 36, 60 and 97 as phosphorescence dopants of emission layers.

The light emitting element of the Comparative Example was manufactured using Comparative Compound X1 as a light emitting dopant material of an emission layer.

### Comparative Compound

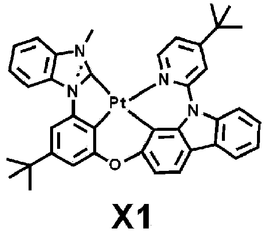

### Other compounds used for the manufacture of elements

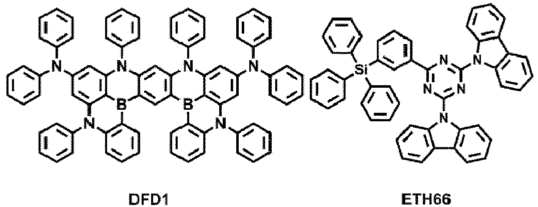

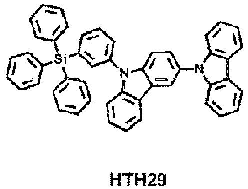

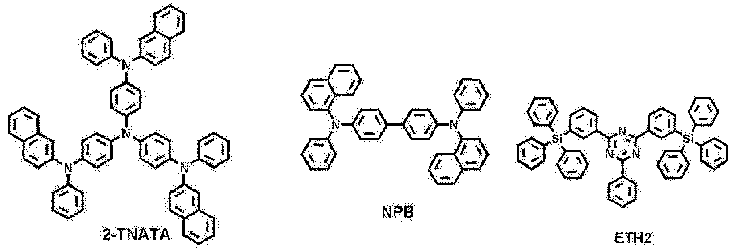

Light emitting elements of embodiments including the organometallic compounds in emission layers were manufactured as follows. Light emitting elements were manufactured using the Example Compounds and the Comparative Compound as dopant materials of emission layers as shown in Table 1.

For example, a glass substrate on which ITO of 15 Ω/cm² (1200 Å) was formed of Corning Co., as a substrate and a first electrode, was cut into a size of 50 mm x 50 mm x 0.7 mm, washed by ultrasonic waves using isopropyl alcohol and pure water for about 5 minutes each, and cleaned by exposing to ultraviolet rays for about 30 minutes and exposing to ozone, and the glass substrate was installed in a vacuum deposition apparatus.

Then, 2-TNATA was vacuum deposited on the ITO formed on the glass substrate to form a hole injection layer with a thickness of about 600 Å, and on the hole injection layer, NPB was vacuum deposited to form a hole transport layer with a thickness of about 300 Å.

On the hole transport layer, ETH66 (second compound) and HTH29 (third compound) (weight ratio of 3:7), which were co-hosts, and the Example Compounds or Comparative Compound were co-deposited such that the weight ratio of the co-hosts and the dopant became 90:10 to form an emission layer with a thickness of about 400 Å.

On the emission layer, ETH2 was deposited to form a hole blocking layer with a thickness of about 50 Å, and on the hole blocking layer, Alqs was deposited to form an electron transport layer with a thickness of about 300 Å. Then on the electron transport layer, LiF was deposited to form an electron injection layer with a thickness of about 10 Å, and on the electron injection layer, Al was vacuum deposited to form a second electrode with a thickness of about 3000 Å to manufacture a light emitting element.

In some embodiments, a light emitting element of Example 5 was manufactured by using the same method as in Example 1 except for vacuum depositing during forming the emission layer, Compound 1 (first compound), Compound ETH66 (second compound), Compound HTH29 (third compound) and Compound DFD1 (fourth compound) instead of Compound 1 (first compound), Compound ETH66 (second compound) and Compound HTH29 (third compound) on the hole transport layer. Here, the amount of Compound 1 was about 10 wt% per the total weight (100 wt%) of the emission layer, the amount of Compound DFD1 was about 0.5 wt% per the total weight (100 wt%) of the emission layer, and the weight ratio of Compound ETH66 and Compound HTH29 was controlled to 3:7.

### Evaluation of properties of light emitting element

In Table 1, the evaluation results of the light emitting elements of Example 1, Example 2, and the Comparative Example are shown. In Table 1, ³MLCT, ³MC, the predicted values of the maximum emission wavelength (λmax) and the measured values of the maximum emission wavelength are shown. Metal to ligand charge transfer (³MLCT) and 3 metal centered state (³MC) energy were quantum simulated according to a B3LYP DFT calculation method, and the results are shown.

**Table 1**

| Element | Dopant | ³MLCT | Predicted value of λmax | Measured value of λmax | ³MC |
|---|---|---|---|---|---|
| | | (%) | (nm) | (nm) | (kcal/mol) |
| Comparative Example | X1 | 8.8 | 468 | 471 | 0.21 |
| Example 1 | 1 | 12.2 | 463 | 458 | 0.42 |
| Example 2 | 36 | 12.3 | 464 | 457 | 0.41 |
| Example 3 | 60 | 12.2 | 463 | 457 | 0.42 |
| Example 4 | 97 | 12.6 | 444 | 456 | 0.45 |

Referring to the results of Table 1, it could be confirmed that the light emitting elements of Example 1 and Example 2 had higher ³MLCT values, higher ³MC values, and shorter wavelengths of the maximum emission wavelength when compared to the light emitting element of the Comparative Example.

The light emitting elements of the Examples had higher ³MLCT values and higher ³MC values when compared to the light emitting element of the Comparative Example, and may have high emission efficiency. In some embodiments, the light emitting elements of the Examples had shorter wavelengths of the maximum emission wavelength when compared to the light emitting element of the Comparative Example, and may emit blue light with high purity (higher purity than Comparative Example).

The driving voltage (V) at about 1000 cd/m², emission efficiency (cd/A), color change efficiency (cd/A/y), maximum emission wavelength (nm) and life (T₉₀) of the light emitting elements of Examples 1 to 5 were measured using Keithley MU 236 and a luminance meter of PR650, and the results are shown in Tables 2 and 3. In Table 3, the life (T₉₀) was obtained by measuring time (hr) taken for reaching 90% of luminance in contrast to initial luminance.

**Table 2**

| No. | Dopant | Host | | Delayed fluoresce nce dopant | Luminan ce (cd/m²) | Driving voltage (V) | Emissio n efficien cy (cd/A) |
|---|---|---|---|---|---|---|---|
| | First compou nd | Second compou nd | Third compou nd | Fourth compou nd | | | |
| Example 1 | 1 | ETH66 | HTH29 | - | 1000 | 4.8 | 54 |
| Example 2 | 36 | ETH66 | HTH29 | - | 1000 | 4.8 | 51 |
| Example 3 | 60 | ETH66 | HTH29 | - | 1000 | 4.9 | 53 |
| Example 4 | 97 | ETH66 | HTH29 | - | 1000 | 4.9 | 54 |
| Example 5 | 1 | ETH66 | HTH29 | DFD1 | 1000 | 4.8 | 60 |
| Comparati ve Example 1 | X1 | ETH66 | HTH29 | - | 1000 | 5.0 | 22 |

Referring to Table 2, it could be confirmed that the light emitting elements of Example 1 to Example 5 had lower driving voltages and higher emission efficiency when compared to Comparative Example 1. Through this, it could be found that when the first compound of the Example was included in an emission layer, the driving voltage and emission efficiency of the light emitting element were improved (increased). For example, when the second and third compounds were included together with the first compound in an emission layer, as in Example 1 to Example 4, and when the second to fourth compounds were included together with the first compound in an emission layer, as in Example 5, it could be confirmed that the driving voltage and emission efficiency were improved (increased) in all cases.

**Table 3**

| No. | Dopant | Host | | Delayed fluoresce nce dopant | Color change efficien cy (cd/A/y) | Maximum emission wavelength (nm) | Life (T₉₀)(hr ) |
|---|---|---|---|---|---|---|---|
| | First compound | Second compound | Third compound | Fourth compound | | | |
| Example 1 | 1 | ETH66 | HTH29 | - | 380 | 458 | 70 |
| Example 2 | 36 | ETH66 | HTH29 | - | 360 | 457 | 71 |
| Example 3 | 60 | ETH66 | HTH29 | - | 375 | 457 | 68 |
| Example 4 | 97 | ETH66 | HTH29 | - | 380 | 456 | 63 |
| Example 5 | 1 | ETH66 | HTH29 | DFD1 | 498 | 457 | 97 |
| Comparat ive Example 1 | X1 | ETH66 | HTH29 | - | 160 | 471 | 53 |

Referring to Table 3, it could be confirmed that the light emitting elements of Example 1 to Example 5 showed higher color change efficiency, lower maximum emission wavelengths, and longer life characteristics when compared to Comparative Example 1. Through this, it could be found that when the first compound of the Example was included in an emission layer, color change efficiency, color purity of blue light and element life were improved. For example, when the second and third compounds were included together with the first compound in an emission layer, as in Example 1 to Example 4, and when the second to fourth compounds were included together with the first compound in an emission layer, as in Example 5, it could be confirmed that color change efficiency, color purity of blue light and element life were improved in all cases.

The organometallic compound of an embodiment includes spirobiacridine and may have a high ³MLCT value, a high ³MC value, and a low maximum emission wavelength. The light emitting element of an embodiment includes the organometallic compound of an embodiment in an emission layer, and may have high emission efficiency, high color purity and long-life characteristics.

The light emitting element of an embodiment includes an organometallic compound having a high ³MLCT value and a high ³MC value, and may show high efficiency properties, high color purity properties and long-life characteristics.

The organometallic compound of an embodiment includes spirobiacridine and may have a high ³MLCT value and a high ³MC value.

The use of "may" when describing embodiments of the present disclosure refers to "one or more embodiments of the present disclosure."

As used herein, the term "substantially," "about," and similar terms are used as terms of approximation and not as terms of degree, and are intended to account for the inherent deviations in measured or calculated values that would be recognized by those of ordinary skill in the art. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Also, any numerical range recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this disclosure is intended to include all higher numerical limitations subsumed therein. Accordingly, Applicant reserves the right to amend this disclosure, including the claims, to expressly recite any sub-range subsumed within the ranges expressly recited herein.

The light emitting element (or device) or any other relevant devices or components according to embodiments of the present disclosure described herein may be implemented utilizing any suitable hardware, firmware (e.g., an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

## Claims

1. A light emitting element (ED), comprising:
a first electrode (EL1);
a second electrode (EL2) on the first electrode (EL1); and
an emission layer (EML) between the first electrode (EL1) and the second electrode (EL2), and comprising a first compound represented by Formula 1, and at least one selected from among second to fourth compounds;
wherein the first compound to the fourth compound are different from each other: 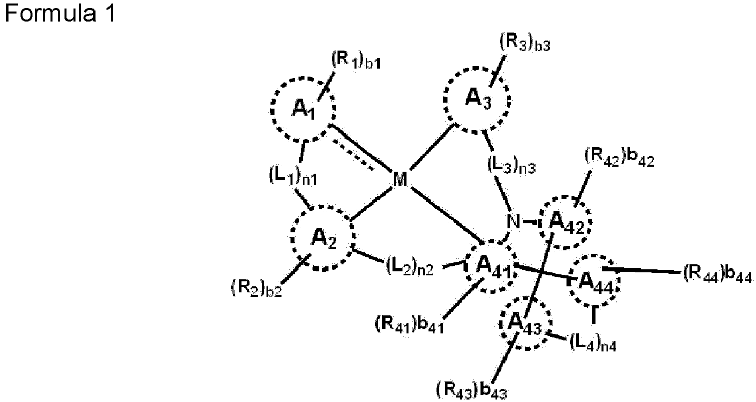 wherein in Formula 1,
M is Pt, Pd, Cu, Ag, Au, Rh, Ir, Ru or Os,
A₁ to A₃, and A₄₁ to A₄₄ are each independently a hydrocarbon ring of 5 to 60 ring-forming carbon atoms, or a heterocycle of 1 to 60 ring-forming carbon atoms,
b1 to b3 are each independently an integer from 0 to 4,
b41 to b44 are each independently an integer from 0 to 4,
L₁ to L₄ are each independently selected from among a direct linkage, *-O-*', *-S-*', *-C(R₁₁)(R₁₂)-*', *-C(R₁₃)=*', *-C(R₁₄)=C(R₁₅)-*', *-C(=O)-*', *-C(=S)-*', *-C≡C-*', *-B(R₁₆)-*', *-N(R₁₇)-*', *-P(R₁₈)(R₁₉)-*', *-Si(R₂₀)(R₂₁)-*', and *-Ge(R₂₂)(R₂₃)-*',
n1 and n3 are each independently an integer from 0 to 3,
n2 and n4 are each independently an integer from 1 to 3,
R₁ to R₃, and R₄₁ to R₄₄ are each independently a hydrogen atom, a deuterium atom, a halogen atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 3 to 30 ring-forming carbon atoms, and
R₁₁ to R₂₃ are each independently a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms.

2. The light emitting element (ED) of claim 1, wherein Formula 1 is represented by Formula 2: 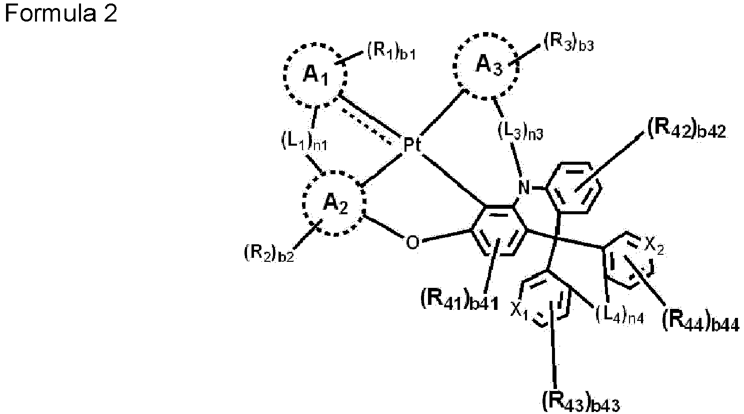 wherein in Formula 2,
X₁ and X₂ are each independently CRa, or N,
Rₐ is a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms,
b41 is an integer from 0 to 2, and
A₁ to A₃, n1, n3, n4, L₁, L₃, L₄, b1 to b3, b42 to b44, R₁ to R₃, and R₄₁ to R₄₄ are the same as defined in Formula 1.

3. The light emitting element (ED) of claim 2, wherein Formula 2 is represented by Formula 3-1 or Formula 3-2: 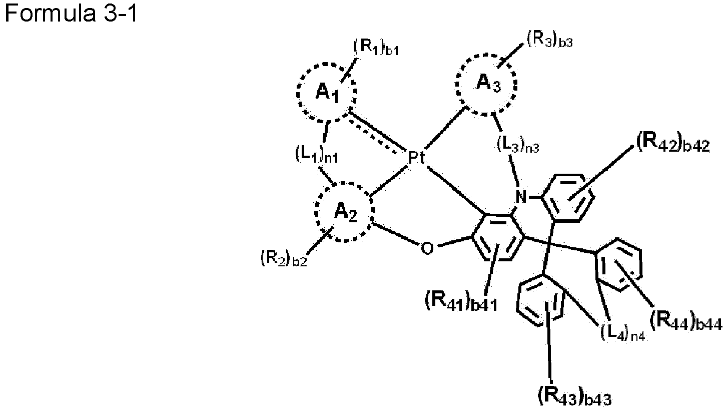 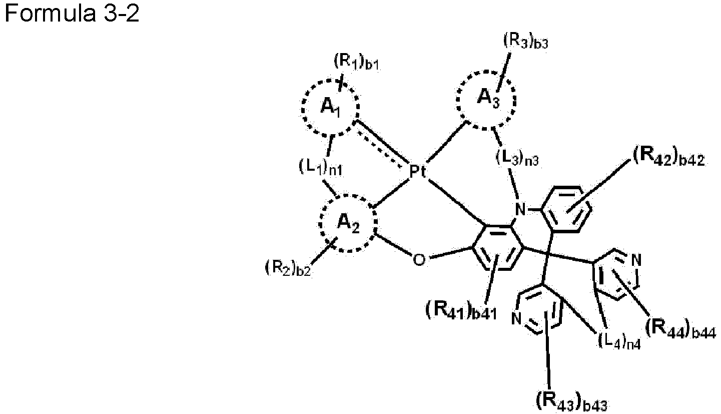 wherein in Formula 3-1 and Formula 3-2, b41 is an integer from 0 to 2, and A₁ to A₃, n1, n3, n4, L₁, L₃, L₄, b1 to b3, b42 to b44, R₁ to R₃, and R₄₁ to R₄₄ are the same as defined in Formula 1.

4. The light emitting element (ED) of claim 3, wherein Formula 3-1 is represented by Formula 3A or Formula 3B: 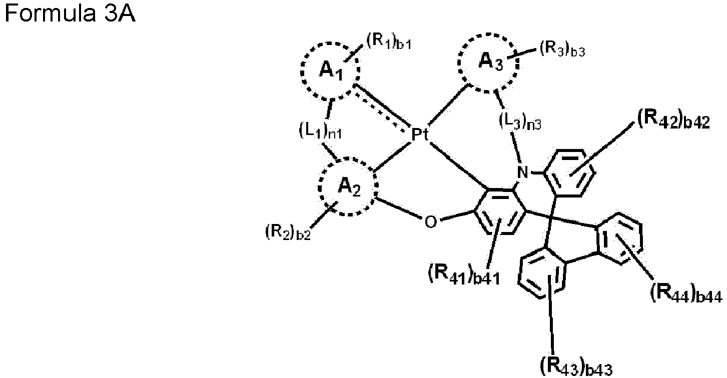 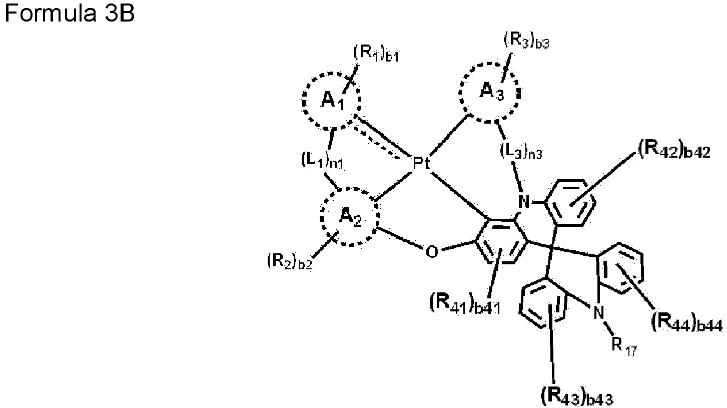 wherein in Formula 3A and Formula 3B, b41 is an integer from 0 to 2, and A₁ to A₃, n1, n3, L₁, L₃, b1 to b3, b42 to b44, R₁ to R₃, R₄₁ to R₄₄, and R₁₇ are the same as defined in Formula 1.

5. The light emitting element (ED) of claim 4, wherein R₁₇ in Formula 3B is a substituted or unsubstituted phenyl group.

6. The light emitting element (ED) of at least one of claims 3 to 5, wherein R₄₃ and R₄₄ in Formula 3-2 are hydrogen atoms.

7. The light emitting element (ED) of at least one of claims 2 to 6, wherein Formula 2 is represented by Formula 4: 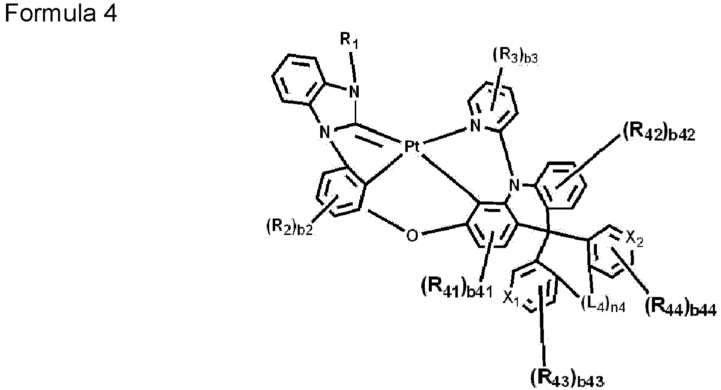 wherein in Formula 4, b41 is an integer from 0 to 2, and n4, L₄, b2, b3, b42 to b44, R₁ to R₃, R₄₁ to R₄₄, X₁, and X₂ are the same as defined in Formula 2.

8. The light emitting element (ED) of at least one of claims 1 to 7, wherein R₁ to R₃, and R₄₁ to R₄₄ are each independently a hydrogen atom, a deuterium atom, a substituted or unsubstituted methyl group, a substituted or unsubstituted t-butyl group, or a substituted or unsubstituted phenyl group.

9. The light emitting element (ED) of at least one of claims 1 to 8, wherein the emission layer (EML) comprises the second compound and the third compound,
the first compound is a phosphorescence dopant, the second compound is a hole transport host, and the third compound is an electron transport host.

10. The light emitting element (ED) of claim 9, wherein the emission layer (EML) further comprises the fourth compound, and the fourth compound is a delayed fluorescence dopant.

11. The light emitting element (ED) of at least one of claims 1 to 10, wherein the emission layer (EML) is configured to emit blue light.

12. The light emitting element (ED) of at least one of claims 1 to 11, wherein the emission layer (EML) comprises at least one selected from among compounds represented in Compound Group 1:

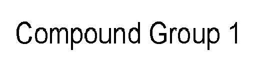

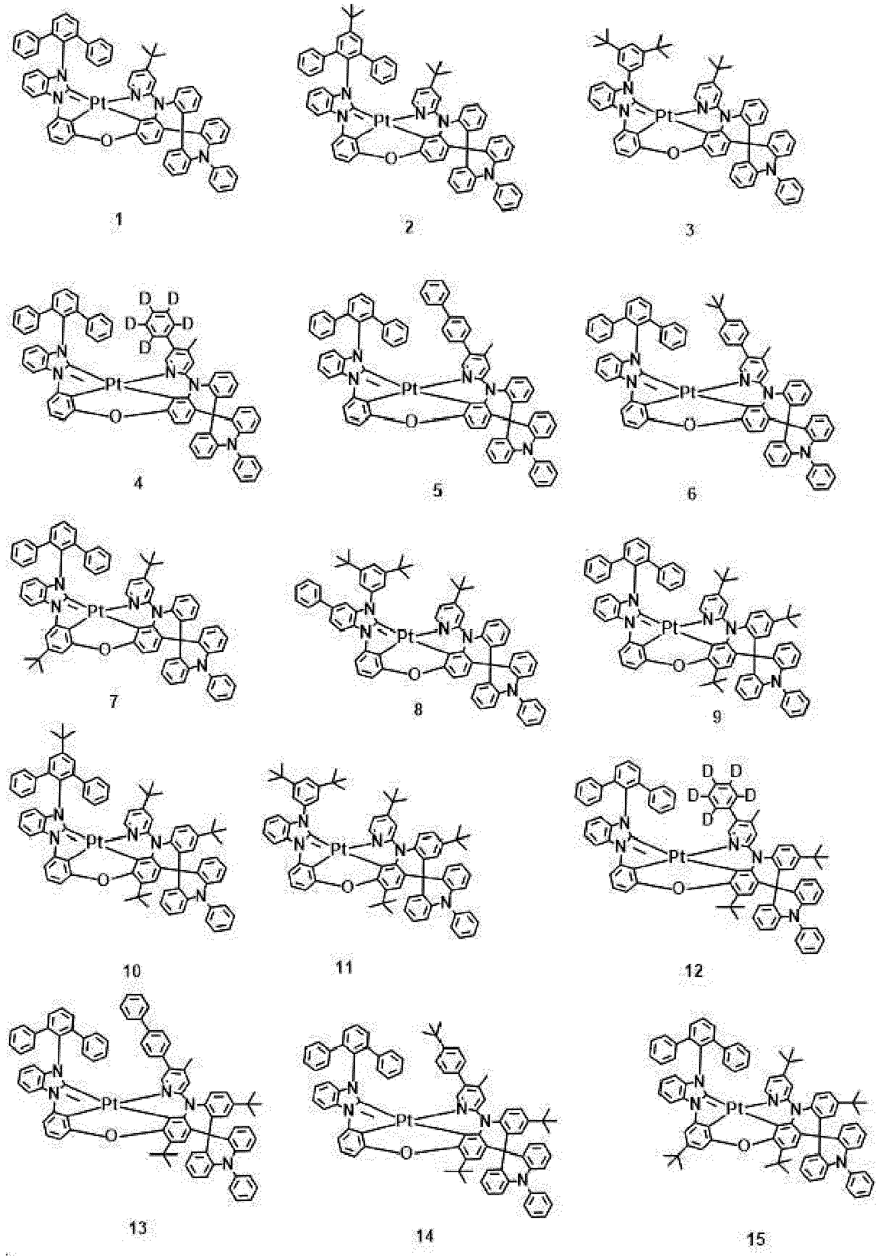

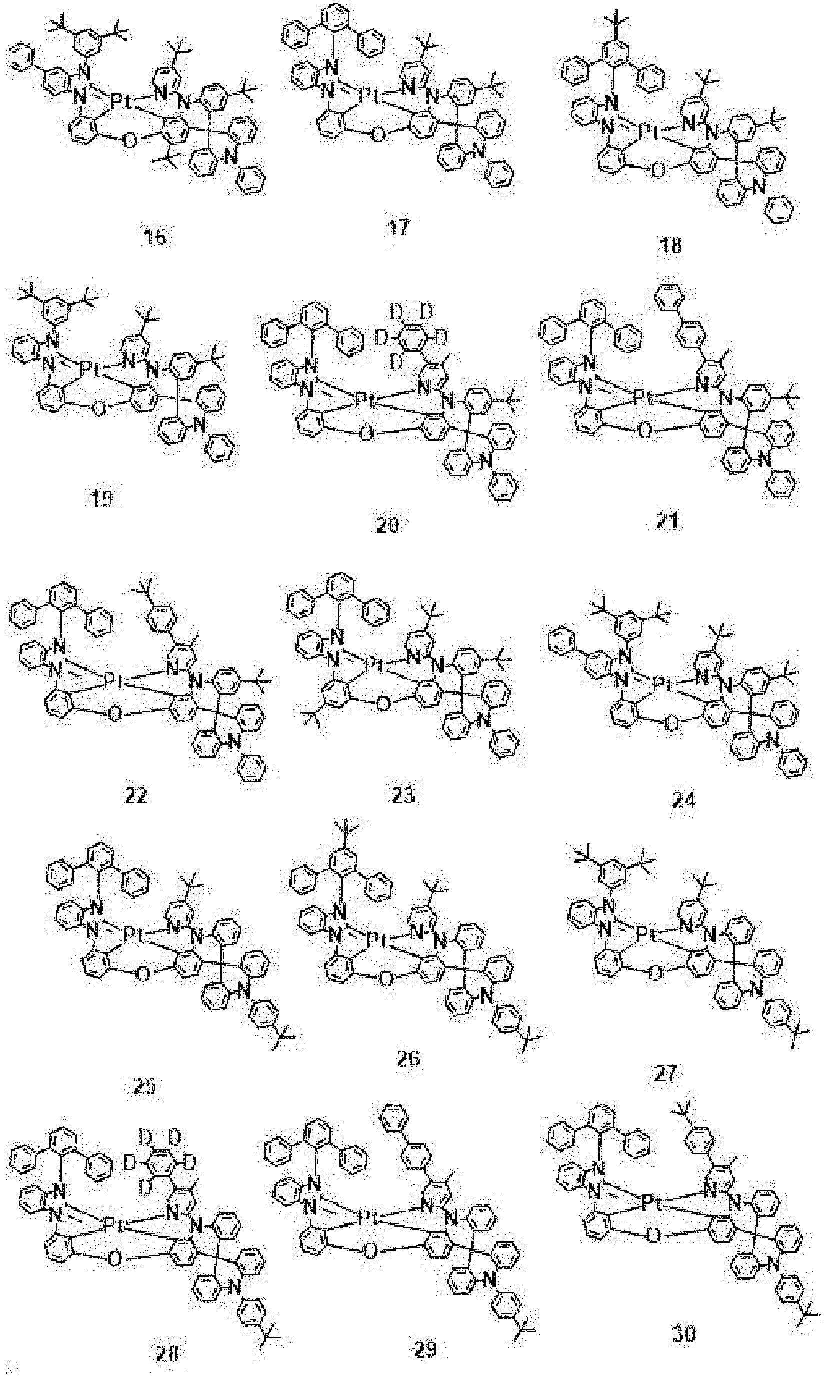

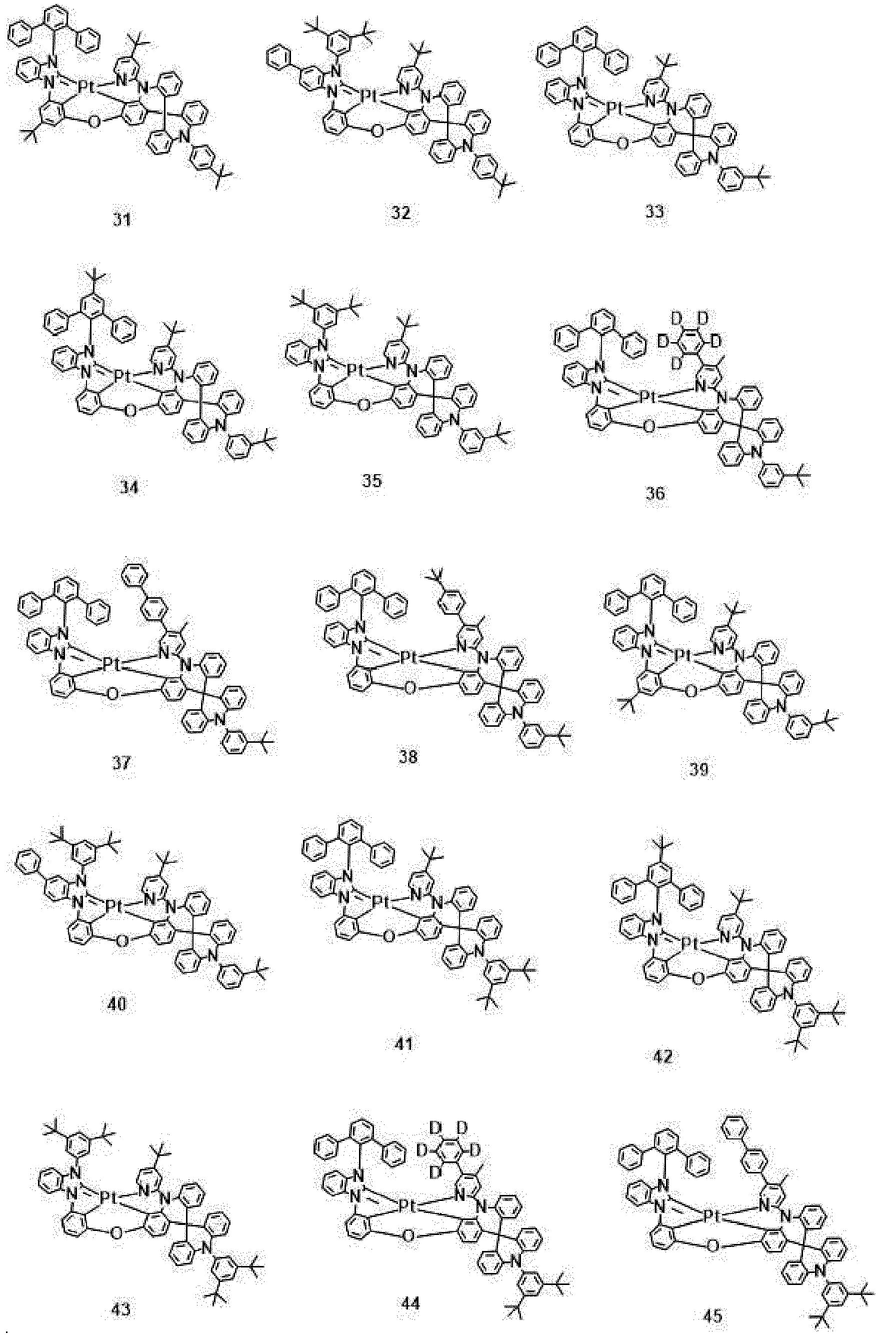

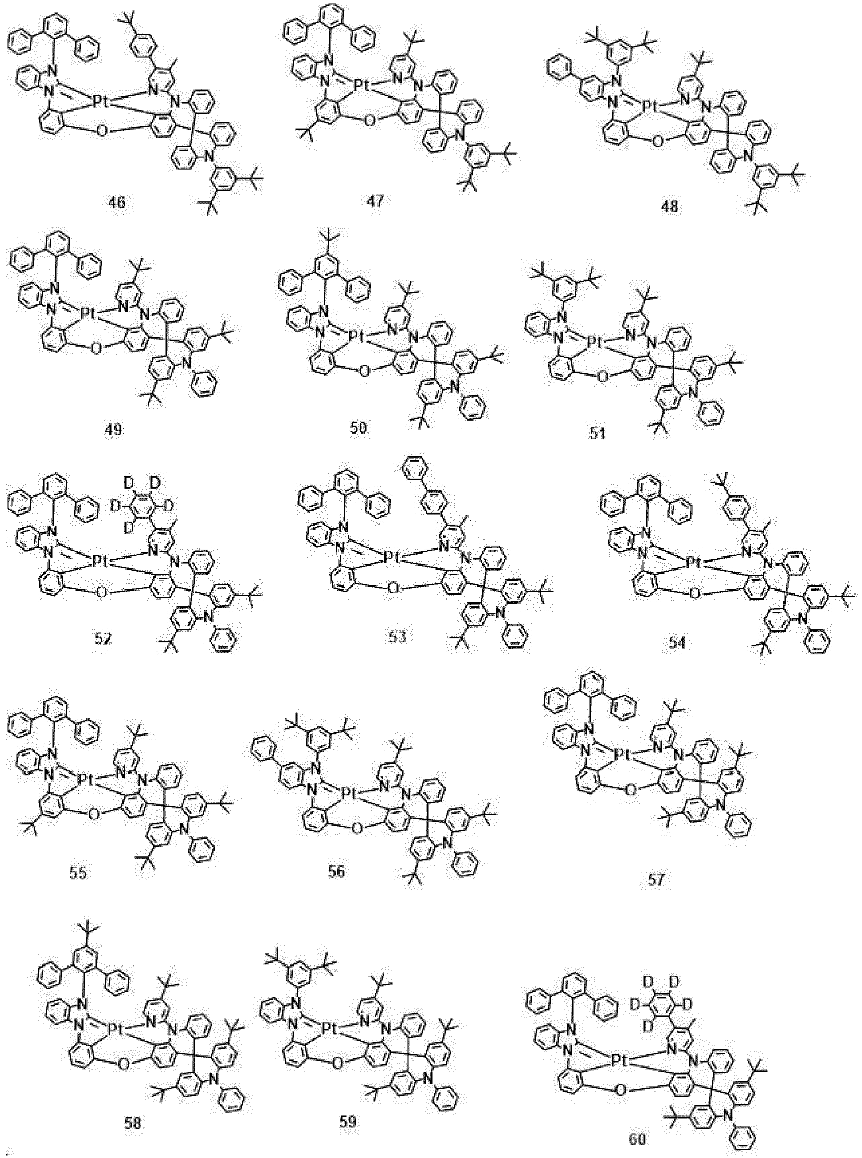

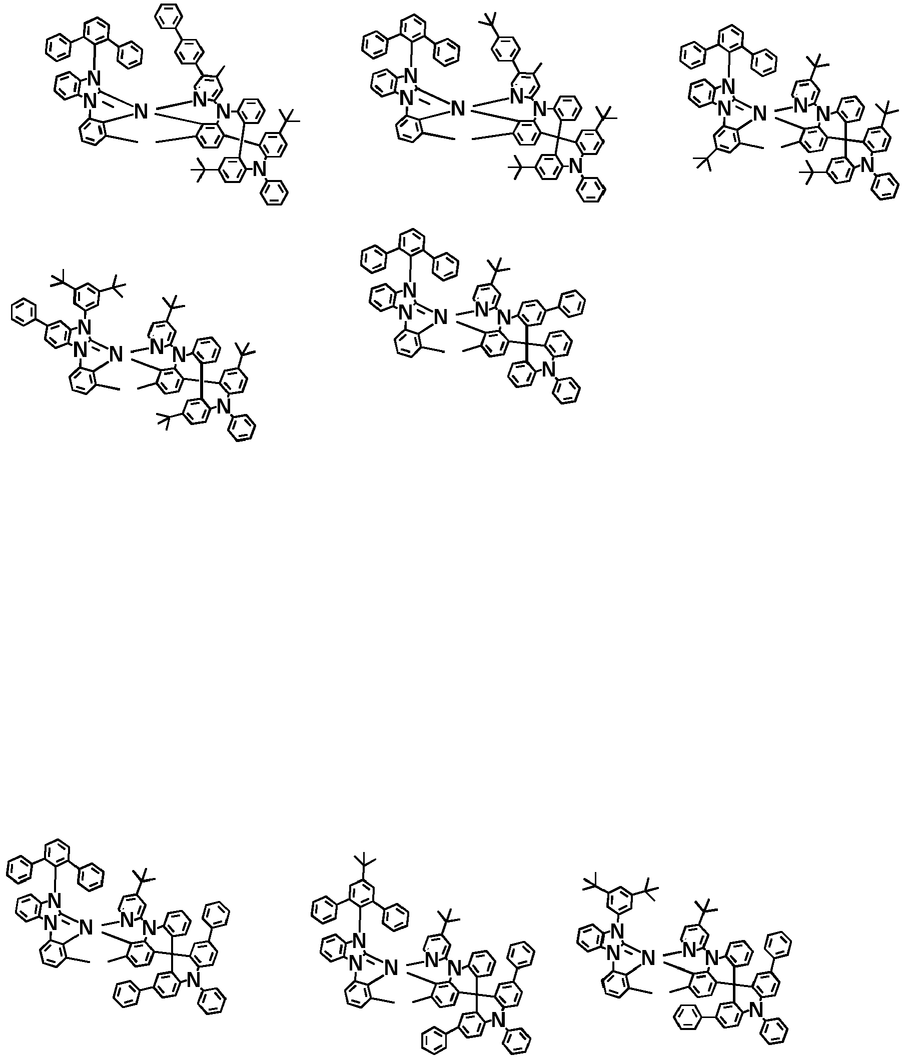

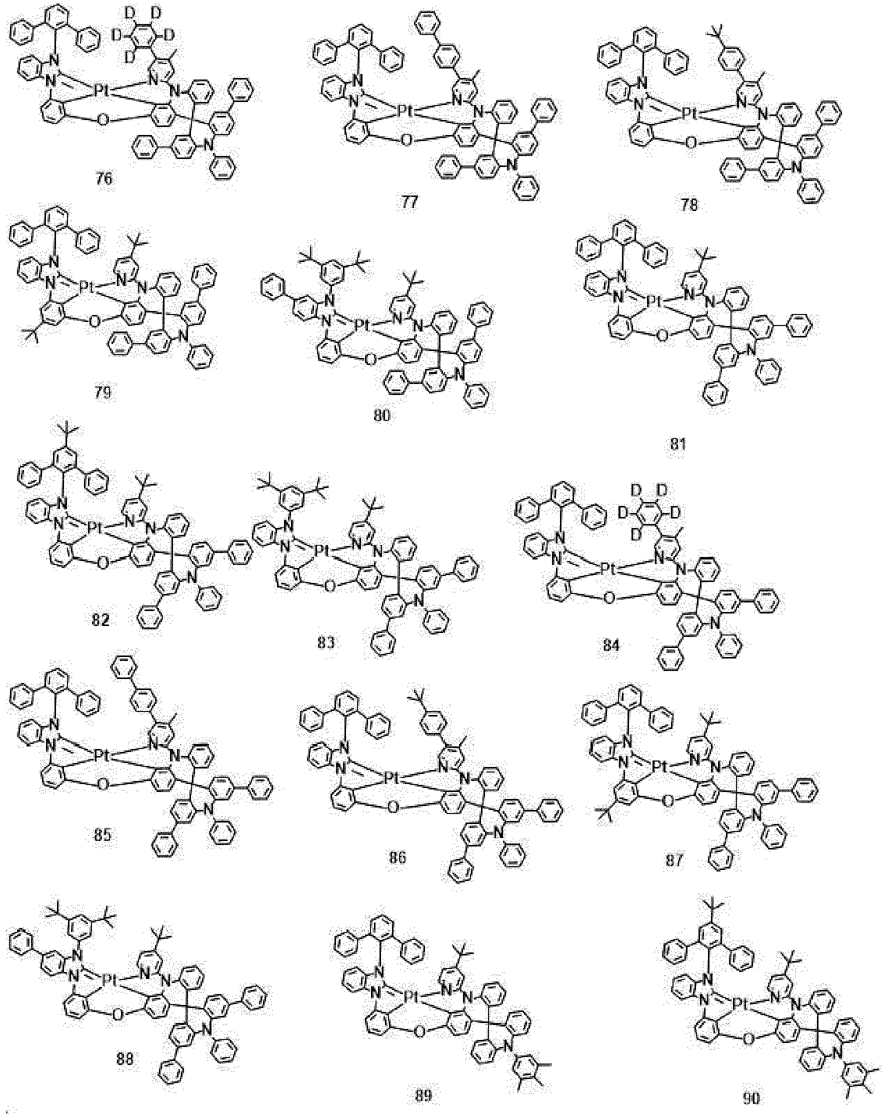

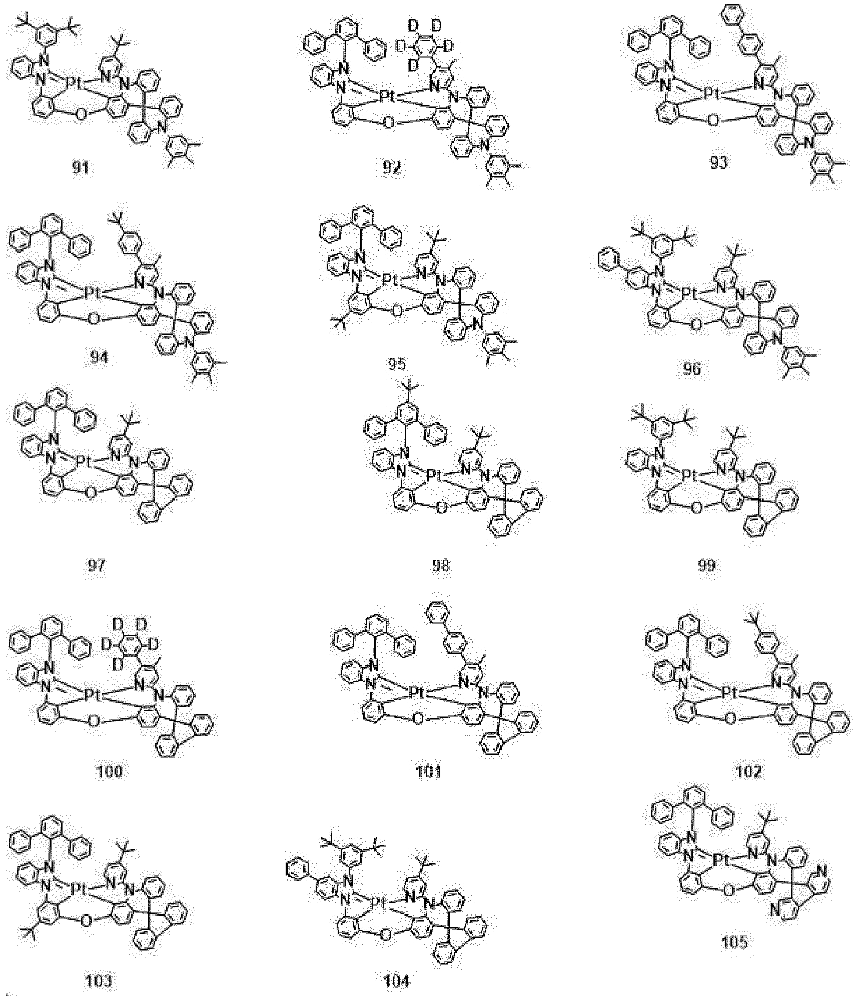

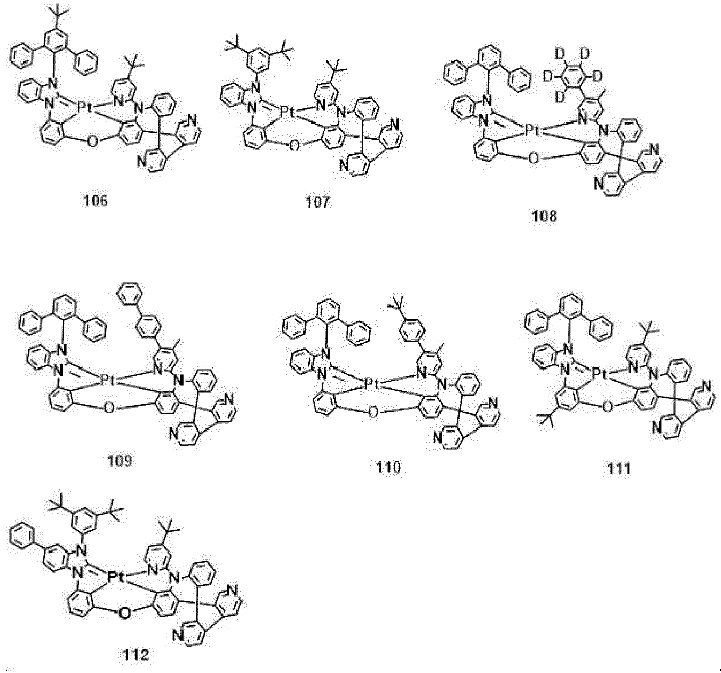

13. An organometallic compound represented by Formula 1: 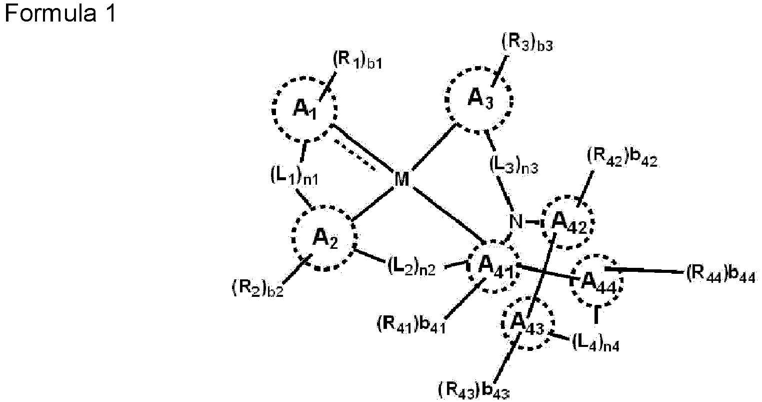 wherein in Formula 1,
M is Pt, Pd, Cu, Ag, Au, Rh, Ir, Ru or Os,
A₁ to A₃, and A₄₁ to A₄₄ are each independently a hydrocarbon ring of 5 to 60 ring-forming carbon atoms, or a heterocycle of 1 to 60 carbon atoms,
b1 to b3 are each independently an integer from 0 to 4,
b41 to b44 are each independently an integer from 0 to 4,
L₁ to L₄ are each independently selected from among a direct linkage, *-O-*', *-S-*', *-C(R₁₁)(R₁₂)-*', *-C(R₁₃)=*', *-C(R₁₄)=C(R₁₅)-*', *-C(=O)-*', *-C(=S)-*', *-C≡C-*', *-B(R₁₆)-*', *-N(R₁₇)-*', *-P(R₁₈)(R₁₉)-*', *-Si(R₂₀)(R₂₁)-*', and *-Ge(R₂₂)(R₂₃)-*',
n1 and n3 are each independently an integer from 0 to 3,
n2 and n4 are each independently an integer from 1 to 3,
R₁ to R₃, and R₄₁ to R₄₄ are each independently a hydrogen atom, a deuterium atom, a halogen atom, a substituted or unsubstituted alkyl group of 1 to 20 carbon atoms, a substituted or unsubstituted aryl group of 6 to 30 ring-forming carbon atoms, or a substituted or unsubstituted heteroaryl group of 3 to 30 ring-forming carbon atoms, and
R₁₁ to R₂₃ are each independently a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms.

14. The organometallic compound of claim 13, wherein Formula 1 is represented by Formula 2: 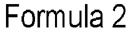 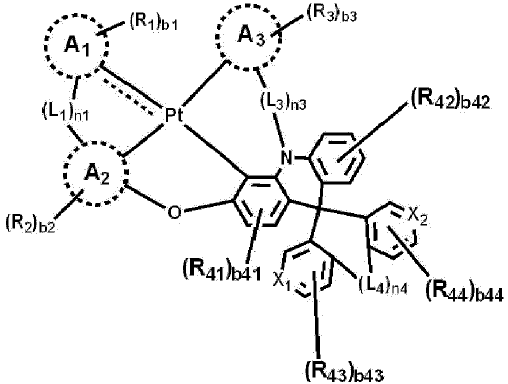 wherein in Formula 2,
X₁ and X₂ are each independently CRa, or N,
Rₐ is a hydrogen atom, a deuterium atom, a halogen atom, a substituted or unsubstituted alkyl group of 1 to 30 carbon atoms, or a substituted or unsubstituted aryl group of 6 to 30 ring-forming carbon atoms,
b41 is an integer from 0 to 2, and
A₁ to A₃, n1, n3, n4, L₁, L₃, L₄, b1 to b3, b42 to b44, R₁ to R₃, and R₄₁ to R₄₄ are the same as defined in Formula 1.

15. The organometallic compound of claim 14, wherein Formula 2 is represented by Formula 3-1 or Formula 3-2: 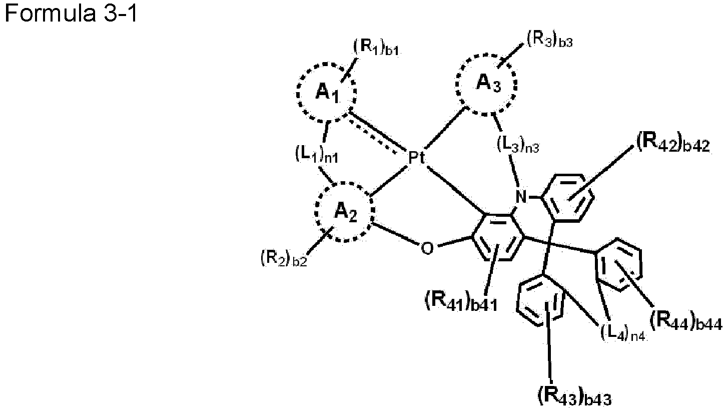 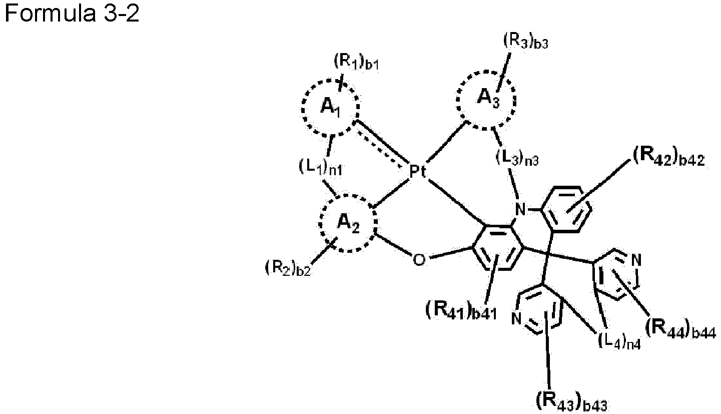 wherein in Formula 3-1 and Formula 3-2, b41 is an integer from 0 to 2, and A₁ to A₃, n1, n3, n4, L₁, L₃, L₄, b1 to b3, b42 to b44, R₁ to R₃, and R₄₁ to R₄₄ are the same as defined in Formula 1.

16. The organometallic compound of claim 15, wherein Formula 3-1 is represented by Formula 3A or Formula 3B: 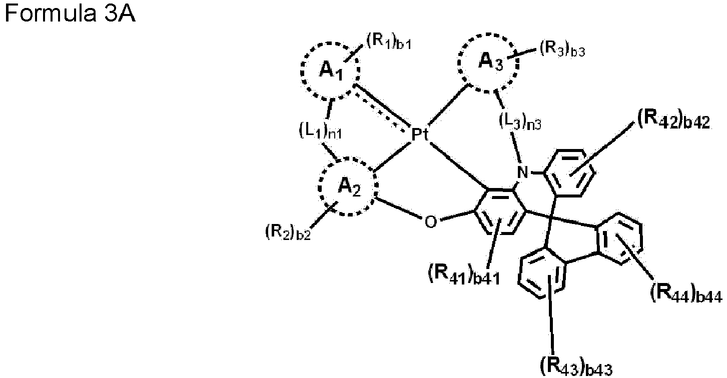 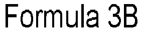 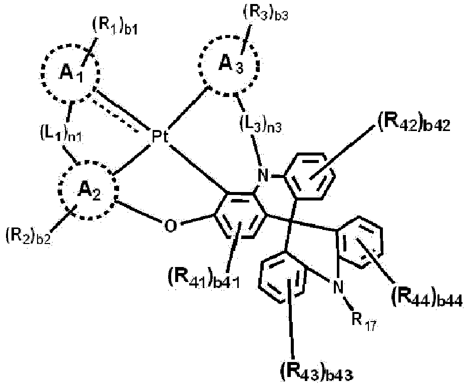 wherein in Formula 3A and Formula 3B, b41 is an integer from 0 to 2, and A₁ to A₃, n1, n3, L₁, L₃, b1 to b3, b42 to b44, R₁ to R₃, R₄₁ to R₄₄, and R₁₇ are the same as defined in Formula 1.

17. The organometallic compound of claim 16, wherein R₁₇ in Formula 3B is a substituted or unsubstituted phenyl group.

18. The organometallic compound of at least one of claims 15 to 17, wherein R₄₃ and R₄₄ in Formula 3-2 are hydrogen atoms.

19. The organometallic compound of at least one of claims 14 to 18, wherein Formula 2 is represented by Formula 4: 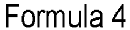 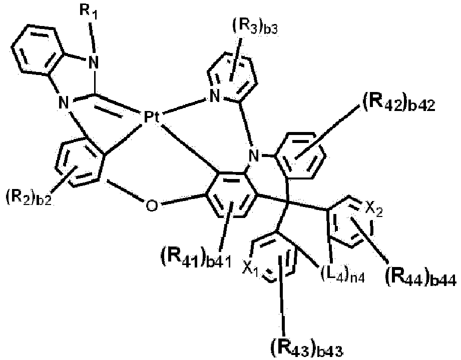 wherein in Formula 4, b41 is an integer from 0 to 2, and n4, L₄, b2, b3, b42 to b44, R₁ to R₃, R₄₁ to R₄₄, X₁, and X₂ are the same as defined in Formula 2.

20. The organometallic compound of at least one of claims 13 to 19, wherein Formula 1 is represented by any one among compounds in Compound Group 1:
